# EUROPEAN PATENT APPLICATION

(11) **EP 4 813 844 A1**
(43) Date of publication of application: **30.09.2026**
(21) Application number: 26167113.5
(22) Date of filing: 24.03.2026
(51) Int. Cl.: B64F 1/20, G08G 5/22, H05B 47/10

(54) **AIRFIELD LIGHTING CONTROL AND MONITORING PLATFORM**

(30) Priority: 24.03.2025 US 202563776535 P
(71) Applicant: SPX Aids to Navigation Pty Ltd, Somerville, Victoria 3912 (AU)
(72) Inventor: OHLE, Jens, Somerville, 3912 (AU); LECLERC, Xavier Pierre, Somerville, 3912 (AU); PEDAN, Sveta, Somerville, 3912 (AU); CHE, Lichang, Somerville, 3912 (AU)
(74) Representative: Viering, Jentschura & Partner mbB Patent- und Rechtsanwälte

(57) **Abstract**

Systems, devices, and methods for managing a workload are provided. For example, a computing device may include memory for storing instructions and a processor operable to execute the instructions. The instructions may cause the processor to receive a request from a user, in which the request is sent from a second computing device over a network. The instructions may cause the processor to determine a dataset based at least in part on the request, and compare the dataset to a layout of an airfield, in which the layout specifies a set of lighting fixtures. Further, the instructions may cause the processor to output at least one signal indicating a report associated with the request based at least in part on the comparison.

## Description

### CROSS-REFERENCE TO RELATED APPLICATIONS

This Application claims priority to U.S. Provisional Patent Application Serial No. 63/776,535, filed on March 24, 2025, entitled "Airfield Lighting Control and Monitoring System and Method," the entire disclosure of which is incorporated herein by reference.

### TECHNICAL FIELD

The present disclosure relates to an airfield lighting management platform. More particularly, the examples of the present disclosure relate to an airfield lighting management platform that enables improved, cost-effective control and monitoring of airfield lighting fixtures. Examples of the present disclosure further include tools to design airfield lighting systems.

### BACKGROUND

Conventional airfield lighting systems are deployed at airports to provide visual guidance for pilots, air traffic controllers, and ground personnel during taxiing, takeoff, and landing operations, particularly under low-visibility conditions. To maintain safety and operational continuity, the Federal Aviation Administration (FAA) in the United States, for example, prescribes performance requirements and redundancy measures for airfield lighting-at least on instrument runways-to mitigate the effects of multi-point failures. Such redundancies may include backup power sources, redundant communication pathways, and overlapping or spare lighting fixtures (e.g., units, nodes, etc.).

Despite these requirements, existing airfield lighting installations typically rely on wired lighting fixtures arranged in series circuits and powered by constant current regulator (CCR) supplies. This architecture may introduce inherent reliability limitations, as a single fault within a series circuit may disable all lights connected to that circuit. Additionally, conventional systems may employ hierarchical tree or star network topologies, which may increase maintenance complexity and cost because a failure at an upstream lighting node may interrupt operation of downstream lighting nodes.

Modernization efforts, such as transitioning to wireless control architectures, may be cost-prohibitive, require substantial installation work, and may necessitate extended airfield closures, leading to operational disruptions. Accordingly, existing airfield lighting infrastructures continue to exhibit limitations in fault tolerance, maintainability, scalability, and cost-effective upgrades, while still being required to comply with regulatory safety standards.

### SUMMARY

In some aspects, the techniques described herein relate to a computing device, including: at least one memory storing processor-executable code; and at least one processor communicatively connected with the at least one memory and individually or collectively operable to execute the code to cause the computing device to: receive a request from a user, in which the request is sent from a second computing device over a network; determine a dataset based at least in part on the request; compare the dataset to a layout of an airfield, in which the layout specifies a set of lighting fixtures; and output at least one signal indicating a report associated with the request based at least in part on the comparison.

In other aspects, the techniques described herein relate to a computing device, in which the at least one processor operable to execute the code further causes the computing device to: analyze the request to identify an interest of the user and an operation mode.

In some cases, the techniques described herein relate to a computing device, in which the operation mode is a primary mode or a sub-system mode.

In other cases, the techniques described herein relate to a computing device, in which the network supports Modbus transmission control protocol and Internet protocol (Modbus TCP/IP) communication, and in which the second computing device communicates with the computing device using the Modbus TCP/IP.

In some examples, the techniques described herein relate to a computing device, in which the second computing device is an air traffic control device, a handheld airfield controller, a pilot-activated lighting control device, or a combination thereof.

In other examples, the techniques described herein relate to a computing device, in which the dataset includes a lighting fixture activation event, a fault condition associated with a lighting fixture, a control command associated with the lighting fixture, or a combination thereof.

In some instances, the techniques described herein relate to a computing device, in which the at least one processor operable to execute the code further causes the computing device to: analyze the request to identify an interest of the user and an operation mode; and generate the layout at an interface based at least in part on the analysis of the request.

In other instances, the techniques described herein relate to a computing device, in which the set of lighting fixtures includes solar-powered radio frequency enabled lighting fixtures, runway edge lighting fixtures, wired lighting fixtures, stand-along steady burning lighting fixtures, or a combination thereof.

In some aspects, the techniques described herein relate to a computing device, in which the at least one processor operable to execute the code further causes the computing device to: receive at least one signal indicating feedback regarding the report.

In other aspects, the techniques described herein relate to a computing device, in which the at least one processor operable to execute the code further causes the computing device to: determine that the airfield satisfies a set of airfield operational conditions based at least in part on the comparison.

In some cases, the techniques described herein relate to a computing device, in which the at least one processor operable to execute the code further causes the computing device to: determine that the airfield has an issue with respect to a set of airfield operational conditions based at least in part on the comparison.

In some instances, the techniques described herein relate to a method for managing a workload, including: receiving a request from a user, in which the request is sent from a second computing device over a network; determining a dataset based at least in part on the request; comparing the dataset to a layout of an airfield, in which the layout specifies a set of lighting fixtures; and outputting at least one signal indicating a report associated with the request based at least in part on the comparison.

In other instances, the techniques described herein relate to a method, further including: analyzing the request to identify an interest of the user and an operation mode.

In some examples, the techniques described herein relate to a method, in which the operation mode is a primary mode or a sub-system mode.

In other examples, the techniques described herein relate to a method, in which the network supports Modbus transmission control protocol and Internet protocol (Modbus TCP/IP) communication, and in which the second computing device communicates with the computing device using the Modbus TCP/IP.

In some aspects, the techniques described herein relate to a method, in which the second computing device is an air traffic control device, a handheld airfield controller, a pilot-activated lighting control device, or a combination thereof.

In other aspects, the techniques described herein relate to a method, in which the dataset includes a lighting fixture activation event, a fault condition associated with a lighting fixture, a control command associated with the lighting fixture, or a combination thereof.

In some cases, the techniques described herein relate to a method, in which the set of lighting fixtures includes solar-powered radio frequency enabled lighting fixtures, runway edge lighting fixtures, wired lighting fixtures, stand-along steady burning lighting fixtures, or a combination thereof.

In other cases, the techniques described herein relate to a computing device, including: at least one memory storing processor-executable code; and at least one processor communicatively connected with the at least one memory and individually or collectively operable to execute the code to cause the computing device to: monitor an airfield to obtain a dataset; compare the dataset to a layout of an airfield, in which the layout specifies a set of lighting fixtures; determine that the airfield has an issue with respect to a set of airfield operational conditions based at least in part on the comparison; generate an action to resolve the issue; and output at least one signal indicating a report based at least in part on the determination, in which the report specifies at least the action and the issue.

In other instances, the techniques described herein relate to a computing device, in which the set of lighting fixtures includes solar-powered radio frequency enabled lighting fixtures, runway edge lighting fixtures, wired lighting fixtures, stand-along steady burning lighting fixtures, or a combination thereof.

In some aspects, the techniques described herein relate to a runway builder, including: at least one memory storing processor-executable code; and at least one processor communicatively connected with the at least one memory and individually or collectively operable to execute the code to cause the runway builder to: receive a request from a user; generate a runway within a first layout of an airfield based at least in part on the request; assign a set of lighting fixtures to the runway to obtain a second layout of the airfield; compare the second layout to a set of airfield operational conditions; and output at least one first signal indicating a notification based at least in part on the comparison.

In other aspects, the techniques described herein relate to a runway builder, in which the request is a validated request.

In some cases, the techniques described herein relate to a runway builder, in which the request is validated while operating in a primary mode.

In other cases, the techniques described herein relate to a runway builder, in which the request is validated while operating in a sub-system mode.

In some instances, the techniques described herein relate to a runway builder, in which the request specifies a set of inputs, and in which the set of inputs specifies a length of the runway, a width of the runway, an orientation of the runway, or a combination thereof.

In other instances, the techniques described herein relate to a runway builder, in which at least one of the set of lighting fixtures is part of a light group in the runway.

In some examples, the techniques described herein relate to a runway builder, in which the at least one processor operable to execute the code further causes the runway builder to: determine that the second layout has an issue based at least in part on the comparison; and output at least one second signal indicating a second notification associated with the issue.

In other examples, the techniques described herein relate to a runway builder, in which the at least one processor operable to execute the code further causes the runway builder to: determine that second layout satisfies the airfield operational conditions based at least in part on the comparison.

In some aspects, the techniques described herein relate to a runway builder, in which the set of lighting fixtures includes solar-powered radio frequency enabled lighting fixtures, runway edge lighting fixtures, wired lighting fixtures, stand-along steady burning lighting fixtures, or a combination thereof.

In other aspects, the techniques described herein relate to a runway builder, in which assigning the set of lighting fixtures to the runway includes associating each lighting fixture of the set of lighting fixture with a physical location on the second layout.

In some cases, the techniques described herein relate to a method for managing a workload, including: receiving a request from a user; generating a runway within a first layout of an airfield based at least in part on the request; assigning a set of lighting fixtures to the runway to obtain a second layout of the airfield; comparing the second layout to a set of airfield operational conditions; and outputting at least one first signal indicating a notification based at least in part on the comparison.

In other cases, the techniques described herein relate to a method, in which the request is a validated request.

In some examples, the techniques described herein relate to a method, in which the request is validated while operating in a primary mode.

In other examples, the techniques described herein relate to a method, in which the request is validated while operating in a sub-system mode.

In some instances, the techniques described herein relate to a method, in which the request specifies a set of inputs, and in which the set of inputs specifies a length of the runway, a width of the runway, an orientation of the runway, or a combination thereof.

In other instances, the techniques described herein relate to a method, in which at least one of the set of lighting fixtures is part of a light group in the runway.

In some aspects, the techniques described herein relate to a method, in which the set of lighting fixtures includes solar-powered radio frequency enabled lighting fixtures, runway edge lighting fixtures, wired lighting fixtures, stand-along steady burning lighting fixtures, or a combination thereof.

In other aspects, the techniques described herein relate to a method, in which assigning the set of lighting fixtures to the runway includes associating each lighting fixture of the set of lighting fixture with a physical location on the second layout.

In some cases, the techniques described herein relate to an interface, including: at least one memory storing processor-executable code; and at least one processor communicatively connected with the at least one memory and individually or collectively operable to execute the code to cause the interface to: generate a runway of an airfield based at least in part on user input; assign a set of lighting fixtures to the runway to obtain a layout of the airfield, in which at least one of the set of lighting fixtures is part of a light group in the runway; compare the layout to a set of airfield operational conditions; and output at least one first signal indicating a notification based at least in part on the comparison.

In other cases, the techniques described herein relate to an interface, in which the set of lighting fixtures includes solar-powered radio frequency enabled lighting fixtures, runway edge lighting fixtures, wired lighting fixtures, stand-along steady burning lighting fixtures, or a combination thereof.

In some aspects, the techniques described herein relate to an airport environment, including: a lighting management platform including an engine and an interface; an airfield including a set of lighting fixtures and a set of constant current regulators (CCRs), in which the platform is communicatively connected to the airfield over a network, in which the engine is designed to: receive a request from a user, in which the request is sent via the interface; determine an action to be taken on a lighting fixture of the set of lighting fixtures based at least in part on the request; communicate with a CCR of the set of CCRs associated with the lighting fixture using a circuit; apply the action to the lighting fixture via the CCR; and output at least one first signal indicating a notification based at least in part on the application.

In other aspects, the techniques described herein relate to an airport environment, in which the engine further designed to: analyze the request to identify an interest of the user and an operation mode.

In some cases, the techniques described herein relate to an airport environment, in which the operation mode is a primary mode or a sub-system mode.

In other cases, the techniques described herein relate to an airport environment, in which the CCR is a multi-step CCR, and in which the action dictates modifying a current-level of the lighting fixture.

In some instances, the techniques described herein relate to an airport environment, in which the lighting fixture is part of a light group in the airfield.

In other instances, the techniques described herein relate to an airport environment, in which the engine further determines the action to be taken based at least in part on an airfield operational condition.

In some aspects, the techniques described herein relate to an airport environment, in which the set of lighting fixtures includes solar-powered radio frequency enabled lighting fixtures, runway edge lighting fixtures, wired lighting fixtures, stand-along steady burning lighting fixtures, or a combination thereof.

In other aspects, the techniques described herein relate to an airport environment, in which the action dictates changing a mode of the lighting fixture, adjusting a workload of the lighting fixture, or a combination thereof.

In some cases, the techniques described herein relate to an airport environment, in which the engine is further designed to: receive at least one second signal indicating feedback regarding the notification.

In other cases, the techniques described herein relate to a method for managing a workload, including: determining an action to be taken on a lighting fixture of a set of lighting fixtures based at least in part on a request; communicating with a constant current regulator (CCR) associated with the lighting fixture using a circuit; applying the action to the lighting fixture via the CCR; and outputting at least one signal indicating a notification based at least in part on the application.

In some aspects, the techniques described herein relate to a method, in which the request is a validated request.

In other aspects, the techniques described herein relate to a method, in which the CCR is a multi-step CCR, and in which the action dictates modifying a current-level of the lighting fixture.

In some cases, the techniques described herein relate to a method, in which the lighting fixture is part of a light group in an airfield.

In other cases, the techniques described herein relate to a method, in which the set of lighting fixtures includes solar-powered radio frequency enabled lighting fixtures, runway edge lighting fixtures, wired lighting fixtures, stand-along steady burning lighting fixtures, or a combination thereof.

In some aspects, the techniques described herein relate to a method, in which the action dictates changing a mode of the lighting fixture, adjusting a workload of the lighting fixture, or a combination thereof.

In other aspects, the techniques described herein relate to a method, further including: receiving at least one second signal indicating feedback regarding the notification.

In some aspects, the techniques described herein relate to a computing device, including: at least one memory storing processor-executable code; and at least one processor communicatively connected with the at least one memory and individually or collectively operable to execute the code to cause the computing device: receive a request from a user, in which the request is sent via an interface; determine an action to be taken on a lighting fixture of a set of lighting fixtures based at least in part on the request; communicate with a CCR associated with the lighting fixture using a circuit; apply the action to the lighting fixture via the CCR; and output at least one signal indicating a notification based at least in part on the application.

In other aspects, the techniques described herein relate to a computing device, in which the set of lighting fixtures includes solar-powered radio frequency enabled lighting fixtures, runway edge lighting fixtures, wired lighting fixtures, stand-along steady burning lighting fixtures, or a combination thereof.

In some cases, the techniques described herein relate to a computing device, in which the CCR is a multi-step CCR, and in which the action dictates modifying a current-level of the lighting fixture.

In some aspects, the techniques described herein relate to a computing device, in which the lighting fixture is part of a light group in an airfield.

### BRIEF DESCRIPTION OF THE DRAWINGS

FIG. 1 is a schematic diagram of an example airport environment that supports a platform for lighting control and monitoring, in accordance with one or more aspects of the present disclosure;
FIG. 2 is a block diagram of an example lighting management platform, in accordance with one or more aspects of the present disclosure;
FIG. 3 is a schematic diagram of an example communication interface, in accordance with one or more aspects of the present disclosure;
FIG. 4A is a flowchart that describes a portion of an example method for managing a workload, in accordance with one or more aspects of the present disclosure;
FIG. 4B is a flowchart that describes a portion of the example method of FIG. 4A for managing the workload, in accordance with one or more aspects of the present disclosure;
FIG. 5 is a block diagram of a computing environment that supports a lighting management platform, in accordance with one or more aspects of the present disclosure;
FIG. 6 is a flowchart of an example method for managing a workload, in accordance with one or more aspects of the present disclosure;
FIG. 7 is a schematic diagram of another example communication interface, in accordance with one or more aspects of the present disclosure;
FIGs. 8-10 are example schematic diagrams of example communication interfaces, in accordance with one or more aspects of the present disclosure;
FIG. 11 is a flowchart that describes an example light group command sequence, in accordance with one or more aspects of the present disclosure;
FIG. 12 is a flowchart that describes an example lighting node status sequence, in accordance with one or more aspects of the present disclosure;
FIGs. 13-14 are example schematic diagrams illustrating CCR management, in accordance with one or more aspects of the present disclosure;
FIGs. 15-17 are example schematic diagrams illustrating example airport environments, in accordance with one or more aspects of the present disclosure;
FIG. 18 is a flowchart that describes an example user management method, in accordance with one or more aspects of the present disclosure; and
FIGs. 19-22 are example flowcharts that describe example methods for managing a workload, in accordance with one or more aspects of the present disclosure.

### DETAILED DESCRIPTION

Airfield lighting systems are widely deployed at airports to provide visual cues for pilots, air traffic controllers, and ground personnel during surface movement, takeoff, and landing operations. In practice, the availability and accuracy of runway, taxiway, and approach lighting may influence operational safety and throughput, particularly during periods of reduced visibility such as nighttime operations, precipitation, fog, or other adverse weather conditions. As a result, airfield operators may need lighting fixtures that not only deliver consistent photometric performance but also preserve control and monitoring capabilities in the presence of faults.

Regulatory authorities may have addressed some of these safety concerns by issuing guidance governing the performance, control architecture, and redundancy of airfield ground lighting systems. In the example of the United States, the FAA has established specifications for Airport Lighting Control and Monitoring Systems (ALCMS), defining requirements intended to streamline the control and monitoring of lighted visual aids and enhance overall airport safety. These frameworks may contemplate that an ALCMS may integrate multiple control and monitoring interfaces and provide operator-facing human-machine interfaces (HMIs) for coordinated management of runway and taxiway lighting systems. In another example, the International Civil Aviation Organization (ICAO) has long supported the deployment of aerodrome visual aids through design and installation guidance (such as aerodrome design manuals addressing visual aids), while leaving implementation details to national regulators and airport operators.

Notwithstanding the availability of such guidance and the longstanding adoption of the ALCMS concept, many deployed installations continue to exhibit technical and operational limitations that complicate regulatory compliance, system resiliency, and lifecycle cost management. For example, conventional airfield lighting infrastructure frequently relies on wired lighting fixtures connected in series circuits and powered by CCRs. Although series-circuit architectures may provide uniform current delivery over long cable runs, they may introduce vulnerability to circuit-level faults. An open circuit, damaged cable segment, failed connector, or other discontinuity may break the loop and render multiple lights, and potentially the entire circuit, inoperable. Thus, a localized electrical fault may escalate into a broader outage condition, undermining redundancy objectives intended to preserve operational continuity during multi-point failures.

Conventional airfield lighting networks may employ hierarchical topologies (e.g., tree or star configurations), in which lighting fixtures and field devices are supervised by upstream distribution nodes. Under these conditions, a failure at a parent node, feeder segment, or control interface may disrupt communications or command execution for multiple downstream services. As a result, the architecture may exhibit single-point or few-point failure modes that cause cascading loss of control, monitoring visibility, or lighting availability, thereby increasing operational risk and elevating maintenance burden. These concerns may become more pronounced when the control system is expected to support fail-safe behaviors and ensure safe operation despite impaired command execution or loss of communications.

Modernization efforts may further compound these challenges. Although advances in control electronics, wireless communications, and visualization software may enable more capable operator interfaces and more granular monitoring, retrofitting existing airfields may still be constrained by cost and operational disruption. Upgrading a conventional wired system, whether partially or in full, to incorporate wireless controls or solar-powered lighting units may require extensive field work. The field work may include excavation, cable rerouting, equipment replacement, commissioning, and re-certification activities. Such efforts may impose downtime, necessitate phased runway or taxiway closures, and materially disrupt airfield operations, which in turn may discourage incremental upgrades even when modernization would otherwise improve resilience or make the system easier to maintain.

In addition, traditional ALCMS implementations may rely on bespoke solutions engineered for the specific characteristics of a given airfield, including its topology, circuit segmentation, operational procedures, and integration constraints. This may involve application engineering, custom programming, and system integration effort, with corresponding impacts on procurement cost, deployment timelines, and ongoing support complexity. These factors may create friction between adopting more advanced control and monitoring capabilities aligned with evolving standards and the practical need to reduce installation complexity, downtime, and lifecycle maintenance costs.

For at least the reasons discussed above and to avoid or reduce resource-intensive efforts (from the perspective of, for example, time, engineering, cost, utilization of excessive computing resources, energy requirements, etc.), a fundamentally different lighting management platform may be preferred. The techniques, systems, devices, and methods described herein may provide a lighting management platform that addresses the limitations of conventional architectures while maintaining compliance with applicable regulatory safety and redundancy requirements. In some aspects, the platform may support cost-effective and robust control and monitoring, enhanced fault tolerance for multi-point failure scenarios, real-time data transmission, and system interoperability, while enabling scalable upgrades of existing wired systems with reduced operational disruption.

In other aspects, the platform may provide an advancement in the management, control, and monitoring of airfield lighting systems. Unlike conventional ALCMS that may involve extensive application engineering, bespoke programming, and specialized system integration, the platform may streamline configuration and deployment by enabling user-level mapping, customization, and airfield setup directly through a communication interface. By shifting traditionally complex engineering tasks into an intuitive, software-driven configuration layer, the platform may reduce design overhead, integration complexity, and commissioning effort, thereby making monitored ALCMS capabilities accessible and cost-effective for general aviation, regional, and smaller airfields.

As discussed above, traditional ALCMS solutions typically involve considerable capital investment, with system costs often scaling from tens of thousands of dollars upward depending on airfield size, hardware requirements, and design services. As a result, many smaller or unmanned airfields have historically been unable to justify the expense and operational disruption associated with such systems, despite the safety and compliance benefits of active lighting monitoring. The disclosed platform may address this gap by providing a cost-effective solution that delivers enhanced safety, monitoring, and operational efficiency without extensive infrastructure modifications, thereby expanding access to advanced airfield lighting control for airfields that were previously underserved.

In the present disclosure, the platform may manage different lighting fixtures (e.g., wired lighting fixtures, radio-frequency (RF) controlled lighting fixtures, solar-powered lighting fixtures, etc.) in accordance with aviation administration requirements in the jurisdiction in which the platform is installed (e.g., FAA L-890 requirements in the United States, requirements of the Civil Aviation Safety Authority in Australia, etc.). Unlike conventional systems that are limited to wired circuits or that rely on parallel control systems for different fixture technologies, the platform may provide a common control and monitoring interface across heterogeneous lighting fixtures. This unified architecture may enable consistent monitoring, fault detection, and control behavior across light types, supporting broader adoption of solar airfield lighting while maintaining regulatory monitoring requirements that have historically been difficult to satisfy for solar-powered lighting fixtures.

In some cases, the platform may enable secure and reliable monitoring and control over standard transmission control protocol/Internet protocol (TCP/IP) networks, supporting both local area network (LAN) and secure wide area network (WAN) connectivity. This architecture may allow lighting fixtures to be monitored and managed not only from on-site control points but also from remote locations where permitted, thereby improving operational visibility and response capability. In other cases, alarm and event monitoring may be extended through satellite-based communications (e.g., Iridium Short Burst Data (SBD) communications or other satellite-based communications), enabling status reporting and fault alerts for remote or unattended airfields where terrestrial communications infrastructure may be limited or unavailable. These capabilities may enhance operational safety and continuity for airfields that lack continuous on-site personnel.

In supporting solar-powered lighting integration, the platform may enable solar fixtures to be incorporated into the broader airport lighting infrastructure, extending lighting coverage to areas with limited or no access to grid power. This capability may enhance operational flexibility and resilience and align the platform with emerging regulatory and industry trends toward sustainable airfield lighting solutions. By providing monitoring and control mechanisms consistent with aviation jurisdictional requirements, the platform may address a longstanding barrier to the widespread deployment of monitored solar airfield lighting systems.

In the present disclosure, the platform may be designed to align with various aviation administration standards. For example, the platform may support full L-890 Type A, Type B, and Type C functionalities within a single system interface. By integrating wired, RF-controlled, and solar lighting fixtures into one monitored system, the platform may distinguish itself from existing solutions that provide only partial compliance or single-technology control. This comprehensive standards alignment may position the platform to support diverse operational environments while maintaining regulatory compatibility.

By leveraging available protocols (e.g., IEEE 802.15.4, MODBUS TCP/IP, etc.) and standard TCP/IP networking, the platform may support reliable and efficient communication across distributed lighting fixtures while reducing power consumption. These technologies may facilitate wireless control and monitoring of solar and/or RF-enabled fixtures and allow gradual system expansion or modification as airfield requirements evolve, without necessitating wholesale system replacement.

Further, the platform may provide precise control over both wired and RF-controlled lighting fixtures, along with comprehensive event, warning, and alarm logging presented through a user-friendly communication interface. In some aspects, additional integrations (e.g., pilot-activated lighting control (PALC) interfaces, photocells or photosensitive switches for automated intensity control, external equipment interfaces via MODBUS TCP/IP, etc.) may allow the platform to monitor and control ancillary airfield equipment without specialized adapters or non-standard interfaces. Designed to manage one or more lighting fixtures, the platform may scale efficiently across a wide range of airfield sizes and configurations, from small, unmanned airstrips to complex multi-runway facilities.

In some aspects, the platform may provide a runway builder that enables authorized users to create, edit, and validate a digital representation of an airfield for purposes of lighting control, monitoring, alarm management, and configuration. Rather than relying on specialized integrators to translate airfield drawings into a deployable configuration, the runway builder may provide a software-driven setup workflow, in which a user may define runway geometry, runway designations and headings, and other airfield features. The platform may then store the resulting airfield layout as a structured configuration suitable for subsequent control and monitoring operations. In this manner, the runway builder may reduce commissioning time and cost and may make monitored airfield lighting capabilities more accessible to airfields that lack the resources typically required to deploy conventional systems.

In other aspects, the runway builder may support multiple layout definition approaches, including parameter-based entry, grid-based or segment-based construction, and hybrid workflows. The runway builder may further apply or recommend placement constraints associated with airfield lighting (e.g., spacing, symmetry, and location conventions for different lighting fixture types) and may provide validation feedback when a user-entered configuration is incomplete, internally inconsistent, or incompatible with selected operational settings. The airfield layout produced by the runway builder may be schematic or approximate while still being sufficiently structured to support group-based lighting control, visibility monitoring, and fault localization, particularly for smaller or infrastructure-limited airfields that may not maintain detailed or current engineering drawings.

In some cases, the runway builder may additionally provide a mapping workflow that associates lighting fixtures and logical light groups with locations or elements within the defined airfield layout. For example, once the runway geometry is established, the runway builder may allow a user to associate one or more lighting fixtures with one or more controllable groups and related operational parameters (e.g., intensity steps, context-dependent behaviors, etc.). The runway builder may store these associations as part of the airfield configuration such that communication interfaces may display a location-aware view of lighting status and alarms, and control actions may be executed consistently against the user-defined layout without requiring custom code for each airfield deployment.

By leveraging existing infrastructures and employing standardized communication protocols, the platform may reduce system complexity, simplify maintenance, and extend operational lifespan. The platform's modular and interoperable design may enable seamless integration with existing controller-based systems, providing operators with flexibility to tailor deployments to specific operational needs. Collectively, these features may position the platform as a future-ready solution that not only addresses current airfield lighting control challenges but also adapts to anticipated technological and regulatory developments.

Before any examples of the disclosure are explained in detail, it is to be understood that the disclosure is not limited in its application to the details of construction and the arrangement of components set forth in the following description or illustrated in the following drawings. The disclosure is capable of other examples and of being practiced or of being carried out in various ways. Also, it is to be understood that the phraseology and terminology used herein are for the purpose of description and should not be regarded as limiting. The use of "including," "comprising," or "having" and variations thereof herein is meant to encompass the items listed thereafter and equivalents thereof as well as additional items. Unless specified or limited otherwise, the terms "mounted," "connected," "supported," and "coupled" and variations thereof are used broadly and encompass both direct and indirect mountings, connections, supports, and couplings. Further, "connected" and "coupled" are not restricted to physical or mechanical connections or couplings.

The following discussion is presented to enable a person skilled in the art to make and use examples of the disclosure. Various modifications to the illustrated examples will be readily apparent to those skilled in the art, and generic principles presented herein can be applied to other examples and applications without departing from examples of the disclosure. Thus, examples of the disclosure are not intended to be limited to examples shown but are to be accorded the widest scope consistent with the principles and features disclosed herein. The following detailed description is to be read with reference to the figures, in which like elements in different figures have like reference numerals. The figures, which are not necessarily to scale, depict selected examples and are not intended to limit the scope of examples of the disclosure. Skilled artisans will recognize that the examples provided herein have many useful alternatives and fall within the scope of examples of the disclosure.

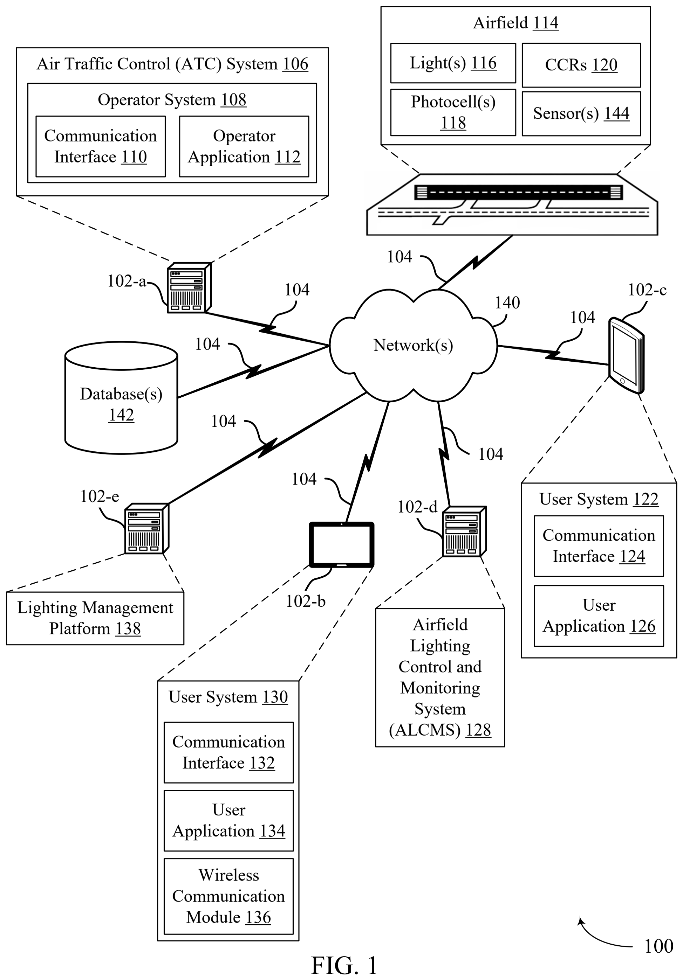

FIG. 1 is a schematic diagram of an example airport environment 100 that supports a lighting management platform 138 for airfield lighting control and monitoring, in accordance with one or more aspects of the present disclosure. The lighting management platform 138 is referred to herein as the "platform 138." The airport environment 100 may include one or more computing devices 102-a through 102-e (collectively referred to as computing devices 102), at least one network 140, an airfield or aerodrome 114, and at least one database 142. The at least one network 140 may be in communication with the one or more computing devices 102 and components of the airfield 114 via one or more communication links 104, which may include other communication networks, such as classical networks and entanglement networks. The computing devices 102 and the components of the airfield 114 may communicate with each other via the at least one network 140, or they may directly communicate via peer-to-peer or sidelink communications, for example. Each component illustrated in FIG. 1 is discussed below.

The one or more computing devices 102 may be any type of computing device, such as classical computing devices including a desktop computer, laptop, mobile phone, smartphone, tablet, netbook, database, personal digital assistant (PDA), wearable device (e.g., smartwatch, smart glasses, fitness tracker, etc.), personal computer, Internet of Things (IoT) device, embedded system, smart speaker, smart controller, industrial control system, database server, thin client, zero client, edge computing device, a workstation, network attached storage (NAS) device, storage area network (SAN) component, a mainframe computer, a supercomputer, computing cluster, a server (e.g., rack server, blade server, tower server, microserver, etc.), or other electronic device. The one or more computing devices 102 may be enabled with Internet or other network access and may be locatable by the at least one network 140. In some aspects, the one or more computing devices 102 may be configured to transmit or otherwise output instructions to control various devices, receive data or other signals from external devices, and transmit or otherwise output the received data or other data to the at least one network 140, the one or more databases 142, a component of the airfield 114, a server, or another remote computing device 102 (e.g., another database) of the airport environment 100.

Further, the one or more computing devices 102 may interface with the one or more databases 142. Different types of data may be stored in a single database 142 (e.g., a codebase, a vector database, a knowledge base, etc.) or may be stored in separate databases 142, or any combination. Each of the one or more databases 142 may be any type of centralized database, distributed database, or the like. For example, a centralized database may reside in one central location, which may be accessed by various users, computing devices 102, or applications via a network, such as the at least one network 140. In another aspect, a distributed database may be spread across multiple servers in the at least one network 140, with each server managing part of the database 142. Within a distributed database, a user may retrieve data seamlessly, similar to if it were stored within a centralized database.

In the present disclosure, each of the databases 142 may store, log, or record unstructured data or structured data (or data structures) that may include (or specify) one or more of, for example (but not limited to), telemetry data including past and present usage of the one or more computing devices 102, data (or metadata) for execution of applications or services, data related to the airfield 114 and light nodes 116, a set of model training or fine-tuning parameters, a product identifier of a computing device (e.g., 102-b), a type of a computing device (e.g., 102-b), an identifier of a user (e.g., a unique string or combination of bits associated with a particular user), a cumulative history of user/administrator activity records obtained over a prolonged period of time, a detail of a job that has been initiated by the computing device 102-e, a number of requests handled (in parallel) per minute (or per second, per hour, etc.) by the computing device 102-e, a documentation that shows how the computing device 102-e performs against a service level objective or a service level agreement (SLA), computing resource and Internet Protocol (IP) address details of each of the computing devices 102, information indicating a user experience with respect to a provided service, information associated with a hardware resource set that is considered by the platform 138 (e.g., while executing a user-requested workload, while managing enterprise data, etc.), store packages such as archive files, data related to the platform 138, information related to the status of a light node 116, or the like. In some aspects, the data structures described may be stored in the databases 142 by the one or more computing devices 102 or based on historical user interactions with each computing device.

In some instances, the archive files may be bundled or compiled files containing the information or software code that may define, manage, or execute components of the platform 138 for servicing users' workload execution requests. In some instances, the archive files or templates may store definitions (e.g., rule strategy or rule type), logic, parameters (e.g., threshold values), metadata (e.g., rule name, description, status, priority, version, etc.), outcome (e.g., approve, decline, challenge/step-up, flag for review, etc.), or change history of all components, modules, and management rules used, for example, by the platform 138 in servicing one or more workload execution requests.

In other instances, the status of a light node 116 may include, for example (but not limited to): an identifier (e.g., a media access control (MAC) address) of the light node, a timestamp associated with the light node (e.g., the timestamp may represent the absolute Universal Time Coordinate (UTC) time), information with respect to the battery voltage of the light node (e.g., the current battery voltage may be measured by the node itself), an operating mode of the light node (e.g., the current physical state of the node as part of a light group, such as 0 (standby) or 1 (always ON)), information with respect to the light group (e.g., the beam mode command for all the light nodes included in the light group, such as 0 (none), 1 (visible only), 2 (infrared only), or 4 (visible and infrared)), information with respect to the intensity step associated with the light node (e.g., the beam step level command for all the light nodes included in the light group), an internal status of the light node (e.g., 8 bits to indicate the internal configuration or relay status, depending on the node type), location details of the light node (e.g., the longitude and latitude reported by the light node), a status report period of the light node (e.g., a heartbeat period configured at the node), information with respect to the failsafe timeout (e.g., time required to elapse following loss of communication with the platform 138 before entering the pre-defined failsafe operational state), a failsafe operating mode of the light node (e.g., the current failsafe operation mode of the node in the event the node enters the failsafe state), a failsafe intensity level of the light node (e.g., the current failsafe beam intensity setting of the node in the event the node enters the failsafe state), or the like.

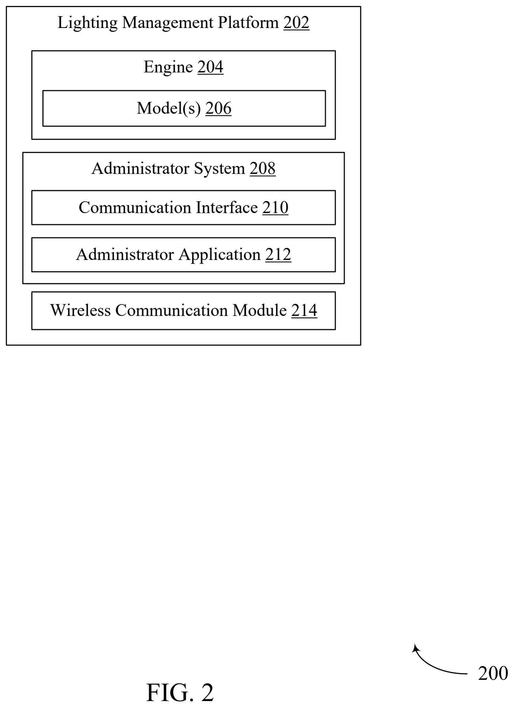

As used herein, an IP address may be a unique string of characters that identifies each computing device 102 or light node 116 using IP to communicate over the network 140. As used herein, a MAC address may be a 12-digit hexadecimal number assigned to each computing device connected to the network 140. In some aspects, the status report period may be used by the light node 116 to monitor reception of the heartbeat signal (e.g., sent by the engine 204 of FIG. 2) and to detect any RF communication failure.

In the example of FIG. 1, at least the computing device 102-e may include the platform 138. The platform 138 may operate as a fully autonomous, no-touch solution for end-to-end airport management. However, in other aspects, the platform 138 may be user-triggered and responsive to a range of input methods. For instance, authorized users may initiate actions via one or more of direct queries to the platform 138, provide structured requirements or consents, or reference existing documentation.

In some aspects, the platform 138 may be designed to enable remote control, supervision, and status monitoring of airfield lighting systems (e.g., 116) across a wide range of operational airfields (e.g., 114). The platform 138 may be scalable and intelligent, allowing users and/or administrators to improve airfield operations at, for example, non-towered airfields, regional airports, international hubs, and military installations. In other aspects, the platform 138 may manage these airfield lighting systems (e.g., solar-powered RF-enabled lighting fixtures, wired lighting fixtures, etc.) in accordance with aviation administration requirements (e.g., FAA L-890 requirements), while providing comprehensive lighting control and real-time monitoring through a unified communication interface (e.g., 210, FIG. 2).

In some cases, the platform 138 may be mounted on or within air traffic control (ATC) buildings, equipment shelters, or other fixed structures, and may transmit operator commands to distributed lighting fixtures (e.g., light nodes 116) over a wireless mesh network (e.g., 140). The platform 138, via its engine (e.g., 204, FIG. 2), may receive and process operational status data from the lighting fixtures, enabling centralized visibility into lighting states, faults, alarms, and performance metrics. Depending on deployment requirements, the platform 138 may operate as a primary airfield lighting management platform (e.g., operating in the primary mode) or may be connected to an existing ALCMS 128 to manage one or more designated light groups (e.g., made up of some of the light nodes 116) as a subordinate or integrated subsystem (e.g., operating in the sub-system mode).

In other cases, to ensure reliable wireless communication, the platform 138 may be positioned to improve RF signal propagation across the airfield 114. The platform 138 may incorporate one or more customized antennas *(see* FIG. 2) and a tailored RF communication path (e.g., over the at least one network 140) designed to provide full-site coverage and efficient operation of platform components and connected lighting fixtures (e.g., light nodes 116). Further, the platform 138 may be installed and secured on a variety of surface types (e.g., sand, frozen ground, mud, ice, asphalt, concrete, etc.), thereby supporting deployment in diverse environmental and geographic conditions.

As indicated above, the platform 138 may interoperate with existing third-party lighting control and monitoring systems (e.g., the ALCAMS 128), enabling integration without requiring wholesale replacement of installed infrastructure. The platform 138 may be designed to support one or more distributed lighting nodes (e.g., light nodes 116), allowing deployment across airfields of varying size and complexity while maintaining adaptability to evolving operational demands and future technological developments.

In the present disclosure, each component of the platform 138 may be designed to withstand a wide range of environmental conditions and operate effectively without causing electromagnetic interference to other airport devices or systems (e.g., 106, 116, 120, 122, 128, 130, etc.). Each component may be rated to function within a temperature range of, for example, 32°F to 104°F (0°C to 40°C) and at 0-90% relative humidity. In other examples, at least some of the components may be rated to operate in much cooler or warmer temperatures or up to 100% humidity. In addition, these components may be housed in robust enclosures that meet at least National Electrical Manufacturers Association (NEMA) 12 standards, providing protection against dust, dirt, and moisture. Further, the platform 138 may be designed to reduce radiated and conducted electromagnetic interference, thereby ensuring compatibility and coexistence with other sensitive equipment, including computers, radars, instrument landing systems, and communication receivers across the airport environment 100.

Those skilled in the art will appreciate that the foregoing environmental ranges are provided merely as examples, and that other environmental ranges may be considered without departing from the scope of the present disclosure.

In some aspects, the platform 138 may be designed to operate in a primary mode, in which the platform 138 may function as a primary ALCMS for the airfield 114. When operating in the primary mode, the platform 138 may be granted full authority over airfield lighting operations and serve as a master control entity and a primary user access point for controlling and monitoring one or more components of the airfield 114. For example, in the primary mode, the platform 138 may directly control and monitor all of the light nodes 116 across the airfield 114, either individually or by defined light groups. Further, when operating in the primary mode, the platform 138 may enable centralized execution of airfield commands, support per-group and per-fixture control, and maintain a unified view of airfield status, alarms, and operational conditions, thereby allowing ATC personnel or other authorized operators to make timely adjustments in response to changing operational needs, environmental conditions, or safety requirements.

In the primary mode, the platform 138 may interface with external controllers (e.g., 102-b) and remote sub-systems (e.g., 106, 122, 128, etc.) relevant to airfield operations through standardized communication protocols, such as MODBUS TCP/IP. In such implementations, the platform 138 may operate as a MODBUS server, while external controllers and/or sub-systems may function as MODBUS clients. In this manner, the platform 138 may periodically update its MODBUS registers with current lighting node status information, alarm conditions, operational states, and other relevant data. The aforementioned controllers and/or sub-systems may initiate communication by issuing read or write requests to specific registers of the platform 138 to retrieve monitoring data or to transmit control commands and configuration settings. In response, the platform 138 may provide the requested data or acknowledge receipt and execution of the control instructions, thereby ensuring that connected controllers and/or sub-systems maintain access to up-to-date operational information and may initiate actions based on real-time conditions.

In other aspects, when the platform 138 operates in the primary mode, it may maintain multiple concurrent TCP/IP communication sessions with a set of controller units (e.g., 102-a, 102-b, etc.) for operator access, monitoring, and control, while refraining from functioning as a MODBUS server for external airfield lighting control systems. In such configurations, the platform 138 may be configured to ignore, reject, or otherwise not act upon MODBUS-based control commands originating from an external ALCMS (e.g., ALCMS 128), thereby preserving the platform 138 as the authoritative control entity for the airfield. The platform 138 may further be configured to sustain these concurrent controller connections without unexpected loss of connectivity over extended operational periods. Conversely, when operating in the sub-system mode, the platform 138 may support MODBUS-based communications with an external ALCMS (e.g., 138), including managing a MODBUS TCP/IP connection with the external ALCMS while concurrently maintaining a TCP/IP connection with a controller unit, such that the platform 138 functions as an integrated sub-system that exchanges monitoring data and control information with the external ALCMS in accordance with the sub-system operating configuration.

The MODBUS-based communication interface between the platform 138 and the aforementioned controllers and/or sub-systems may facilitate efficient and secure exchange of both dynamic and static data relevant to airfield operations. Use of MODBUS TCP/IP may facilitate expansion or modification of an airport environment (e.g., 100), enabling airfields (e.g., 114) to upgrade or incrementally widen their lighting control systems (e.g., 128, 138, etc.) as desired.

In some aspects, dynamic data may include real-time status updates, fault conditions, alarms, and control commands associated with individual lighting nodes, while static data may include configuration parameters, preset control settings, and operational thresholds. In the primary mode, the platform 138 may transmit lighting node status and control data to the aforementioned controllers and/or sub-systems, while receiving supervisory commands, acknowledgments, or configuration updates (e.g., from users, administrators, etc.). In other aspects, the MODBUS-based communication may occur over TCP/IP networks (e.g., 140) using various physical media, including copper Ethernet, fiber-optic links, or wireless Ethernet, thereby enabling robust and reliable data exchange across the airport environment 100.

Additionally, when operating in the primary mode, the platform 138 may provide RF network-based management of one or more lighting fixtures (e.g., 116) to pilots via a PALC device (e.g., 102-c). Further, the platform 138 may centralize alarm detection, event logging, and status reporting, ensuring that communication interfaces (e.g., 110, 124, 132, etc.) remain continuously updated with current airfield conditions. By consolidating control, monitoring, and communication functions within a single authoritative system, the platform 138 may enable direct and efficient management of airfield lighting fixtures (e.g., 116) while maintaining conformance with aviation administration requirements and supporting seamless integration into existing airport environments (e.g., 100).

As used herein, MODBUS may be defined as a client/server data communications protocol in the application layer. As used herein, MODBUS TCP/IP may be a network protocol in computing environments, providing a simple and robust method for transmitting data over Ethernet networks (e.g., 140). This protocol may combine the traditional MODBUS protocol, commonly used for direct device communication, with the TCP/IP suite, which is standard for modern networked communications. This fusion may allow MODBUS data to be transmitted over TCP/IP networks (e.g., 140), thereby enabling integration of the platform 138 into the airport environment 100.

In some aspects, MODBUS data may be read from and written to MODBUS registers, which may be 16-bit data elements identified by a register address and used to read or write information at a specific location using MODBUS messaging protocol. As indicated above, the platform 138 may use MODBUS registers to store and transmit data. The registers may be divided into two main types: (i) dynamic registers and (ii) static registers. In some cases, dynamic registers may be organized in accordance with lighting node type and allocated based on the MAC address of individual lighting nodes (e.g., 116). For example, data for each light node 116 may require 30 MODBUS registers to accommodate 60-bytes of information. In other cases, static registers may be pre-configured within the platform 138 and used to store consistent data (e.g., command and control information, light group statuses, alarm indicators, etc.). In some aspects, static registers may be configured via the communication interface (e.g., 210, FIG. 2) of the platform 138. The configuration through the interface may allow the platform integrators (e.g., administrators, operators, etc.) to define and modify the function of each static register, tailoring the control and monitoring capabilities to the specifications of the airfield 114.

In the present disclosure, the platform 138 and the ALCMS 128 may be configured with unique IP addresses to facilitate distinct identification over the network (e.g., 140). In some aspects, a standard MODBUS TCP/IP port (e.g., port 502) may be employed for communication. The platform 138 and the ALCMS 128 may be assigned static IP addresses to ensure consistent accessibility and communication over the network. In other aspects, the network (e.g., 140) may be configured with appropriate subnet masks and gateway settings to facilitate efficient and secure data transmission. A segregated network dedicated to lighting management traffic may be implemented to enhance security and reduce network congestion.

In some cases, the platform 138 may receive and transmit data in a structured, packeted format over Ethernet (e.g., 140) using MODBUS TCP/IP. Each MODBUS TCP/IP packet may include a transaction identifier, protocol identifier, length field, unit identifier, and the MODBUS data payload, for example. This structure may ensure that each packet is self-contained and may be correctly routed and processed by the receiving device (e.g., 102-a, 102-b, 102-c, 116, etc.). Error checking and packet validation may be performed by the underlying TCP/IP suite, providing reliability and ensuring data integrity during transmission. In other cases, to maintain data integrity and reliability, MODBUS TCP/IP communication may employ built-in mechanisms (e.g., acknowledgments, retransmissions, error detection, etc.). These mechanisms may ensure that any packets corrupted during transit are re-sent and that the message order is preserved, which may support reliable operation of the platform 138.

In some examples, the platform 138 may employ one or more error detection mechanisms (e.g., cyclic redundancy checks (CRC)) to identify errors in data transmission. When an error is detected, the engine (e.g., 204, FIG. 2) of the platform 138 may define retransmission procedures to maintain data accuracy. Further, the engine may be designed to address packet loss by initiating mechanisms to request retransmission of lost packets, thereby ensuring reliable communication in the presence of network issues.

In the event of communication failures or system errors, the engine (e.g., 204, FIG. 2) may employ one or more predefined recovery protocols to restore normal operation. For example, such protocols may include procedures for system restarts, reinitialization of communication sessions, and restoration of last known valid states. The engine may further be designed to enter a safe state upon detecting a failure, thereby maintaining airfield operational safety.

In some aspects, to maintain synchronization and consistency of data (e.g., data related to lighting fixtures), the platform 138 may ensure that updates to the registers are atomic (e.g., performed as a single, indivisible operation that may not be partially applied) and accurately reflect the current airfield state. The engine (e.g., 204, FIG. 2) of the platform 138 may be programmed to process the data coherently, ensuring that one or more management actions are performed based on synchronized and consistent data readings.

In some instances, MODBUS TCP/IP communication may be improved to meet the timing constraints of airfield operations. This may include rapid response times for status updates and alarm notifications, as well as efficient handling of control commands to support timely activation or adjustment of lighting fixtures (e.g., 116). In other instances, the platform 138 may employ, via its wireless communication module (e.g., 214, FIG. 2), a Global Navigation Satellite System (GNSS) to synchronize and timestamp the data, and the current GNSS time may be made available in a MODBUS register to the ALCMS 128 to ensure that its clock remains aligned. This synchronization may support accurate timestamping and coordinated operation among different components of the airport environment 100. In some aspects, the GNSS may be, for example (but not limited to): Global Positioning System (GPS), Galileo, Globalnaya Navigatsionnaya Sputnikovaya Sistema (GLONASS), BeiDou Navigation Satellite System (BDS), or the like.

In the present disclosure, the platform 138 may employ one or more mechanisms (e.g., Advanced Encryption Standard (AES) 256-bit encryption) for data transmitted over the network 140, thereby helping ensure secure communication and maintaining data integrity. In some aspects, other mechanisms to ensure data integrity may include checksums or hash functions that verify the completeness and correctness of the data upon receipt. These mechanisms may allow any corruption that occurs during transmission to be detected and addressed. Additionally, the platform 138 may implement access management controls and authentication procedures to restrict data access to authorized computing devices 102 and users.

In some aspects, the platform 138 may be designed to operate in the sub-system mode, in which the platform 138 may be integrated into an existing airport environment (e.g., 100) to manage one or more designated lighting groups on the airfield 114 under the direction of the ALCMS 128. In this configuration, the platform 138 may not function as the primary management authority for the airfield 114 but instead operates as an intermediary system that extends the control and monitoring capabilities of the ALCMS 128 across the airport environment 100. For example, the platform 138 may enable management of the light nodes 116, the CCRs 120, the photocells 118, or other airfield components that may not be natively supported or readily monitored by the ALCMS 128. In this manner, the platform 138 may support incremental modernization of airfield lighting infrastructure while utilizing the operational framework and communication interfaces already deployed at the airport environment 100.

When operating in a sub-system mode, the platform 138 may function as a MODBUS client that communicates with an external MODBUS server (e.g., 128). In this mode, end users may not interact directly with the platform 138 through a dedicated communication interface (e.g., 210, FIG. 2) but instead communicate with the ALCMS 128 (as the centralized authority over airfield operations). The platform 138 may operate as a functional interface between one or more lighting fixtures (e.g., 116) and the ALCMS 128 via MODBUS TCP/IP communication. Through this interface, the platform 138 may transmit data (e.g., lighting control commands, lighting node monitoring data, alarm conditions, status information, etc.) to the ALCMS 128, thereby enabling the ALCMS 128 to maintain comprehensive oversight of the airfield 114. Alternatively, in some examples, the platform 138 may function as a MODBUS server while in the sub-system mode.

In the sub-system mode, the platform 138 may at least (i) enable the integration of lighting fixtures (e.g., solar-powered taxiway lighting fixtures) into the broader airport lighting infrastructure, thereby extending lighting coverage to areas with limited or no access to grid power, (ii) facilitate centralized monitoring and control of both wired and wireless lighting fixtures through the ALCMS 128, enhancing visibility into lighting system performance, and (iii) provide unified management of lighting fixtures (e.g., 116), simplifying maintenance activities and supporting consistent operational oversight across the airfield 114. In some aspects, the platform 138 may employ additional communication interfaces (e.g., 110, 124, etc.) for monitoring purposes; however, the platform 138 may execute control actions only in response to commands received from the ALCMS 128. For example, configuration changes, control commands, and system-level modifications affecting airfield components (e.g., 116, 118, etc.) may be initiated through the communication interface of the ALCMS 128, with the platform 138 operating to translate, relay, or apply such commands.

As indicated above, operation in the sub-system mode may allow the platform 138 to extend the reach and functionality of an existing ALCMS (e.g., 128) without displacing it, providing a flexible integration mechanism that supports gradual expansion of the airfield 114, enhanced monitoring of the airfield 114, and the incorporation of new lighting fixtures into the airfield 114. By communicating with the ALCMS 128 through standardized protocols (e.g., MODBUS TCP/IP), the platform 138 may enable reliable data exchange and maintain compatibility with established airport traffic control architectures or devices (e.g., 106), allowing the airport environment 100 to enhance airfield lighting control and monitoring capabilities while preserving existing infrastructures.

In the present disclosure, the platform 138 may interface with, or otherwise receive instructions from, one or more programs run on another computing device 102. Further, the platform 138 may be in communication with various components of the airport environment 100 to service a user's request (e.g., a workload execution request). The platform 138 may manage one or more requests received from or sent to the at least one network 140. For example, a user may send a request or input to execute one or more workloads or applications to receive computer-implemented services.

In some instances, different components of the platform 138 may be located on the same, different, or additional computing devices (e.g., the computing devices 102). Further, at least some of the functionalities of the platform 138, the ALCMS 128, one or more user systems (e.g., 122, 130, etc.), an operator system 108, the airfield 114, and the databases 142 may be located within the at least one network 140, such as on the cloud.

In some cases, components of the platform 138 may be interconnected and communicate via a bus. The bus may enable communication via any standard or specification, such as peripheral component interconnect, peripheral component interconnect express, parallel advanced technology attachment, or serial advanced technology attachment. The bus may be provided in the form of a single bus or multiple buses that are operatively interconnected.

As described herein, aspects or components of the platform 138 may be any computer program or application that is trained (or fine-tuned) on data and may learn to recognize patterns, identify relationships, or make classifications for input data. The platform 138 may be able to perform many different types of functions, such as facilitating the development, organization, completion, and execution of tasks and requirements, including processing data. The platform 138 may perform these functions itself or may interface with one or more other applications or programs to perform the various functions.

In some aspects, the platform 138 may ensure that data passed across its components *(see* FIG. 2) is durably stored in its memory to keep the data for later use. The platform 138 may perform this level of data storage, for example (but not limited to): to allow auditing and debugging of workflows in case of failures or catastrophic events, to enable the data to be utilized in subsequent workflows, tasks, or jobs, or the like. Further, with respect to type-agnostic communication guarantees, the platform 138 may ensure that its components (e.g., 204, 214, FIG. 2) are multi-modal (e.g., processing text data, image data, video data, speech data, etc.) and, based on that, data abstraction may be used to transfer arbitrary data types across the components.

In some cases, the platform 138 may be implemented as part of one or more processors of the computing device 102-e and may be provided in the form of a single module or separate modules. In some instances, the platform 138 may be a single computing device that includes separate components or modules. However, in other instances, the platform 138 may be part of a collection of individual devices, in which each device may include one or more modules.

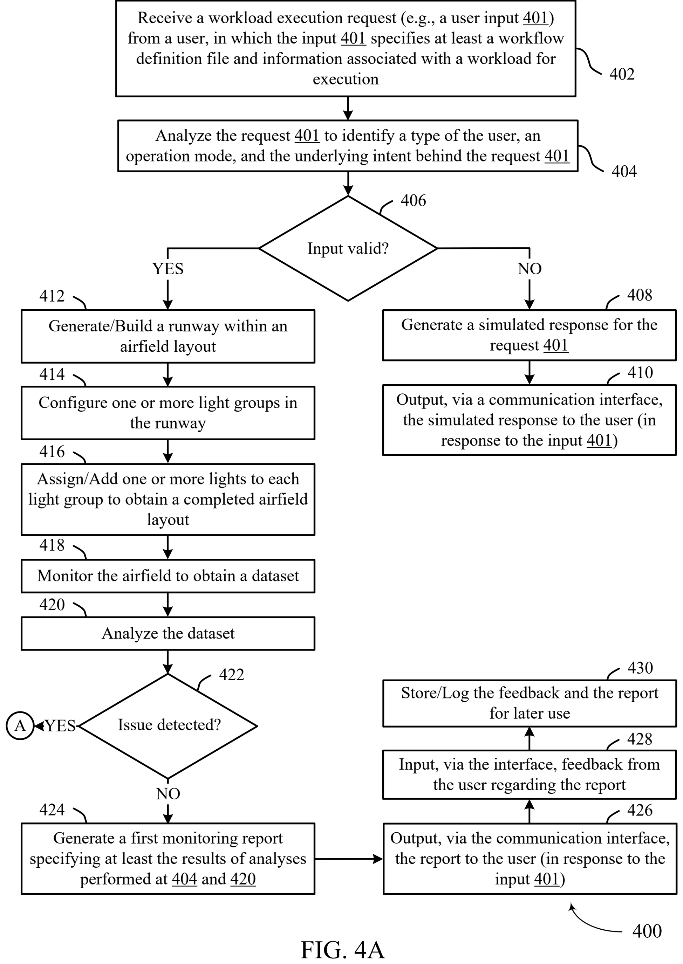

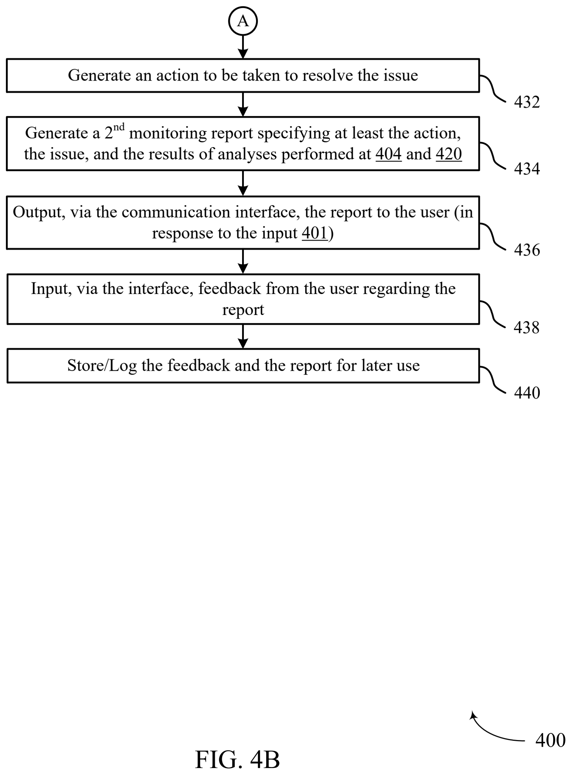

In the present disclosure, the platform 138 may be designed to perform all, or a portion, of the functionalities described in FIGs. 4A and 4B. One of ordinary skill in the art should appreciate that the platform 138 may perform other functionalities (by itself or in conjunction with other computing devices) without departing from the scope of the present disclosure. The platform 138 may be implemented using hardware (e.g., any number of integrated circuits for processing computer-readable instructions), software (e.g., a computer program), or any combination thereof.

In some aspects, at least one computing device 102 may be associated with a user, a customer, and/or an administrator. In one example, one or more administrative computing devices 102 may be used by one or more administrators or authorized personnel to manage and oversee the operation of the airfield 114 to perform one or more administrative tasks related to lighting fixture management, policy enforcement, and network monitoring.

In the example of FIG. 1, the computing device 102-a may include an ATC system 106, which may host an operator system 108. The operator system 108 may include a communication interface 110 and an operator application 112.

In some aspects, the ATC system 106 may serve as an operator-facing control mechanism for managing and supervising airfield lighting operations. The ATC system 106 may receive one or more operator commands through the communication interface 110 and convert those commands into a digital format suitable for transmission over various communication media (e.g., fiber-optic links, wireless networks, copper-based connections, etc.) to corresponding computing devices 102. In other aspects, the ATC system 106 may be implemented as an industrial-grade solution capable of continuous operation within an enclosure and may be designed to meet the environmental, reliability, and availability requirements of airfield operations. Further, the ATC system 106 may function as an airfield control mechanism, enabling authorized operators to issue lighting commands, monitor airfield status, and configure operational parameters for airfield components (e.g., 116, 118, etc.).

In the present disclosure, the ATC system 106 may be designed to support uninterrupted control operations across the airport environment 100 in the event of a communication failure or component outage via the communication interface 110. Operators may use the communication interface 110 to control and monitor airfield lighting fixtures (e.g., 116) in real-time or near real-time, enabling dynamic adjustment of lighting intensity, configuration, or operational state to support safety and operational efficiency. In addition, the ATC system 106 may support MODBUS-enabled control and monitoring of external equipment (e.g., 116, 118, etc.) and integrated communication networks via TCP/IP over copper, fiber, or wireless Ethernet, thereby enabling robust and reliable data exchange and integration with lighting control systems (e.g., 128, 138, etc.).

In some aspects, the ATC system 106 may be used to configure the platform 138 and/or the ALCMS 128 for managing the airfield 114. For example, the ATC system 106 may provide operator access to graphical representations of runways, taxiways, and associated lighting groups, enabling operators to select and modify lighting parameters (e.g., intensity, color, etc.) through the communication interface 110. In one scenario, ATC personnel may adjust runway and/or taxiway lighting fixtures (e.g., 116) in response to a change in weather conditions by selecting the relevant lighting groups displayed on the communication interface 110 and increasing the intensity of selected lights to improve visibility.

In another example, maintenance personnel may use the ATC system 106 during routine night operations to perform diagnostic checks and monitor the operational status of lighting fixtures (e.g., 116) across different sectors of the airfield 114. During such maintenance activities, maintenance personnel may request control of specific lighting circuits (e.g., 120) from the ATC operator, after which the ATC system 106 may grant temporary control or activate designated lighting circuits to support safe and efficient maintenance procedures. Through these capabilities, the ATC system 106 may enable coordinated operational control, maintenance oversight, and real-time responsiveness while preserving centralized authority and system integrity.

The communication interface 110 (e.g., a human-machine interface) may be an application (e.g., a front-end application, a mobile application, a web application, etc., that functions on the front-end) or a touchscreen through which an end-user may interact with the ATC system 106. For example, the communication interface 110 may enable a user to enter requests or inputs (e.g., natural language queries), and the communication interface 110 may output auditory or visual elements of responses generated by the platform 138. As yet another example, the communication interface 110 may display an airfield graphic (e.g., a complex airfield layout including lighting fixtures and their configurations) with touch buttons that control components (e.g., 116, 118, etc.) of the airfield 114. In this manner, operators may monitor overall airfield usage (e.g., including alerts, faults, etc.) and ensure improved lighting coverage to support safe operations across the airfield 114.

In another example, the communication interface 110 may provide information related to a failed or unhealthy component in the airfield 114 to an administrator. In another example, the communication interface 110 may provide a notification regarding execution of an operator-requested workload to an administrator for review. In another example, the communication interface 110 may enable an operator to output supervisory commands, acknowledgments, or configuration updates associated with the components of the airfield 114. In another instance, the communication interface 110 may enable operators to adjust configurations of the lighting fixtures (e.g., 116) with ease, thereby enhancing operational response times during challenging situations (e.g., weather changes, emergencies, etc.). In this manner, an operator may manage settings of airfield components (e.g., 116, 118, etc.) and design a customized airfield configuration without extensive training or a specialist. In some cases, the communication interface 110 may maintain an active session with an operator for a time period, such as, but not limited to, an hour.

As described herein, the communication interface 110 may include a dashboard program, an application programming interface (API), a graphical user interface (GUI), a programmatic interface, an application service layer/interface, an audio interface, or the like, that may provide interactive output to an operator or another computing device (e.g., 102-c). For example, the communication interface 110 may display its GUI to an operator at a display device of the computing device 102-a. In the GUI, the communication interface 110 may present information related to, for example, details of a completed task. The communication interface 110 may support a range of operator interactions, such as drag-and-drop image upload, text input fields for questions, and visual displays of computed results. The communication interface 110 may further output notifications or alerts related to an interrupted task. In some examples, the communication interface 110 may present step-by-step visualizations of the reasoning process executed by the platform 138, including intermediate annotations, extracted values, or tool outputs, thereby improving transparency and fostering operator trust. Furthermore, at least some of the functionalities of the communication interface 110 may be located within the at least one network 140, such as on the cloud.

In the present disclosure, a ranked list of tasks and a map may be prepared for presentation (via the communication interface 110), ensuring that each presented item is accompanied by relevant details (e.g., task descriptions, any other pertinent information that would assist an end-user's decision-making process, etc.). Such information may be reviewed, edited, and modified by the end-user on demand. For an end-user-centric presentation, upon receiving relevant data (e.g., from the databases 142, from the platform 138, etc.), the communication interface 110 may organize the data in a user-friendly manner for the end-user (e.g., to enhance the likelihood of end-user acceptance and satisfaction), highlighting beneficial information and insights that may guide the end-user in a response review process.

Further, the communication interface 110 may include functionality to: (i) obtain (or receive) data (e.g., any type or quantity of input) from any source (and may aggregate the data), (ii) based on (i) and by employing a set of linear or non-linear models, analyze a user-initiated query to derive additional data, (iii) encompass hardware components or software components and functionalities provided by the computing device 102-a to operate as a service over the one or more networks 140 so that the communication interface 110 may be used externally, (iv) employ a set of subroutine definitions or protocols for enabling communications between the computing device 102-a and external entities (e.g., developers, users, administrators, etc.), (v) by generating auditory or visual elements, allow an administrator to at least interact with an operator of the computing device 102-a, (vi) concurrently display one or more separate windows, for example, on its GUI, (vii) facilitate a variety of functions for a user (e.g., access control, timekeeping, etc.), (viii) enable the user to interact with the operator application 112 to initiate or schedule execution of a workload on the airfield 114 through the platform 138, and/or (ix) generate auditory outputs or visualizations of the method or process illustrated in FIGs. 4A and 4B.

In some cases, the communication interface 110 may communicate with the platform 138 over communication links 104, transmitting user queries and relevant information, and receiving results, explanations, or visualizations generated by the engine (e.g., 204, FIG. 2) and/or other components of the platform 138. Thereafter, via its GUI, the communication interface 110 may output the received results, explanations, or visualizations to the user.

The operator application 112 may be an application designed to initiate, for example, airfield management requests or otherwise facilitate airfield management performed by the ATC system 106 to support the processing workflows described herein. In some instances, the operator application 112 may be provided by or associated with an organization. In other instances, the operator application 112 may manage one or more inputs received from an operator via the communication interface 110. In some cases, the operator application 112, operating in conjunction with the communication interface 110, may be used by an operator to enter information (e.g., operator identification information) and to send such information to the platform 138 via the at least one network 140.

In some aspects, the operator application 112 may operate in tandem with the platform 138 and the databases 142, enabling the scheduling and authentication of one or more requests. For instance, an operator may use the operator application 112 to perform one or more functions related to airfield management.

In other aspects, the operator application 112 may communicate with the platform 138 over at least one communication link 104, transmit data associated with a scheduled request, and receive a corresponding response from the platform 138. Thereafter, via its GUI, the communication interface 110 may output the response (e.g., including explanations, visualization, etc.) to the operator. In some examples, the operator application 112 may facilitate communication between the communication interface 110, the platform 138, the airfield 114, and the databases 142.

In some cases, the operator application 112 may take the form of a different type of application capable of interacting with the platform 138, such as a lighting management application or other user-facing software that communicates data or requests to the computing devices 102. These alternative implementations are provided merely to illustrate that the described techniques are compatible with a wide range of application architectures and are not limited to a particular application domain.

In the example of FIG. 1, the computing device 102-d may include the ALCMS 128. In some aspects, the ALCMS 128 may operate based on the operating mode (e.g., primary mode, sub-system mode, etc.) of the platform 138. In one example, when the platform 138 operates in the sub-system mode, the ALCMS 128 may allow a user to directly control each light group individually, in which case the ALCMS 128 may be considered the primary device controlling the airfield 114. In another example, when the platform 138 operates in the sub-system mode, the airport environment 100 may seek to expand its airfield lighting capabilities to include solar-powered RF taxiway lights (e.g., 116) in areas where grid power is not available. The ALCMS 128 may manage existing wired circuits (e.g., 120) but may lack compatibility with the RF-enabled taxiway lights. Accordingly, to achieve full management of the airfield 114, an operator may use the platform 138 in conjunction with the ALCMS 128 to perform operations on the RF-enabled taxiway lights.

In the present disclosure, the computing device 102-c may include a user system 122 (e.g., a PALC), which may host a communication interface 124 and a user application 126. In some aspects, the communication interface 124 may provide fewer, the same, or more functionalities or services as compared to the communication interface 110. Similarly, the user application 126 may provide fewer, the same, or more functionalities or services as compared to the operator application 112.

In other aspects, the addition of the user system 122 to the airport environment 100 may enable the platform 138 and corresponding users (e.g., pilots) to manage one or more airfield components (e.g., 116, 118, etc.) without requiring specialized interfaces. In this manner, the user system 122 may provide an additional layer of operational flexibility to support varying airport requirements and to enhance safety during low-visibility conditions and after-hours operations. The platform 138 may recognize one or more signals from the user system 122, transmitted via MODBUS TCP/IP, and execute corresponding lighting adjustments at the airfield 114, thereby maintaining compliance with aviation safety regulations and ensuring a responsive airfield lighting environment. Further, the user system 122 may allow the platform 138 to extend its functionality to accommodate pilot-activated lighting controls, thereby enhancing the applicability of the platform 138 across diverse operational scenarios.

The computing device 102-b (e.g., a handheld airfield controller, a ruggedized portable controller, etc.) may include a user system 130, which may host a communication interface 132, a user application 134, and a wireless communication module 136. In some aspects, the communication interface 132 may provide fewer, the same, or more functionalities or services as compared to the communication interface 110. Similarly, the user application 134 may provide fewer, the same, or more functionalities or services as compared to the operator application 112.

The airport environment 100 may include one or more handheld controllers designed to allow remote operating personnel to interface with the platform 138 and, in certain cases, with the ALCMS 128. In some aspects, the user system 130 may support multiple user types with differing levels of authorization, with access privileges determined through role-based user authentication. For example, different classes of users-such as operations personnel, maintenance personnel, or supervisory users-may be granted distinct control, monitoring, or configuration permissions based on the operational requirements of the airfield 114. One or more handheld controllers may be assigned to a dedicated or limited group of authorized users, and controller operation may be transferable between connected communication interfaces (e.g., 110, 124, 132, etc.) to enable exclusive use by a single interface or shared use across multiple interfaces, as permitted by the applicable authorization policy.

As being a portable, user-facing device, the computing device 102-b may enable personnel to remotely control and monitor airfield lighting fixtures (e.g., 116). In addition to supporting primary operational control of the platform 138, handheld controllers may be deployed at various locations throughout the airport environment 100 to facilitate localized monitoring of airfield components (e.g., 116, 118, etc.). In some cases, the user system 130 may connect to the airport network (e.g., 140) through the wireless communication module 136, and may present status information, alarms, warnings, and event logs required by the airport environment 100 through the communication interface 132. Through this interface, the user system 130 may provide precise control over both wired and RF-controlled lighting fixtures (e.g., 116), along with comprehensive event, warning, and alarm logging, thereby enhancing situational awareness and operational responsiveness.

In some aspects, the user system 130 may be configured to operate individual lighting fixtures (e.g., 116), configure lighting groups, or adjust other aspects of the airfield 114 to provide operational flexibility. In one example, airport personnel may use the computing device 102-b to perform diagnostic checks and monitor the status of lighting fixtures across different sectors of the airfield 114. Through the communication interface 132, a user may view a graphical representation of the airfield 114 and select one or more specific lights (e.g., 116) or lighting groups for analysis. In another example, the computing device 102-b may be used to request temporary control of certain lighting functions from an ATC operator, after which the user system 130 may activate or deactivate a specific lighting circuit (e.g., part of the CCRs 120) undergoing maintenance or troubleshooting. Deployment of multiple handheld controllers may be scaled according to airport size, complexity, and redundancy requirements, ensuring that control and monitoring operations remain uninterrupted even in the event of a single-controller failure.

In other aspects, the user system 130 may communicate directly with the platform 138 via a wireless network (e.g., 140), allowing users (e.g., maintenance personnel) to connect to the platform 138 from locations proximate to their work area on the airfield 114. In one example, a technician attempting to locate a faulty runway visual range (RVR) sensor (e.g., 144) or RF-enabled lighting fixture (e.g., 116) may connect the computing device 102-b to the platform 138 to obtain real-time status and diagnostic information. In another example, during overnight maintenance operations, a technician may switch a mode of the communication interface 132 from a "view-only" mode to a "control" mode to test newly installed lighting fixtures (e.g., 116), adjust intensity levels, or verify proper operation without accessing or contacting the ATC system 106. Further, the user system 130 may support airfield configuration and alarm management functions, allowing operators to create or modify runway, taxiway, and approach lighting layouts using the communication interface 132, which models the current airfield configuration.

In some instances, the wireless communication module 136 may be designed to direct radio-based control of one or more light groups. The module 136 may include RF and/or GPS antenna operating, for example, in the 2.4 gigahertz (GHz) band. To ensure improved RF performance and reduce communication disturbances, the antenna may be mounted on an extendable mast and positioned to reduce obstructions. Communication may be supported through multiple modalities, including Wi-Fi hotspot connectivity (e.g., IEEE 802.11) over TCP/IP, wired LAN connections, or RF mesh networking at 2.4 GHz, configurable based on the selected RF chipset hosted by the module 136. In other instances, RF communication with lighting fixtures (e.g., 116) may be encrypted (e.g., using 128-bit encryption) and may operate on a predefined channel and frequency to ensure secure and reliable control.

As indicated above, using an RF mesh networking architecture, the computing device 102-b may communicate directly with individual airfield lighting fixtures or lighting groups (e.g., 116), enabling manual activation or deactivation of lights from the airfield 114 without reliance on a centralized control system (e.g., 128, 138, etc.). This capability may allow users to control lighting assets directly, via the communication interface 132, when the platform 138 is unavailable or operating in a limited capacity, thereby enhancing system resilience. Further, the computing device 102-b may operate as a standalone control unit, as a backup to the platform 138, or in conjunction with the platform 138 in either the primary mode or the sub-system mode.

The computing device 102-b may be fully portable and may operate using an internal battery, enabling deployment anywhere on the airfield 114 without external power sources. Additionally, the computing device 102-b may be designed to withstand harsh environmental conditions typical of airfield environments, including exposure to dust, moisture, and temperature extremes, ensuring reliable operation across a wide range of operational scenarios.

One of ordinary skill in the art should appreciate that each of the communication interface 110, the operator application 112, the ALCMS 128, the user system 122, and the user system 130 may perform other functionalities (by itself or in conjunction with other computing devices) without departing from the scope of the present disclosure. Each of the communication interface 110, the operator application 112, the ALCMS 128, the user system 122, and the user system 130 may be implemented using hardware (e.g., any number of integrated circuits for processing computer-readable instructions), software (e.g., a computer program executing on the underlying hardware of a computing device 102), or any combination thereof.

The airfield 114 may represent any aviation operating area that includes one or more runways, taxiways, approach areas, or landing surfaces used to support aircraft and/or rotary-wing operations. In some aspects, the airfield 114 may correspond to a general aviation airport, a regional or smaller airport, a remote or unmanned airfield, or other aviation facility having limited infrastructure, fewer lighting fixtures, and simplified operational requirements relative to large commercial hubs. The airfield 114 may include a single runway or multiple runways and may be configured to support fixed-wing aircraft, rotary-wing aircraft, or a combination thereof. In some aspects, the airfield 114 may further include one or more helipads, heliports, or helicopter landing areas, along with associated lighting and visual guidance systems.

In other aspects, the airfield 114 may be characterized by a need for basic control and monitoring functionality, intuitive configuration tools, and simplified mapping and layout capabilities that allow users to create, modify, and visualize an operational representation of the airfield 114. For example, operators may define an approximate or schematic layout of runways, taxiways, approach lighting, and helipad lighting using communication interfaces (e.g., 110, 124, 132, etc.), without having detailed engineering drawings or complex configuration processes. As will be understood by those skilled in the art, the term "airfield" is not limited to the above and may also encompass larger or more complex airport environments, including international airports, where similar control, monitoring, or integration techniques may be applied.

In some cases, the airfield 114 may include a set of lights 116 (e.g., light nodes, light fixtures, lanterns, beacons, light-emitting diode (LED) lights, etc.), a set of photocells 118, a set of CCRs 120, and a set of sensors 144. In the present disclosure, the set of lights 116 may include, for example (but not limited to): solar-powered lighting fixtures, runway edge lights, taxiway lights, stop bar lights, approach lights, wireless or RF-controlled lighting fixtures, solar-powered RF-enabled lighting fixtures, wired lights, touchdown lights, perimeter lights, both wired and solar-powered lighting fixtures, helipad floodlights, stand-alone steady burning lights

(SSBLs), precision approach path indicators (PAPIs), or the like. In other cases, each light of the set of lights 116 may be identified by its identifier number (e.g., its MAC address) and may be controlled at least by the platform 138 or the computing device 102-b.

In some aspects, RF-controlled lighting fixtures may include, for example (but not limited to): an RF antenna (e.g., for bi-directional RF communications for enhanced control and monitoring), a GPS antenna (e.g., provided in the form of a GNSS antenna), an LED control board, a battery, a solar panel, a controller, or the like. In other aspects, solar-powered lighting fixtures may improve the resilience of the airfield 114 (e.g., the airfield lighting system) by reducing dependency on grid power and mitigating the effects of power outages or infrastructure failures. In some cases, the set of lights 116 may be configured as one or more nodes within a LAN topology or a mesh network (e.g., 140). The mesh network may relay data to the set of lights 116, communicating instructions from, for example, the platform 138 over Modbus TCP/IP.

In one example, a runway edge light (e.g., 116) may be a portable, self-contained, LED-based light fixture positioned along the edges of a runway. The fixture may produce a steady light output that is synchronized with other runway lights within the airfield 114 to provide a parallel lighting reference to the runway centerline. In some aspects, the runway edge light may provide medium-intensity runway lighting capabilities with both visible and near-infrared (NIR) output and may be operated using solar power (e.g., without cabling). In other aspects, the runway edge light 116 may receive signals to switch between visible and IR modes and to adjust intensity levels.

In another example, a stop bar light (e.g., 116) may be a unidirectional fixture that is deployed in pairs, with one light positioned on each side of a taxiway. In some aspects, the illuminated side of the stop bar light may be identified by a band (e.g., a red and white band) at the base of the light head. This design may allow the light to be oriented such that the steady burning red section is directed toward the taxiway, thereby reducing the chance of an accidental aircraft entry onto an active runway.

In another example, a solar-powered light (e.g., 116) may be designed to track the sun and operate reliably in low-sunlight conditions. In some aspects, the light may include one or more solar modules incorporated into its lens, in which the solar modules may convert sunlight into electrical current used to charge an internal battery. The battery may then provide power to operate the light during nighttime conditions.

In another example, a PAPI (e.g., 116) may be a self-contained, LED-based unit designed for a range of aviation applications, including permanent approach lighting as well as expeditionary and tactical airfield operations. The PAPI may be installed alongside a runway to provide users (e.g., pilots) with a visual indication of the aircraft's position relative to the correct glide path. In some aspects, the PAPI may be controlled via RF signals or by CCR current levels through the platform 138 and/or the computing device 102-c. Further, the PAPI may support visual and IR operational states within the same optic and may be switchable by operators to allow pilots to identify approach slope information. In some cases, the PAPI may be powered by CCR current and solar power and may include a battery box assembly (BBA) that houses communication and control power components, such as batteries, a CCR power supply, and a solar charger.

In another example, an SSBL (e.g., 116) may be a portable, self-contained, LED-based fixture used within the airfield 114 to provide pilots with visual alignment with the runway. The fixture may produce a steady, medium-intensity beam (e.g., white light) generated by an LED array. Further, the SSBL may be controlled either manually via external switches or remotely through the platform 138 and/or the computing device 102-b. The SSBL may be powered by CCR current and auxiliary solar power and may include an integrated battery system with solar charging. In some aspects, the SSBL may be operated in a visible mode or in a NIR mode that is visible only to observers using night-vision goggles.

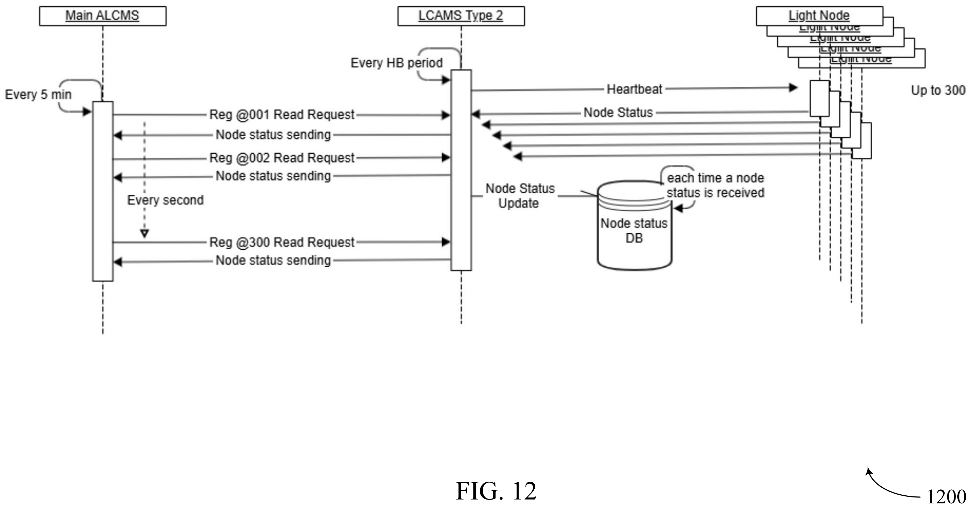

In the present disclosure, each light of the set of lights 116 may transmit its internal status to the platform 138 during every heartbeat period (e.g., every 220 seconds, or any other period), and the platform 138 may refresh the status of each light at least once per heartbeat period (e.g., upon receipt of the corresponding status) *(see* FIG. 12).

In some aspects, the set of lights 116 may be organized into one or more light groups, with each light group including one or more lighting fixtures. By default, each light type may be assigned a distinct light group identifier to enable rapid and intuitive control from the platform 138 and/or the computing device 102-b. This grouping arrangement may allow operators to efficiently manage lighting fixtures based on functional classification, location, or operational purpose, while maintaining flexibility to reconfigure group assignments as airfield requirements evolve.

In other aspects, each light group may be controlled independently of other light groups, and the platform 138 may be designed to process and enforce a received light group control command only when the requested command differs from the current operational state of the corresponding light group. If a received command (e.g., via the communication interface 210 of FIG. 2) matches the existing light group status, the platform 138 may disregard the command to avoid unnecessary command execution or network traffic. Upon execution of a valid light group control command, the platform 138 may update and publish the corresponding light group status within a defined update interval-such as on the order of one second-thereby providing near real-time feedback to connected monitoring and control system (e.g., 106, 122, 130, etc.).

In some cases, light group control may support multiple command types, including intensity-step commands, operation-mode commands, and LED-bank commands. An intensity-step command may specify a beam-intensity level that is applied uniformly to all lighting fixtures (e.g., 116) within a given light group. In other cases, a light group may be designed to support a predefined number of intensity steps, such as a one-step configuration (e.g., 0/1), a three-step configuration (e.g., 0/1/2/3), or a five-step configuration (e.g., 0/1/2/3/4/5), where the highest step in each configuration may represent a maximum (e.g., 100%) intensity output. In some aspects, an operation-mode command may define a physical or operational state for all lights in the light group, such as a standby state or an always-on state. Further, an LED-bank command may define a beam or emission mode for all lights within the light group, including, for example, visible-only operation, night-vision goggle or IR-only operation, combined visible and night-vision goggle operation, or no emission.

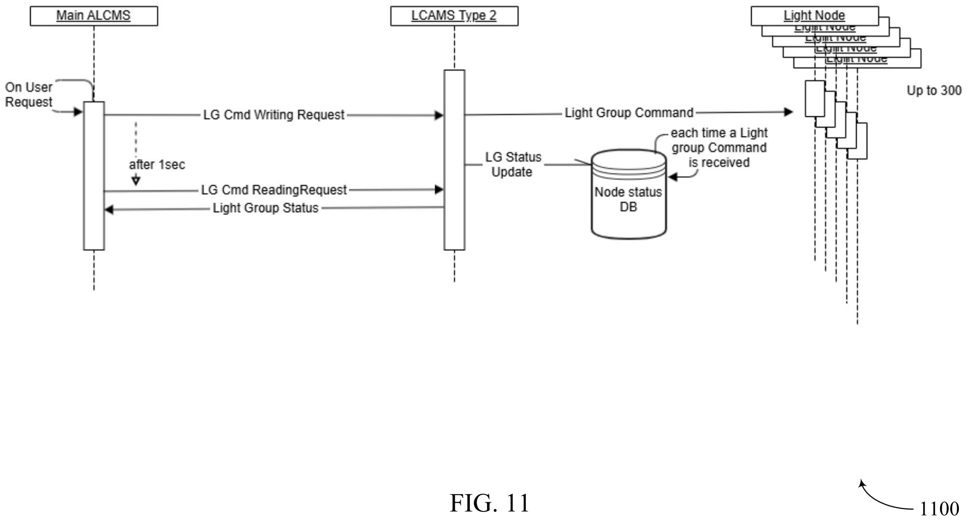

Through these command types, the platform 138 may enable consistent and synchronized control of multiple lighting fixtures (e.g., 116) within a light group while preserving fine-grained configurability *(see* FIG. 11). In some aspects, light group control may be initiated from one or more authorized communication interfaces (e.g., 110, 124, 132, etc.) and may be applied uniformly across the corresponding lighting fixtures. This light group abstraction may simplify operational workflows, reduce operator burden, and support scalable airfield lighting management across airfields of varying size and complexity.

In the present disclosure, the engine (e.g., 204, FIG. 2) of the platform 138 may be designed to perform real-time fault evaluation and status determination for one or more light groups based on a group configuration and status information received from associated lighting fixtures (e.g., 116). The engine may continuously or periodically receive light-level status data *(see* FIG. 12), including operational state, communication status, and fault indicators, and may compute light group level warnings and alarms by aggregating such light-level information in accordance with predefined thresholds. These computations may be performed in real-time or near real-time, enabling timely detection of abnormal conditions affecting one or more light groups.

In some aspects, a corresponding system (e.g., 106, 122, 130, etc.), via its communication interface (e.g., 110, 124, 132, etc.), may issue periodic read or polling requests to the platform 138 at defined intervals (e.g., every five minutes) when monitoring data is required. Such polling intervals may be selected to remain consistent with light fixture status update rates, thereby ensuring that the platform 138 maintains an up-to-date view of light group operational status, warning conditions, and alarm states without generating excessive communication overhead.

In other aspects, the engine (e.g., 204, FIG. 2) of the platform 138 may be designed to evaluate multiple fault types at the light group level by comparing the number of lights reporting a given fault condition against configurable warning thresholds and alarm thresholds defined for each light group. In one example, a light warning condition may be raised when the number of lights within a light group reporting a light-related fault exceeds a corresponding warning threshold for that group. In another example, a light alarm condition may be raised when the number of lights reporting the light-related fault exceeds a corresponding alarm threshold for the same light group. In another example, an RF-communication warning may be generated when the number of lights experiencing RF-communication faults exceeds a corresponding warning threshold.

Additional fault categories may include low-battery conditions, particularly for solar-powered or battery-backed lighting fixtures (e.g., 116). In such cases, a low-battery warning may be raised when the number of lights reporting a low-battery condition exceeds a corresponding warning threshold for the light group, while a low-battery alarm may be raised when the number of lights reporting the condition exceeds a corresponding alarm threshold. By distinguishing between warning-level and alarm-level conditions, the platform 138 may enable fault reporting that allows operators to respond proactively to emerging issues while prioritizing more severe conditions.

Upon determining that a warning or alarm condition exists for a given light group, the engine (e.g., 204, FIG. 2) of the platform 138 may update the corresponding light group status indicators and make this information available to connected systems (e.g., 106, 122, 128, 130, etc.). In some aspects, status updates may be propagated within a defined update interval (e.g., on the order of one second), thereby ensuring that fault conditions are reflected promptly across the airport environment 100. This light group level fault management approach may enable scalable monitoring of airfield lighting fixtures (e.g., 116) by abstracting light-level fault complexity into actionable group-level warnings and alarms, improving situational awareness, reducing operator burden, and supporting timely maintenance and corrective actions.

In the present disclosure, the platform 138 may support photocell-based dusk-and-dawn management to enable automated control of airfield lighting intensity based on ambient light conditions. To this end, the platform 138 may employ the set of photocells 118 (e.g., photosensitive switches) to automatically adjust lighting operation in accordance with predefined thresholds. Such automated intensity control may align with international airfield monitoring and lighting control standards by enabling consistent, repeatable transitions between day and night operating modes without manual intervention. In some aspects, the platform 138 may utilize signals received from the set of photocells 118 to control airport lighting during periods when the ATC system 106 is unavailable. Based on photocell input, the platform 138 may determine when to activate, deactivate, or modify lighting intensity levels across one or more light groups, thereby supporting safe and energy-efficient airfield operations while reducing reliance on continuous operator supervision.

In some cases, the set of CCRs 120 may be associated with wired lighting circuits to provide power supply, control, and monitoring functionality for one or more components (e.g., 116, 118, 144, etc.) of the airfield 114. For example, a lighting fixture (e.g., 116) may correspond to a physical lighting device or associated equipment controlled through a wired network and/or an RF network, while a corresponding CCR supplies regulated current to one or more light loops and enables centralized monitoring of circuit status and operating conditions. In other cases, the platform 138 may be designed to communicate with the set of CCRs 120 to manage power delivery, execute lighting control commands, and monitor operational parameters of wired lighting circuits. This coordinated communication may enable integrated operation between wired lighting fixtures and RF-enabled lighting fixtures within the airfield 114, while preserving compatibility with existing airfield electrical infrastructure.

In some aspects, the set of CCRs 120 may be implemented as multi-step CCRs (e.g., ten-step CCRs, eleven-step CCRs, etc.), which provide finer granularity in current-level adjustment relative to conventional step-based regulators. These additional intensity steps may enable more precise modulation of lighting output across varying operational conditions, including changes in weather, runway visibility, or operational mode. In contrast to traditional CCR implementations that use current steps solely to adjust light intensity, the set of lights 116 may interpret individual CCR steps as control signals that influence not only intensity but also operational modes and load behavior. For example, different CCR steps may be mapped to distinct lighting states, such as IR-only emission at a first step, visible light emission at an intermediate step, and high-intensity visible operation at a higher step, thereby effectively partitioning the CCR current range into a greater number of control states than is traditionally available.

To enable interoperability with existing CCR-based airfield power systems-particularly where low-power LED lighting fixtures are connected to circuits designed for higher electrical loads-the airfield 114 may incorporate a burden circuit or equivalent load-handling mechanism. In some aspects, the burden circuit may be configured to present an electrical load sufficient to satisfy CCR operating requirements while translating CCR output characteristics into control and power signals suitable for low-power lighting fixtures (e.g., 116). Through this mechanism, the platform 138 may maintain proper CCR operation while enabling control of lighting features beyond conventional high-medium-low intensity control. By combining multi-step CCRs, burden circuitry, and platform-level control logic, the platform 138 may enable granular, bidirectional interaction with the set of CCRs 120 (or the CCR infrastructure). This approach may support refined intensity transitions, improved dimming performance, dynamic handling of load variations, enhanced fault tolerance, extended light lifespan, and expanded use of CCR signaling for operational control, thereby advancing CCR-based airfield lighting beyond traditional limitations.

In some examples, the platform 138 may be designed to obtain RVR information from the set of sensors 144 (e.g., RVR sensors) positioned on, proximate to, or otherwise associated with the airfield 114. The platform 138 may obtain such RVR information through a direct interface with the set of sensors 144 or, in some implementations, through manual data entry performed by an authorized user, thereby enabling compatibility with airfields having varying levels of sensor infrastructure. In other examples, the set of sensors 144 may be operative to measure prevailing visibility conditions along a runway and to generate sensor data indicative of the measured runway visibility. Each sensor of the set of sensors 144 may generate respective data outputs that may vary in format, resolution, or reporting interval based on manufacturer specifications or deployment configuration.

In some aspects, sensor data generated by the set of sensors 144 may be communicated to the platform 138 and stored within one or more data repositories (e.g., 142) for real-time processing, historical trend analysis, or audit and compliance purposes. Based on the received or manually entered RVR information, the platform 138 may automatically regulate lighting intensity levels for one or more light groups in accordance with predetermined visibility thresholds and applicable aviation regulatory requirements. In this manner, variations in measured or manually entered RVR values may be algorithmically correlated with corresponding lighting intensity steps, thereby enabling consistent, repeatable, and regulation-compliant adjustments to airfield lighting in response to changing weather or visibility conditions while maintaining operational flexibility across the airport environment 100.

In the present disclosure, all, or a portion, of the components of the airport environment 100 may be operably connected to each other or other entities via any combination of wired or wireless connections (e.g., 104). In one example, the aforementioned components may be operably connected, in part, via the at least one network 140. Further, all, or a portion, of the components of the airport environment 100 may interact with one another using any combination of wired or wireless communication protocols.

In some examples, the one or more networks 140 may be at least one LAN, at least one WAN, or other types of networks, supporting protocols like TCP/IP over Ethernet. In some instances, the one or more networks 140 may be a cloud network. The one or more communication networks 140 may serve as a system hub, providing computational resources and storage capabilities. The at least one network 140 may include resources to manage and deliver computing services over the Internet or other communication forms. The at least one network 140 may be executed within or as a virtual machine (VM) or a virtual server that may be managed in a cloud-based computing environment. Also, the application(s) may be located on one or more virtual server(s) running in a cloud-based computing environment rather than being tied to one or more specific physical network computing devices. For example, the application(s) may be running in one or more VMs. In some examples, the at least one network 140 may include elements such as data centers, virtualized resources, cloud services, and security tools. In some aspects, the at least one network 140 may utilize data centers that also host servers capable of processing, storing, and managing network traffic, allowing centralized control without on-site hardware.

In some examples, the one or more networks 140 may include an Automatic Data Processing (ADP) device coupled to a plurality of server devices that may host a plurality of databases and a plurality of client or user devices via the network 140. The ADP device may store one or more applications that can include executable instructions that, when executed by the ADP device, cause the ADP device to perform desired actions, such as to transmit, receive, or otherwise process network messages, for example, and to perform other actions described and illustrated herein with reference to the figures. The ADP may work alongside the platform 138 for managing the execution of various tasks. The applications may be implemented as modules or components of other applications. Further, the applications may be implemented as operating system extensions, modules, plugins, or the like.

In the present disclosure, the at least one network 140 may be configured to facilitate monitoring and management of airfield operations through a secure and reliable TCP/IP communication framework, thereby supporting both on-site and remote connectivity. In some cases, the network 140 may provide LAN communication across the airfield 114 as well as WAN connectivity that enables authorized personnel to activate, control, and monitor airfield lighting fixtures (e.g., 116) from remote locations, where permitted. Such connectivity may enhance operational awareness, reduce response times, and improve overall system availability, particularly for remote or unmanned airfields.

In some aspects, the network 140 may additionally support alarm and event monitoring through satellite-based communication channels, such as Iridium SBD or other suitable satellite networks. In this manner, fault notifications, light status updates, and safety alerts may be transmitted to the platform 138 even when terrestrial communication infrastructure is unavailable, unreliable, or otherwise degraded. The inclusion of satellite-based communication capabilities may enhance operational safety and regulatory compliance by ensuring continuous monitoring and reporting for airfields operating in remote or infrastructure-limited environments.

In other aspects, the platform 138 and other components of the airport environment 100 may be communicatively coupled through one or more Ethernet switches, one or more fiber-optic cables, copper conductors, wireless Ethernet links, or any combination thereof. The airport environment 100 may employ a dedicated communication network designed for the platform 138, thereby interconnecting the platform 138 with controlled and monitored airfield equipment, including lighting fixtures (e.g., 116), CCRs (e.g., 120), sensors (e.g., 144), and photocells (e.g., 118). The availability of multiple transmission media-ranging from hardwired and fiber-optic connections to modern wireless technologies, including MODBUS TCP/IP over Ethernet-may allow the network 140 to be tailored to the infrastructure and operational requirements of the airport environment 100 while maintaining robustness, scalability, and reliable system performance.

In the present disclosure, the dedicated network may interconnect airport computing devices (e.g., 102) and components to form a cohesive architecture that improves the efficiency, reliability, and fault tolerance of the platform 138 to manage airfield operations. In at least this way, the network 140 may provide resilience against multi-point failures, thereby supporting compliance with regulatory requirements related to redundancy and operational continuity. The platform 138 may further be designed to interface with external devices and existing airport systems (e.g., 128) through MODBUS TCP/IP communication implemented via one or more Ethernet switches, enabling control and monitoring of additional airfield equipment without reliance on non-standard interfaces. MODBUS-enabled data exchange over TCP/IP across copper, fiber-optic, or wireless Ethernet links may provide robust, deterministic communication and ensure compatibility with one or more aviation administration requirements.

In some aspects, the at least one network 140 may incorporate appropriate subnet masks, gateway parameters, and traffic-segmentation techniques to support secure and efficient data transmission across the airport environment 100. The dedicated network for the platform 138 may enhance security and reduce network congestion by isolating safety control and monitoring traffic from other airport components. This dedicated networking approach may facilitate real-time or near real-time communication among platform components, enabling rapid adjustment of lighting and monitoring functions in response to changing environmental or operational conditions.

In other aspects, the network 140 may further incorporate a self-healing wireless mesh topology that supports communication among distributed airfield components using IEEE 802.15.4 radio technology operating, for example, in the 2.4 GHz band. In some cases, communication between airfield components (e.g., 116, 118, etc.) and the platform 138 may be facilitated by one or more radio modules operating under protocols such as DigiMesh and OpenThread, enabling each component to communicate with multiple other components in a decentralized manner. This mesh-based architecture may improve reliability, redundancy, and coverage by providing alternate communication paths when individual components or links become unavailable. As indicated above, the network 140 may be designed to support and integrate both DigiMesh and OpenThread protocols within a common 802.15.4 framework, thereby providing a flexible and future-ready communication layer.

By employing a combination of standard TCP/IP networking, MODBUS TCP/IP communication, and IEEE 802.15.4-based mesh technologies, the platform 138 may support efficient, low-power, and reliable data exchange across distributed wired, RF-enabled, and/or solar-powered lighting fixtures (e.g., 116). This hybrid networking approach may allow incremental system expansion or modification as airfield requirements evolve, without necessitating wholesale replacement of existing infrastructure. As indicated above, the network 140 may include hardwired connections, fiber-optic cabling, wireless Ethernet links, RF mesh links, satellite communication links, or any combination thereof, thereby providing a resilient and adaptable communication foundation for airfield lighting management operations.

Further, different computing devices may have different computational capabilities. For example, the computing device 102-e may have 16 gigabytes (GB) of dynamic random-access memory (DRAM) and a central processing unit (CPU) with 16 cores, whereas the computing device 102-b may have 8 GB of persistent memory and a CPU with 8 cores. Other different computational capabilities of computing devices not listed above may be considered without departing from the scope of the present disclosure.

While FIG. 1 shows a specific configuration of the airport environment 100, other configurations may be used without departing from the scope of the present disclosure. For example, although the one or more computing devices 102 and the databases 142 are shown to be operatively connected through a communication network (e.g., 140), the one or more computing devices 102 and the databases 142 may be directly connected (e.g., without an intervening communication network).

Further, the functioning of the one or more computing devices 102 and the databases 142 may not be dependent on the functioning or existence of other components (e.g., devices) in the airport environment 100. Rather, the one or more computing devices 102 and the databases 142 may function independently and perform operations locally. Accordingly, the systems and methods disclosed herein may not be limited to the configuration of components shown in FIG. 1.

The airport environment 100 may be a distributed environment (e.g., a data processing environment) and may deliver at least computing power (e.g., real-time (on the order of milliseconds or less) network monitoring, server virtualization, etc.), storage capacity (e.g., data backup), and data protection (e.g., software-defined data protection, disaster recovery, etc.) as a service to users of the one or more computing devices 102. The airport environment 100 may represent a comprehensive middleware layer executing on the one or more computing devices 102 that supports application and storage environments.

A user may be automatically directed to a login screen of a computing device (e.g., 102-b) when the user is connected to the computing device. Once the login screen of the computing device is displayed, the user may enter credentials (e.g., a username, a password, etc.) on the login screen. The login screen may be a GUI, generated by a visualization module (e.g., 132) of the computing device. The visualization module may be implemented using hardware (e.g., any number of integrated circuits for processing computer-readable instructions), software (e.g., a software program), or any combination thereof.

A GUI may be displayed on a display of a computing device (e.g., 102-b) using functionalities of a display engine, in which the display engine is operatively connected to the computing device. The display engine may be implemented using hardware, software, or any combination thereof. The login screen may be displayed in any visual format that would allow the user to easily comprehend (e.g., read and parse) the listed information.

Some of the computing devices 102, such as the computing device 102-e, may be a server/node and include (i) a chassis (e.g., a mechanical structure, a rack-mountable enclosure, etc.) designed to house one or more servers (or blades) and their components and (ii) any instrumentality or aggregate of instrumentalities operable to compute, classify, process, transmit, receive, retrieve, originate, switch, store, display, manifest, detect, record, reproduce, handle, or utilize any form of data for business, management, entertainment, or other purposes.

As described above, information associated with a hardware resource set (e.g., including at least computing resource-related parameters) may specify, for example (but not limited to): a configurable CPU, a configurable memory option, a configurable graphics processing unit (GPU) option, a configurable data processing unit (DPU) option, a configurable storage space option, a configurable storage input/output (I/O) option, a network resource related template, a DPU related template, a GPU related template, a storage space related template, a CPU related template, a storage mode configuration, or the like.

Additionally, while illustrated as being stored in one of the databases 142, any of the aforementioned data structures may be stored in different locations (e.g., in persistent storage of one or more computing devices) or spanned across any number of computing devices 102 without departing from the scope of the present disclosure.

In the present disclosure, each computing device and each component of the airfield 114 may be utilized individually or in combination to provide the described functionalities. These functionalities may be invoked using any communication model including, for example, message passing, state sharing, memory sharing, or the like.

Additionally, in some examples, elements within the airport environment 100 may include components such as processors, memory, displays, input devices, media readers, network interfaces, and output devices. The processors may be designed to execute software instructions for performing functions described herein, in addition to other functions, such as receiving queries, analyzing the queries, retrieving resolutions, and displaying results.

As discussed above, the airport environment 100 may include computational and storage capabilities, such as processing power, memory, networking, and storage required for the computational success of one or more computing programs. In some instances, the airport environment 100 may integrate cloud computing, where applications may access large amounts of computing power on demand, allowing them to scale resources up or down based on computational and storage needs.

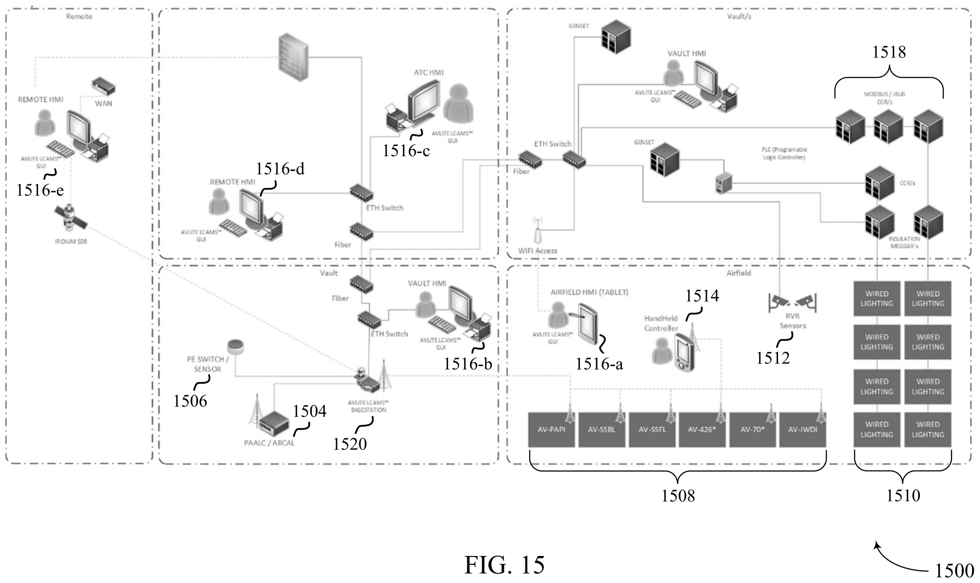

While FIG. 1 shows one example configuration of components, other configurations may be used without departing from the scope of the present disclosure. For example, alternative aspects or configurations of the airport environment 100 are described below with reference to FIGs. 15-17.

FIG. 2 is a block diagram 200 of an example lighting management platform 202, in accordance with one or more aspects of the present disclosure. In some cases, the platform 202 may be implemented as part of one or more processors. The platform 202 may be provided in the form of a single module or separate modules, as described within FIG. 1. In some instances, different components of the platform 202 may be located on the same, different, or additional computing devices (e.g., 102, FIG. 1). Further, at least some of the functionalities of the platform 202 may be located within a network (e.g., 140, FIG. 1), such as on the cloud.

The lighting management platform 202 may be an example of, or include one or more aspects of, the platform 138 of FIG. 1. The platform 202 is for explanatory purposes only and is not intended to limit the scope of the present disclosure. FIG. 2 may provide oversight on the components of the platform 202 that are designed to manage the execution of various workloads or tasks.

In the present disclosure, the lighting management platform 202 may include at least an engine 204, an administrator system 208, and a wireless communication module 214, among other modules or components. In some aspects, the engine 204 may include a set of models 206. In other aspects, the platform 202 may be designed to deliver enhanced safety, monitoring, and operational efficiency while reducing the need for extensive infrastructure modifications, thereby making airfield lighting control capabilities accessible to airfields (e.g., 114, FIG. 1) that previously could not support such functionality.

In some cases, the engine 204 may be designed to control and monitor airfield lighting systems (e.g., 116, FIG. 1) and associated airfield components and may scale efficiently across a wide range of airfield sizes and configurations, from small or unmanned airstrips to large, multi-runway airport facilities. The engine 204 may function as a centralized control and decision-making component of the platform 202, executing lighting control logic, monitoring the status of the airfield components, and coordinating communications among wired, wireless, and/or RF-enabled lighting fixtures.

In other cases, the engine 204 may be designed to interface with external computing devices using standard communication protocols, including MODBUS TCP/IP, without requiring custom protocol extensions. In some aspects, the engine 204 may employ an internal model or software layer (e.g., 206) that operates as a protocol translation and orchestration layer, serving as a gateway between the engine's control logic and external communication protocols (e.g., MODBUS). Through this architecture, the engine 204 may utilize MODBUS in a non-traditional manner by interpreting MODBUS data within the context of its internal model, thereby enabling control behaviors that extend beyond basic register-level command execution. The engine 204 may further manage wired lighting circuits, wireless RF links, CCR integration, and airfield layout information generated by a runway builder capability implemented within the model.

In the present disclosure, the engine 204 may process pilot-initiated control inputs (e.g., one or more PALC commands, air-to-ground radio signals, ground-based radio signals, etc.) received through a corresponding computing device (e.g., 102-c, FIG. 1). The engine 204 may further combine such inputs with environmental signals (e.g., photocell or photoelectric (PE) cell inputs) to differentiate and reinterpret identical commands based on time-of-day conditions, such as daytime, twilight, or nighttime operation. For example, a single pilot-initiated command may trigger different lighting behaviors depending on ambient light levels, with the engine 204 selectively activating different lighting groups, intensity settings, or operational modes. This functionality may be enabled by the engine's internal model 206 and its discrete, group-level control over lighting fixtures (e.g., 116, FIG. 1), allowing the engine 204 to determine which lighting groups should respond, at what intensity, and under which operational mode for a given command context.

In some aspects, when the platform 202 operates in the primary mode, the engine 204 may limit automatic control of lighting fixtures (e.g., 116, FIG. 1) by external devices unless such actions are confirmed or mediated by the engine. These limitations may apply to automatic control changes initiated by RVR inputs, radio-based control signals, photocell inputs, or sunrise/sunset tables. However, the engine 204 may include provisions that allow operator-enabled acceptance and processing of inputs from photocells or air-to-ground radio systems. Further, the engine 204 may be capable of controlling CCRs and other airfield components using either internally supplied control power or externally supplied control power, depending on deployment.

In other aspects, the engine 204 may provide customizable, user-defined mapping and airfield configuration through the communication interface 210, enabling operators to create and modify airfield layouts, light group associations, and operational parameters directly through the interface. This capability may be useful for small- to medium-sized airfields with limited technical resources, as it simplifies configuration, reduces training requirements, and lowers integration complexity. The engine 204 may manage one or more airport components through an RF network (e.g., 140, FIG. 1), and may further provide an interface (e.g., 210) for user interaction, configuration, and monitoring of those components.

In some cases, the platform 202 may be designed for deployment in indoor or outdoor environments and may include one or more communication interfaces (e.g., 210, 214, etc.) for wired Ethernet, internal or external RF communications, PALC or PE-cell inputs, USB-C connections, or other interface types. In other cases, the engine 204 may manage both airfield control and monitoring functions, as well as user interactions, including applying configuration changes on demand and ensuring that connected airfield components maintain their intended functionality. Through its internal model (e.g., 206), the engine 204 may provide more secure and reliable control and monitoring of airfield lighting fixtures and related equipment, while supporting comprehensive event, fault, warning, and alarm logging consistent with aviation administration requirements. The engine 204 may further assist operators by providing rapid access to the location and status of lighting fixtures requiring maintenance, thereby simplifying troubleshooting and reducing operational downtime.

In some aspects, the wireless communication module 214 may include an RF repeater to enhance RF communications between the engine 204 and one or more lighting fixtures (e.g., 116, FIG. 1). The RF repeater may improve RF coverage and network reliability across the airfield (e.g., 114, FIG. 1), and, in the event of a loss of RF communication, the engine 204 may generate an alarm notification for presentation through the communication interface 210 to alert an operator. In other aspects, the RF repeater may be activated by the engine 204 as needed to improve network coverage in response to airfield layout, environmental conditions, or expansion of lighting fixtures.

In the present disclosure, the engine 204 may control remote sub-systems (e.g., 106, 122, 130, FIG. 1) via MODBUS TCP/IP while simultaneously controlling and monitoring lighting fixtures (e.g., 116, FIG. 1) through a mesh RF network (e.g., 140, FIG. 1). The engine 204 may process commands (e.g., lighting control commands) and status information at a light group level, while still receiving and evaluating status and fault information reported individually by each light fixture.

In some aspects, the engine 204 may further support a configurable soft-start control functionality for lighting fixtures (e.g., 116, FIG. 1). The soft-start feature may include both ramp-up and ramp-down control, enabling gradual adjustment of lighting intensity during activation and deactivation. Ramp-up control may progressively increase brightness to a desired level after circuit activation, while ramp-down control may decrease brightness in controlled steps prior to circuit shutdown. The timing interval between intensity adjustments may be configurable, allowing operators to tailor ramping behavior to specific operational or environmental requirements. This functionality may reduce thermal and electrical stress on lighting fixtures, thereby enhancing fixture longevity and overall operational reliability.

In other aspects, the engine 204 may be designed to ensure continued safe operation of airfield lighting in the event that a command may not be executed for a controllable element (e.g., 116, FIG. 1). Fail-safe behavior may be applied at either a system level or a component level and may enforce predefined default lighting operation when an ALCMS (e.g., 128, FIG. 1) or control interface failure occurs. In some cases, the engine 204 may ensure that airfield lighting remains in a fail-safe state as long as a corresponding CCR (e.g., 120, FIG. 1) has power. Local override of a fail-safe state may be permitted at the CCR by authorized personnel, and maintenance activities may be performed on portions of the CCR without altering the operational status of the lighting fixture. The fail-safe functionality may be adaptable to each CCR, regardless of whether control power is supplied internally or externally, thereby ensuring consistent safety behavior across varied deployment configurations.

In some instances, the engine 204 may receive or intercept a user's request (e.g., generated by the communication interface 210) before the request arrives at its targeted destination (e.g., 114, FIG. 1). The engine 204 may analyze (e.g., perform feature engineering) the request and its details in accordance with request validation rules or policies set by an administrator of the lighting management platform 202. Based on the analysis, the engine 204 may (i) determine whether the request is valid and (ii) if the request is determined to be valid, proceed with the subsequent steps of the related request.

In some examples, based on the analysis, the engine 204 may infer or identify whether, for example (but not limited to): the intercepted request is a valid request (e.g., the request has been sent by an authorized or trusted user, the request is an authentic request, etc.) or an invalid request (e.g., the request is related to a network attack initiated by a malicious sender), or the like. If the request is determined to be invalid (e.g., an abnormal request), the engine 204 may reject the request by taking preventive or proactive measures (e.g., sending a fake or simulated response to the malicious sender via the communication interface 210). In this manner, the engine 204 may ensure that unauthorized entities or users may not have access to airfield data and that the requested airfield management process may not be initiated until the request is validated.

In some cases, the engine 204 may concurrently continue providing services that support data protection, integrity, and availability within the airport environment (e.g., 100, FIG. 1), while the engine 204 is analyzing an intercepted request. For example, while analyzing an intercepted request or incoming network traffic, the engine 204 may intercept another request in parallel.

In some aspects, the engine 204 may ensure that data passed across its components are durably stored in its memory to retain the data for later use. The engine 204 may perform this level of data storage, for example (but not limited to): to allow auditing and debugging of airfield management workflows in case of failures or catastrophic events, to enable the data to be utilized in subsequent workflows, tasks, or jobs, or the like. Further, with respect to type-agnostic communication guarantees, the engine 204 may ensure that the models 206 operate in a multimodal manner (e.g., capable of processing text data, image data, video data, speech data, etc.). Based on this capability, data abstraction may be used to transfer arbitrary data types across the various components of the lighting management platform 202.

In other aspects, in order to allow auditing and debugging of airfield management workflows, the engine 204 may include functionality to at least (i) generate immutable logs capturing all activities within the lighting management platform 202, and (ii) based on (i), provide unalterable audit trails associated with the activities for security, troubleshooting, and compliance with aviation administration policies.

In the present disclosure, the engine 204 may interact with its environment, collect data, and reason to reach a predetermined goal, with little to no human interaction. The engine 204 may be defined by a software-based system capable of performing analysis or reasoning. More specifically, the engine 204 may employ the set of models 206 (e.g., linear models, non-linear models, etc.) to provide its functionalities (e.g., process and generate information in a multimodal fashion, perform autonomous task execution through perception (e.g., collecting, interpreting, and inferring input data from its environment) and decision-making, perform more secure user recognition and authorization, etc.) with multiple data types (e.g., structured data, semi-structured data, unstructured data, etc.). Further, the engine 204 may possess memory to store, recall, and use past interactions or learned information to guide future behavior and responses, thereby enabling itself to learn from events. However, in some aspects, the engine 204 may operate without persistent memory. In other aspects, the memory may include short-term memory (e.g., for managing recent or current information), long-term memory (e.g., for retaining persistent facts or patterns), episodic memory (e.g., for recalling specific past events), and semantic memory (e.g., for inferring general knowledge and concepts). Additionally, the engine 204 may or may not be connected to external systems via software integrations. Where such connections exist, the engine's 204 access to context-specific tools and APIs may extend the engine's capabilities in a certain area, allowing the engine to perform a greater level of complexity of various tasks.

As described above, the engine 204 may include a software-based system capable of performing analysis or reasoning, and possess a memory component to store, recall, and use past interactions or learned information to guide future behavior and responses. However, in other aspects, the engine 204 may operate without a memory component.

In some aspects, a model of the set of models 206 may function as the reasoning component of the engine 204, enabling interpretation of a user's request, determination of an appropriate sequence of actions, and generation of subgoals to guide the engine's operations. Through this model, the engine 204 may perform direct control and monitoring of lighting fixtures (e.g., 116, FIG. 1), configure lighting groups and intensity levels, manage alarms, and generate logs of activities, warnings, faults, and alarms. This reasoning capability may allow the engine 204 to translate high-level operator inputs into coordinated control behaviors while maintaining comprehensive visibility into the operational state of airfield components.

As described herein, each model 206 may be designed to generate responses based on user questions, prompts, provided context, a particular task, an image, a graph, any retrieved context, code snippets, structured data, time-series data, tabular information, geographical information, mathematical expressions, domain-specific terminology, or the like. Each model 206 may process inputs in various formats including text, images, audio transcriptions, JavaScript Object Notation (JSON) documents, eXtensible Markup Language (XML) documents, or combinations thereof. Further, each model 206 may generate outputs in forms such as natural language text, structured data, code, logical reasoning chains, summarizations, translations, creative content, or the like.

As described herein, each model 206 may be provided in the form of any computer program or application that is trained (or fine-tuned) on data (e.g., a massive training dataset including a cumulative total of three trillion tokens) and may learn to recognize patterns, identify relationships, or make classifications for data input to the set of models. Each model 206 may be able to perform many different types of functions, such as facilitating the development, organization, completion, and execution of tasks and requirements, including processing data. Each model 206 may perform these functions itself or may interface with one or more other applications or programs to perform the various functions.

One of ordinary skill in the art should appreciate that the engine 204 (and its components) may perform other functionalities (by itself or in conjunction with other computing devices) without departing from the scope of the present disclosure. The engine 204 may be implemented using hardware (e.g., any number of integrated circuits for processing computer-readable instructions), software (e.g., a computer program executing on the underlying hardware of a computing device), or any combination thereof.

The administrator system 208 may include the communication interface 210 and an administrator application 212. In some aspects, the communication interface 210 may provide fewer, the same, or more functionalities or services as compared to the communication interface 110 of FIG. 1. Similarly, the administrator application 212 may provide fewer, the same, or more functionalities or services as compared to the administrator application 112 of FIG. 1.

The communication interface 210 may be designed to facilitate user interaction with the engine 204 and associated airfield components (e.g., 116, FIG. 1). The communication interface 210 may enable operators to build, view, and modify an airfield layout, and the engine 204 may manage lighting fixtures based on a customizable layout received via the interface. Through this interface, operators may issue supervisory commands, acknowledgments, and configuration updates associated with airfield components, while also receiving lighting fixture status information, alarm conditions, and operational feedback. The user interaction management functionality of the interface 210 may further include user authentication, configuration management, system monitoring, and other operator-side controls, thereby ensuring that access to control functions is governed by appropriate authorization levels.

In some cases, the communication interface 210 may provide a visualization of an airfield layout, including one or more runways, taxiways, approaches, and associated lighting fixtures, allowing operators to monitor overall airfield usage and ensure appropriate lighting coverage for safe operations. In other cases, the interface 210 may display wired, RF-enabled, and/or solar-powered lighting fixtures (e.g., approach lights, touchdown lights, perimeter lights, taxiway lights, etc.) as well as other navigational aids. The interface 210 may further provide full control and visibility over helipad lighting fixtures (e.g., 116, FIG. 1), including approach lighting, touchdown and lift-off area (TLOF) lights, final approach and takeoff area (FATO) lights, perimeter lights, windsocks, helicopter approach path indicators (HAPI), and beacons. Helipad layout visualization within the interface 210 may enable operators to monitor helipad usage and lighting coverage, thereby enhancing safety and supporting compliance with aviation standards governing helicopter operations.

In some aspects, the communication interface 210 may include a runway builder capability that enables operators, airport personnel, distributors, or integrators to create and configure airfield layouts without reliance on a specialist system integrator. Using the runway builder, a user may define runway geometry-including length, width, designation, orientation, and associated features-and may assign lighting fixtures (e.g., 116, FIG. 1) to the defined layout using parameter-based inputs. The engine 204 may utilize these inputs to generate a schematic or representative airfield layout that conforms to known and regulated airfield design parameters (e.g., light fixture spacing, fixture quantity, placement of lighting types, etc.). This approach may lower the barrier to entry for smaller airfields with limited budgets or resources by allowing users to create an analogous, functional representation of their airfield-similar to sketching a layout on paper-directly within the interface 210, rather than commissioning bespoke engineering drawings or custom integration services.

In other aspects, the communication interface 210 may be designed for ease of use, allowing operators to rapidly adjust lighting configurations, monitor system status, and respond to changing conditions such as adverse weather or emergency scenarios. Selection of an execution mode may be permitted through confirmation provided via the interface 210 and may be subject to appropriate user credentials. The interface 210 may further allow operators to view current operational status and alarms for airfield components, issue lighting control commands, and monitor platform performance in real-time or near real-time, thereby improving operational response times and reducing the risk of operator error.

The communication interface 210 may be designed to directly integrate with an ALCMS (e.g., 128, FIG. 1) or other alternate control and monitoring equipment, thereby providing a common control and monitoring environment across heterogeneous lighting fixtures and sub-systems. By presenting consistent monitoring, fault-detection, and control behavior for wired, RF-enabled, and/or solar-powered lighting assets, the interface 210 may support broader adoption of different lighting technologies while maintaining regulatory monitoring requirements that have historically been difficult to satisfy for certain lighting fixture types. In this manner, the interface 210, in conjunction with the engine 204, may streamline configuration and deployment of lighting fixtures by enabling user-level mapping, customization, and airfield setup directly within the interface, thereby reducing integration complexity and enhancing overall usability.

In some aspects, the wireless communication module 214 may provide fewer, the same, or more functionalities or services as compared to the wireless communication module 136 of FIG. 1.

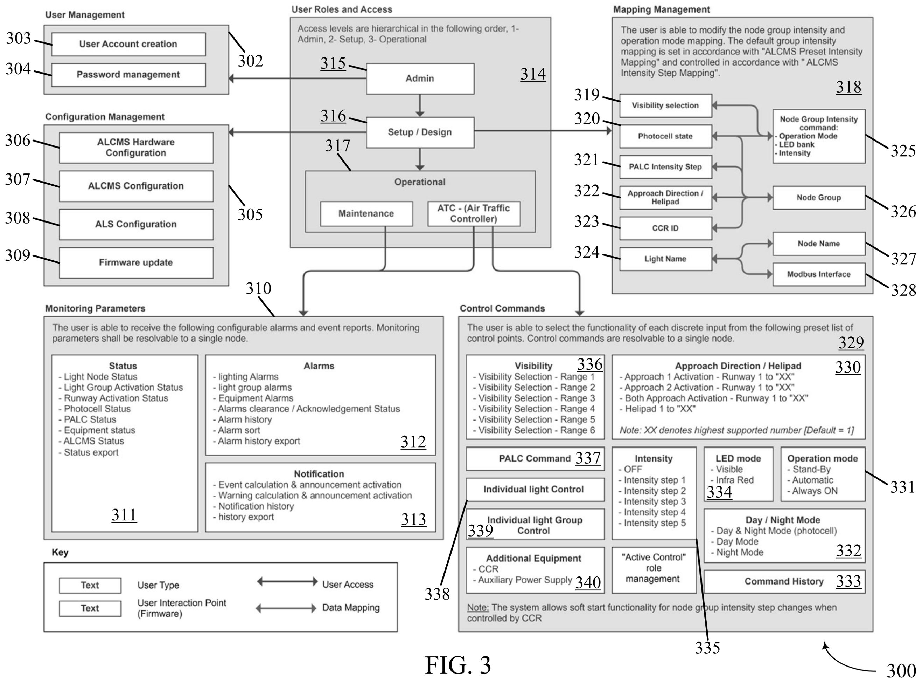

FIG. 3 is a schematic diagram 300 of an example communication interface, in accordance with one or more aspects of the present disclosure. The diagram 300 is for explanatory purposes only and is not intended to limit the scope of the present disclosure. The example communication interface may be an example of, or include one or more aspects of, the communication interface 210 of FIG. 2.

In some aspects, the example communication interface may be designed to enable configuration, monitoring, and control of airfield lighting fixtures (e.g., 116, FIG. 1). The interface may provide an interactive visual environment through which users (e.g., operators) may design an airfield layout, issue lighting control commands, monitor the status of airfield components, and manage alarms and system configuration, all without requiring bespoke system integration.

As shown in FIG. 3, the example communication interface may show a user management module 302 that provides access control to the lighting management platform (e.g., 202, FIG. 2). The user management module 302 may include an account creation and management functionality 303 and a password management functionality 304. A login screen may be presented when the interface is started or after a logout event, enabling an operator to authenticate using credentials or initiate a password reset. The user management module 302 may support role-based access and ensure that only authorized personnel may perform configuration, monitoring, and/or control operations.

The example communication interface may further show a configuration management module 305, which may enable system-level and airfield-level configurations. As illustrated, the configuration management module 305 may include a system (e.g., 138, FIG. 1) hardware configuration functionality 306, an ALCMS (e.g., 128, FIG. 1) configuration functionality 307, an airport lighting system (e.g., 116, FIG. 1) configuration functionality 308, and firmware update functionality 309. Using these configuration tools, an operator may configure platform parameters, define airfield lighting system behavior, associate lighting fixtures with logical groups, and deploy firmware updates to connected lighting fixtures and controllers.

In some aspects, the configuration management module 305 may support user-level mapping and airfield setup, allowing operators to create or modify at least runway, taxiway, and approach lighting configurations directly through the example interface. This capability may enable airfields, particularly smaller airfields with limited budgets and infrastructure, to perform system configuration without reliance on specialist system integrators.

As illustrated in FIG. 3, the example communication interface may show a role-based operational access module 314, providing an admin access functionality 315, a setup/design access functionality 316, and an operational access functionality 317. These access levels may determine which portions of the example interface are available to a given user. Administrative users may perform full configuration and system-level changes, setup/design users may build or modify airfield layouts, and operational users may monitor system status and issue permitted lighting control commands. This hierarchical access structure may ensure safe and controlled operation of the airfield lighting system.

The example communication interface may further show a monitoring module 310, which shows real-time or near real-time visibility into airfield status. The monitoring module may provide an airfield status monitoring functionality 311, an alarm management functionality 312, and a notification management functionality 313. Through these elements, the example interface may display the current operational status of airfield components, and present warnings, faults, alarms, and event reports related to those components. Operators may acknowledge alarms, silence notifications, and clear resolved alerts using the communication interface. Operators may further use the monitoring module 310 to resolve alarms, silence notifications, and clear status alerts.

As shown in FIG. 3, the example communication interface may show a mapping management module 318, which may enable detailed association between airfield layout elements and lighting control logic. In some aspects, the mapping management module 318 may provide a visibility selection functionality 319, a photocell state functionality 320, a PALC intensity step functionality 321, an approach direction functionality 322, a CCR identification functionality 323, a light identification functionality 324, a light node group intensity command functionality 325, a light node group identification functionality 326, a light node identification functionality 327, and a Modbus interface identification functionality 328.

The example communication interface may further show a control commands module 329, which may allow operators to issue lighting fixture control commands and manage lighting fixture behavior. The control commands module 329 may provide an approach direction control functionality 330 (e.g., for approach lighting), a visibility-based control functionality 336, a lighting fixture intensity control functionality 335, an LED mode selection functionality 334, a lighting fixture operation mode selection functionality 331, an illuminance mode control functionality 332, a command history tracking functionality 333, a PALC command functionality 337, an individual lighting fixture control functionality 338, an individual light group control functionality 339, and an additional equipment (e.g., CCRs, auxiliary power supplies, etc.) control functionality 340.

The example communication interface may enable operators to design, configure, monitor, and control an airfield (e.g., 114, FIG. 1). The example interface may present a comprehensive graphical representation of the airfield, including one or more runways, taxiways, approach areas, and helipads, together with associated lighting fixtures and navigational aids. Through the example interface, an operator may view an approximate or schematic layout of the airfield and select individual lighting fixtures or lighting groups for analysis, configuration, or control. The graphical layout may enable operators to monitor overall airfield usage and verify that appropriate lighting coverage is provided to support safe aircraft and helicopter operations.

In some aspects, the example communication interface may include a runway builder functionality that allows users to create and modify an airfield layout directly using the interface. Using drawing tools and parameter-based inputs, operators or users may define runway geometry, taxiway placement, approach lighting, and helipad layouts, including the positioning and association of lighting fixtures. The airfield builder may operate in real-time, providing visual feedback as the layout is constructed or modified. During layout creation, the example interface may display real-time status information for lighting fixtures, runways, helipads, and other aspects of the airfield, enabling operators to validate configuration decisions as they are made.

In other aspects, the example communication interface may further enable customizable, user-defined mapping and airfield configuration, allowing operators to associate lighting fixtures with light groups, define group identifiers, configure intensity-step behavior, and specify operational parameters directly through the interface. User interactions may include applying configuration changes on demand, canceling pending changes, or confirming updates for transmission to the relevant airfield components. Once confirmed, configuration changes may be propagated through an RF network or other communication paths and acknowledged by the components. This capability may allow the engine (e.g., 204, FIG. 2) to manage airfield lighting based on a customizable airfield layout received from the interface.

In some cases, the example communication interface may allow operators to adjust lighting intensity, select visible or IR operation, and manage lighting behavior based on environmental conditions such as day, twilight, or night. Using a small number of interface interactions, an operator may increase runway or taxiway lighting intensity, activate additional lighting systems, or respond to changing weather conditions or emergency scenarios.

In other cases, the example communication interface may support light group configuration and control, including configuration of light group membership, light group intensity settings, and soft-start time-delay parameters. Operators may set or modify parameters such as RF channel, RF network identifier, light group control settings, and group identifiers that denote numerical values assigned to each light group. The interface may include on-screen controls that allow users to cancel an action, revert a settings change, or confirm a configuration update. Visual indicators may be presented to display battery status, RF-connection signal strength, connection quality, current light group selection, screen brightness, and other contextual information relevant to airfield operation.

The example communication interface may further support user authentication and session management. A login screen may be presented when the interface is started or following a logout event, enabling an operator to access system controls using valid credentials or to initiate a password-reset process, if required. Authentication may ensure that configuration, control, and monitoring operations are restricted to authorized users and supports role-based access to different levels of system functionality.

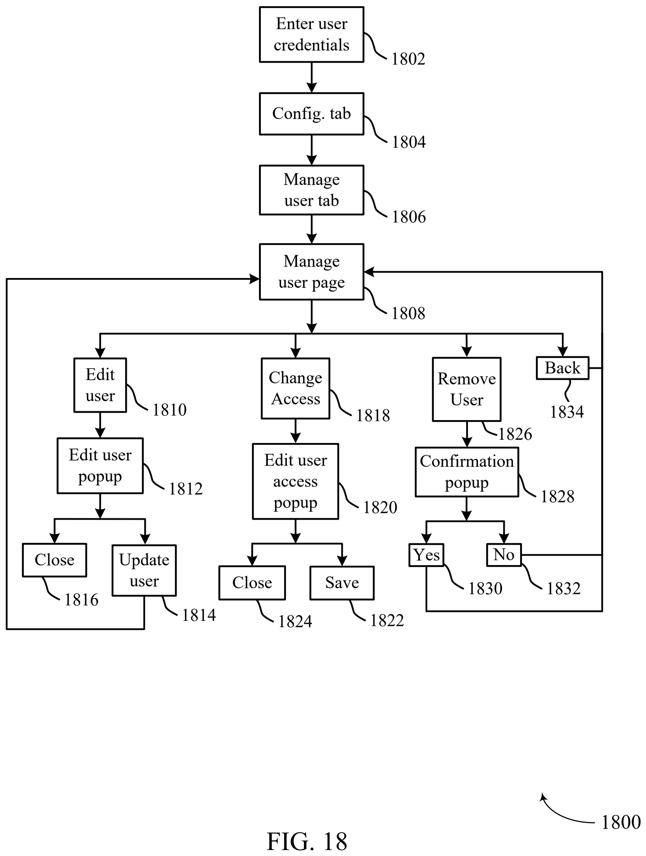

For example, the engine (e.g., 204, FIG. 2) may implement a user management process (*see* FIG. 18) that governs authentication, authorization, modification, and removal of user accounts through the example communication interface. The process may begin at a login step, in which a user is presented with a login screen and prompted to enter user credentials. The credentials may include, for example, a username and password, which are received by the engine for authentication prior to granting access to engine functionality.

Upon successful authentication, the engine may navigate the authenticated user to the example interface, where a configuration tab (e.g., 315) is made available. From the configuration tab, the user may access an add/manage users tab (e.g., 316), which enables administrative or otherwise authorized users to perform user management operations. Selection of the add/manage users tab may cause the example interface to display a management page, which presents a list of existing user profiles along with available user management actions.

From the management page, the example interface may provide an option to edit an existing user profile. When an "edit user" option is selected, the example interface may display an "edit user" popup interface, allowing modification of user-specific information (e.g., name, role, contact details, etc.). The user may close the popup without saving changes or may submit the updated information. If the update is confirmed, the engine may save the modified user profile and update the displayed user list to reflect the changes.

The management page may further provide an option to change a user's access level. Selection of this option may cause the example interface to display a "change access" popup interface, through which an authorized user may assign or modify access permissions associated with the selected user. Access levels may correspond to predefined roles, such as administrative, setup/design, or operational roles. If the user cancels the action, no changes are applied. If the user confirms the access modification, the engine may save the updated access level and automatically return the user to the management page, where the updated access configuration is reflected.

In addition, the management page may include functionality to remove a user account. When a "remove user" option is selected, the example interface may present a confirmation prompt asking the user to confirm the removal action. If the user selects a negative response, the removal operation is canceled and the user is returned to the management page without modification to the user list. If the user confirms the removal, the example interface may delete or deactivate the selected user account and automatically return the user to the management page, where the removed user profile is no longer displayed.

At any point during user management operations, the example interface may provide a "back navigation" option, allowing the user to return to a previous page or exit the management page without making changes. This may ensure that user management actions are deliberate and reversible prior to confirmation.

In addition, the example communication interface may provide real-time or near real-time monitoring of airfield components. Operators may view current operational status, warnings, faults, and alarms associated with lighting fixtures, light groups, communication links, and other airfield components. Alarm management may be performed directly through the interface, allowing operators to acknowledge, silence, or clear alarms as appropriate. By consolidating system configuration, control, and alarm management within a single interface, the example interface may improve operational response times and reduce the risk of operator error.

FIG. 4A is a flowchart that describes a portion of an example method 400 for managing a workload, in accordance with one or more aspects of the present disclosure. The operations of the method 400 may be implemented by one or more computing devices 102 or their components as described herein. The computing devices 102 or their components may communicate with each other via one or more networks (e.g., the networks 140 of FIG. 1). Any of the data communicated between the computing devices 102 or their components may be sent as one or more signals.

For example, the operations of the method 400 shown in FIG. 4A may be performed by an engine 204 as described with reference to FIG. 2. In some instances, the computing devices 102 or the aforementioned computing components may execute a set of instructions to control the functional elements of the computing devices 102 or the aforementioned computing components to perform the described functions. Additionally, or alternatively, the computing devices 102 or the aforementioned computing components may perform aspects of the described functions using special-purpose hardware.

While various operations of the flowchart are presented and described sequentially, those skilled in the art will appreciate that some or all of the operations may be executed in different orders, may be combined or omitted, and some or all operations may be executed in parallel without departing from the scope of the present disclosure.

At 402, the engine 204 may receive or ingest a workload execution request (e.g., a user input 401) from an entity or user via a computing device (e.g., 102-b, FIG. 1), a web application (e.g., 134, FIG. 1) that is being used by the user, an application terminal of a computing device (e.g., 102-c, FIG. 1), or the like. In some cases, the entity may want to execute a workload targeting an airfield (e.g., monitoring and controlling lighting at the airfield).

In some aspects, the input 401 (e.g., an unstructured natural language input) may specify information associated with the workload, for example (but not limited to): a risk level of the workload, a type of the workload, a geographic location of the user, a role of the user in a related organization, an access level of the user to the computing devices of the organization, credentials of the user (e.g., the user's first name and/or last name, the user's password, etc.), a type of the user (e.g., a trusted user, a malicious user, a high-priority user, etc.), IP address details of the computing device, a timeframe within which the workload may be performed, an execution urgency of performing the workload, a user-defined policy to be considered while executing the workload, a user-defined data protection policy to be considered while executing the workload, a workflow definition file (e.g., a declarative file describing output features to be obtained after executing the workload, a programmatic file, etc.) associated with the workload, or the like.

In other aspects, the user-defined policy may define a period of time within which the execution of the workload is projected to be completed. In some instances, the user may send, visually, haptically, or verbally, the user input 401 to the engine 204 via a communication interface (e.g., 210, FIG. 2). In other instances, a login screen may be presented when the interface 210 is launched or following a logout event, allowing the user to authenticate using his or her credentials or initiate a password-reset process. Further,

Upon first login, a user with the appropriate access level may be required to complete a runway generation process (*see* 412) before other engine functions become available. For users without design privileges (e.g., maintenance engineers), the corresponding configuration page or screen may remain hidden, ensuring that only authorized users may access or modify airfield layout settings.

At 404, in response to receiving the input 401, as part of the input 401, or in any other manner (e.g., before initiating any computation with respect to the input 401), the engine 204 may analyze the input 401 and its associated details to identify (i) a type of the user (e.g., administrator, maintenance engineer, etc.), (ii) an operation mode (e.g., the primary mode, the sub-system mode, etc.), and (iii) the user's intent, interest, or preference (e.g., with respect to airfield management) using its model(s) (e.g., 206, FIG. 2). In some aspects, the engine 204 may analyze the input 401 in accordance with rules or policies (e.g., internal rules, anti-fraud policies, compliance rules, etc.) set by an administrator of the lighting management platform (e.g., 202, FIG. 2).

In some aspects, the engine 204 may implement a mode selection process that governs how the platform (e.g., 202, FIG. 2) operates within an airport environment (e.g., 100, FIG. 1). Selection of an operation mode may be performed through the communication interface and may require confirmation from a user possessing appropriate credentials. By enforcing credential-based access to mode selection, the engine 204 may ensure that operational authority is granted only to authorized users and that transitions between modes occur in a controlled and auditable manner.

Upon authentication, a user with sufficient privileges may be presented with an option to determine the operational mode of the platform (or the engine (204)). Depending on deployment requirements, the platform may be designed to operate as a primary airfield lighting management platform or as a subordinate or integrated subsystem within an existing ALCMS (e.g., 128, FIG. 1). The communication interface may guide the user through the mode selection workflow, prompting confirmation before any mode transition is applied to ensure deliberate and intentional configuration changes.

In some aspects, the engine 204 may be designed to operate in the primary mode, in which the engine 204 may function as the principal controller for the airfield (e.g., 114, FIG. 1). When operating in this mode, the engine 204 may be granted full authority over airfield lighting operations and may serve as the master control entity and primary user access point for monitoring and controlling one or more airfield components (e.g., 116, 118, FIG. 1). The engine 204 may support centralized execution of airfield commands, per-group and per-fixture control, and unified presentation of airfield status, alarms, and operational conditions. This centralized authority may enable users (e.g., ATC personnel or other authorized operators) to make timely adjustments in response to changing operational needs, environmental conditions, or safety requirements.

In other aspects, the engine 204 may be configured to operate in the sub-system mode, in which the engine 204 may be integrated into an existing airport environment (e.g., 100, FIG. 1) to manage one or more airfield components under the direction of an ALCMS (e.g., 128, FIG. 1). In this configuration, the engine 204 may not function as the primary management authority for the airfield but instead operates as an intermediary engine that extends the control, monitoring, and communication capabilities of the ALCMS across the airfield. The sub-system mode may allow the engine 204 to provide localized control and monitoring functionality while maintaining compatibility with higher-level supervisory systems.

Throughout the mode selection process, the communication interface may provide visual prompts, confirmation dialogs, and status indicators to ensure that the user is aware of the current mode, the implications of a mode change, and any required credentials. By structuring the mode selection workflow in this manner, the engine 204 may ensure that operational mode transitions are deliberate, authenticated, and consistent with the intended deployment architecture of the airfield lighting environment. Additional details of the primary mode and sub-system mode are described above with respect to FIG. 1.

At 406, by employing its model and based on the analysis at 404, the engine 204 may make a first determination (e.g., in real-time or near real-time) as to whether the input 401 is valid. Accordingly, if the result of the first determination is NO, the method 400 may proceed to 408. If the result of the first determination is YES, the method 400 may proceed to 412. In some aspects, through role-based access control, the engine 204 may ensure that configuration, monitoring, and control functions remain accessible only to users possessing the requisite authorization.

At 408, as a result of the first determination at 406 being NO and by employing its model, the engine 204 may generate a fake or simulated response for the input 401. At 410, in response to the input 401, the engine 204 may output or transmit the simulated response to the user through the communication interface. In some aspects, the simulated response may be output as at least one signal as described herein. The method 400 may end following 410.

At 412, as a result of the first determination at 406 being YES and by employing its model, the engine 204 may generate a runway (or a runway layout) within a layout of the airfield (e.g., 114, FIG. 1). In some aspects, the runway generation process may be initiated when the user selects a configuration module/tab (e.g., 305, FIG. 3) within the communication interface. Selection of the configuration tab may cause the engine 204 to transition into a configuration mode, in which runway layout creation, editing, and related airfield configuration functions are made available. In this configuration mode, the user may be provided with access to tools that facilitate construction and modification of an airfield layout, including visualization and editing capabilities for runway and taxiway geometries.

After the configuration tab is selected, the communication interface may display a configuration page that serves as a centralized workspace for runway layout creation and modification. The configuration page may present any existing runway definitions and may provide selectable controls for creating a new runway, editing an existing runway, or resuming a partially configured layout. In some cases, this page may function as the entry point for invoking a runway builder capability implemented by or through the engine 204, thereby enabling structured development and refinement of runway and associated airfield layout elements.

From the configuration page, the user may select an option such as "create a new runway" to initiate creation of a runway definition. Selection of this option may cause the engine 204 to generate a new runway object or record within the underlying data structure, which may subsequently be populated with runway geometry, identifiers, and associated configuration parameters. Establishing this runway entity may provide the foundational data construct that may later be rendered and manipulated within the runway builder layout view.

In response to the selection, the communication interface may prompt the user to enter a name or designation for the new runway and then select a confirmation control. Upon confirmation, the engine 204 may store the runway identifier and append the newly created runway entry to a runway list displayed through the interface. Establishing the identifier in this manner may enable the runway to be referenced in subsequent interface pages (e.g., a runway selection list) and supports later association of light groups, runway headings, and operational behaviors with the defined runway.

After the runway is created, or when an existing runway is selected for modification, the user may select an "edit runway" tab to access an "edit runway" page. Entry into the "edit runway" page may transition the communication interface into a runway builder mode, in which the runway geometry and associated features are defined through user interactions. In this mode, the runway builder capability may enable the user to generate and configure runway layouts without requiring assistance from a specialist system integrator, thereby streamlining deployment and reducing reliance on external technical resources.

On the edit runway page, the user operator may construct the runway geometry using a drawing grid or similar layout tool. Within this runway builder workflow, the user may define runway geometry-including length, width, designation, orientation, and associated features-through parameter-based inputs and/or iterative placement actions. In some aspects, the engine 204 may process the user inputs to generate a schematic or representative runway layout that conforms to regulated airfield design parameters, thereby ensuring that the resulting configuration aligns with established operational and safety requirements.

In other aspects, the user may select a runway segment option or a taxiway segment option and then select a confirmation control to add the chosen segment to the layout at the designated grid location. Upon confirmation, the selected segment may be rendered within the layout view, thereby incrementally constructing the graphical representation of the runway or taxiway. This segment-based workflow enables the user to place and arrange runway and taxiway features directly within the interface, supporting intuitive, step-wise development of the airfield layout.

The runway generation process may continue through repeated segment placement actions until the runway and any associated taxiway layout are fully constructed. The communication interface may permit ongoing selection of grid squares and repeated confirmation of segment types, thereby enabling progressive refinement of runway geometry and taxiway connectivity. In some cases, the engine 204 may maintain an intermediate design state such that the layout may be resumed across multiple user sessions or revisited at a later time for further modification, ensuring continuity and flexibility in the configuration workflow.

After the runway geometry, taxiway geometry, and runway headings have been defined, the user may select a "save layout" option. Saving the layout may cause the engine 204 to persist the runway representation-such as by storing the layout data in memory and/or a database (e.g., 142, FIG. 1)-and make the stored configuration available for subsequent operational use. In some aspects, saving the layout may enable downstream configuration steps, in which the user may assign lighting fixtures (e.g., 116, FIG. 1) to the defined runway layout using parameter-based inputs, thereby linking physical lighting fixtures to the constructed airfield representation.

At 414, by employing its model, the engine 204 may configure one or more light groups in the runway. In some aspects, the user may generate or update lighting fixtures (e.g., 116, FIG. 1) through the communication interface, with control operations ultimately executed by the engine 204. From a configuration screen on the interface, the user may select a configuration tab (e.g., 308, FIG. 3) and navigate to an "edit runway" mode, where the lighting fixture arrangements associated with the runway are defined. Within this mode, the user may select a "light" tab or an "approach" tab and choose a light type corresponding to a particular lighting application (e.g., a runway edge light, a taxiway light, an approach light, etc.). The user may then specify a light identifier and associate the light with a physical location and light group, thereby creating a system-level representation of the lighting fixture. Upon saving the layout, the light definition may be persisted and made available for subsequent grouping, control, and monitoring operations. This workflow may enable precise modeling of the physical placement of lighting fixtures and supports both wired lighting fixtures and solar-powered, RF-enabled lighting fixtures within a unified configuration platform.

Following generation or modification of individual lighting fixtures, the engine 204, via the communication interface, may enable the user to configure one or more light groups through a dedicated light group configuration workflow. From a configuration screen on the interface, the user may select a "light group" tab and either create a new light group or select an existing group for further modification. For each light group, the user may define a linkage to a runway heading, assign a numerical group identifier, and specify the number of intensity steps used to control the group (e.g., one-step, three-step, five-step, etc.). These parameters may facilitate coordinated control of multiple lighting fixtures as a unified group, enabling consistent adjustments to intensity levels or operating modes. In some cases, the configured light group may be associated with aviation operational parameters (e.g., visibility-based control logic, PALC, etc.), thereby supporting compliance with aviation administration requirements.

In addition, the engine 204 may support a configuration groups and mappings workflow that enables fine-grained control over how light groups respond to operational commands. After the runway layout is completed, the user may navigate to a configuration groups page on the interface and add one or more new groups, assigning an identifier to each group as required. For each group, the user may access a mappings interface to configure parameters (e.g., intensity mappings, visibility-based activation levels, soft-start time delays, fail-safe behaviors, etc.). These mappings may be automatically saved and associated with the corresponding light group, ensuring that light groups respond predictably to subsequent control inputs. The mappings workflow may further allow the user to apply configuration changes on demand, cancel pending updates, or confirm modifications before they are transmitted. Once confirmed, configuration changes may be propagated through an RF network (e.g., 140, FIG. 1) or other communication pathways and acknowledged by the lighting fixtures, thereby reducing the risk of unintended system behavior and ensuring reliable, coordinated lighting control.

In some aspects, the light fixtures (e.g., 116, FIG. 1) may be controlled through the engine 204, which is configured to provide remote control, supervision, and status monitoring of the fixtures across a wide range of operational environments. Through the communication interface, the user may manage the intensity of lighting fixtures, activate supplemental lighting fixtures during adverse weather conditions (e.g., *see* 416), or adjust lighting behavior based on sunrise/sunset tables or other environmental inputs. To reduce the likelihood of unintended adjustments, the communication interface may require an explicit confirmation action before executing a lighting command.

At 416, by employing its model, the engine 204 may add one or more lights to each light group to obtain a completed airfield layout. In some aspects, the engine 204 may implement a light placement workflow through the communication interface. From a configuration page on the interface, the user may select the runway from a list of available runways and then navigate to an "edit lights" mode associated with the selected runway. Upon entering this mode, the interface may display a lights page that visually represents the selected runway and enables the user to add new lighting fixtures or modify existing ones. Further, the user may select a "light tab" and choose a light type from a set of available options corresponding to various airfield lighting applications. Selection of a light type may cause the interface to present a visual indicator-such as a drawing grid cursor or highlight-positioned behind or adjacent to the runway, indicating that the engine 204 is prepared to place a lighting fixture of the selected type.

After a light type is selected, the communication interface may present a "set light values" prompt that enables the user to select a light group from a previously configured list of groups. These light groups may have been defined earlier through a group configuration workflow (*see* 414). Upon selection of a light group and confirmation of the prompt, the user may activate a graphical placement control-such as a "graph paper" or grid-overlay button-and select a location on the drawing grid at which the lighting fixture is to be placed. This action may associate the lighting fixture with both a physical location on the runway layout and a logical light group.

If needed, the user may delete a selected light prior to confirmation, which removes the light from the runway without saving the placement. If the user selects a cancel option, the pending light placement may be discarded, and the interface may return to a prior state, in which the selected light type is no longer highlighted.

When the user selects a confirm control to finalize placement of a lighting fixture, the interface may save the fixture addition to the runway and return the user to the lights page. The selected light type may then be de-highlighted, allowing the user to continue placing additional fixtures of the same type or to select a different light type as needed. In some aspects, this process may repeat until all required lighting fixtures have been added to the runway.

Once confirmed, the light definitions-including light type, physical location, and associated light group-may be transmitted to the engine 204, which manages storage of the configuration and uses the completed airfield layout as a reference for subsequent lighting control, supervision, and status-monitoring operations.

At 418, by employing its model, the engine 204 may monitor the airfield (e.g., 114, FIG. 1) to continuously or periodically obtain a dataset. In some aspects, the engine 204 may monitor the airfield based on the operational requirements, operational demands, and the certification category of the airport environment (e.g., 100, FIG. 1). Such monitoring may include collecting real-time or near real-time status information from airfield components (e.g., lighting fixtures, sensors, etc.), evaluating environmental conditions (e.g., visibility or ambient light levels), and tracking airfield performance metrics relevant to regulatory compliance.

In some cases, the dataset may include, for example (but not limited to): lighting fixture status information, alarm/fault conditions, activation events (e.g., lighting fixture activation events), photocell-based day/night indicators, PALC command states, control commands associated with individual lighting fixtures, one or more lighting fixture configuration parameters, preset control settings, communication status, diagnostic indicators, or the like.

At 420, by employing its model, the engine 204 may analyze the dataset. In some aspects, the engine 204 may analyze the dataset by correlating the dataset with the completed airfield layout to detect anomalies, verify correct fixture behavior, and determine whether operational thresholds or safety criteria are being met. In other aspects, the engine 204 may analyze the dataset to ensure that the lighting fixtures operate in accordance with applicable aviation standards and certification requirements.

At 422, by employing its model and based on the analysis at 420, the engine 204 may make a second determination (e.g., in real-time or near real-time) as to whether any issue has been detected (e.g., with respect to airfield components). Accordingly, if the result of the second determination is YES (e.g., the airfield has an issue with respect to airfield operational conditions), the method 400 may proceed to 432 of FIG. 4B (via connector A in FIGs. 4A and 4B). If the result of the second determination is NO (e.g., the airfield satisfies airfield operational conditions), the method 400 may proceed to 424.

In some cases, the airfield operational conditions may include, for example (but not limited to): visibility conditions, runway and taxiway occupancy status, ambient-light conditions (e.g., derived from the sensors), system health conditions (e.g., indicating whether lighting fixtures, communication links, or control sub-systems are functioning within expected operational tolerances), or the like.

At 424, as a result of the second determination at 422 being NO and by employing its model, the engine 204 may generate a first monitoring report specifying at least the results of the analyses performed at 404 and 420. At 426, the engine 204 may output, via the communication interface, the report to the user in response to the input 401.

At 428, in response to outputting the report (and details of the report), the engine 204, via the communication interface, may receive or input feedback (e.g., positive feedback, negative feedback, etc., in a textual format or audio format) from the user regarding the report. In some examples, the feedback (e.g., human-in-the-loop feedback) may be explicit feedback (e.g., positive ratings, negative ratings, follow-up instructions, etc.) or implicit feedback (e.g., ignoring the details) to enable efficient processing of user inputs. Based on the feedback (e.g., positive feedback about the report, negative feedback about the layout generation, etc.) received via the communication interface, the engine 204 may fine-tune its models to improve, for example, airfield management.

As indicated above, the engine 204 may foster continuous improvement and accuracy, maintaining its models' robustness and reliability. In this manner, the engine 204 may systematically apply the insights or feedback gathered from administrators and/or users to enhance the performance of its models, ensuring the models become more robust, accurate, and reliable in processing data. At 430, the engine 204 may store or log the feedback and the report in a database (e.g., 142, FIG. 1) for later use. The method 400 may end following 430.

FIG. 4B is a flowchart that describes a portion of the example method 400 for managing the workload, in accordance with one or more aspects of the present disclosure. The operations of the method 400 may be implemented by one or more computing devices 102 or their components as described herein. The computing devices 102 or their components may communicate with each other via one or more networks (e.g., the networks 140 of FIG. 1). Any of the data communicated between the computing devices 102 or their components may be sent as one or more signals.

For example, the operations of the method 400 shown in FIG. 4B may be performed by the engine as described with reference to FIG. 2. In some instances, the computing devices 102 or the aforementioned computing components may execute a set of instructions to control the functional elements of the computing devices 102 or the aforementioned computing components to perform the described functions. Additionally, or alternatively, the computing devices 102 or the aforementioned computing components may perform aspects of the described functions using special-purpose hardware.

While various operations of the flowchart are presented and described sequentially, those skilled in the art will appreciate that some or all of the operations may be executed in different orders, may be combined or omitted, and some or all operations may be executed in parallel without departing from the scope of the present disclosure.

At 432, as a result of the second determination at 422 being YES and by employing its model, the engine 204 may generate an action to be taken to resolve the issue. In some aspects, the issue may include, for example (but not limited to): loss of RF communication with a corresponding lighting fixture (e.g., 116, FIG. 1), a faulty RVR sensor (e.g., 144, FIG. 1), a power outage, or the like. In other aspects, the engine 204 may generate the action based on one or more predefined recovery protocols. In some cases, the action may include, for example (but not limited to): restarting the lighting fixture, reinitializing the communication session, deploying an emergency power generator to the airfield, or the like. In other cases, upon detecting the issue, the engine 204 may transition into a safe state, thereby preventing further command execution and maintaining overall airfield operational safety.

At 434, by employing its model, the engine 204 may generate a second monitoring report specifying at least the action, the issue, and the results of the analyses performed at 404 and 420. At 436, the engine 204 may output, via the communication interface, the report to the user in response to the input 401.

At 438, in response to outputting the report (and details of the report), the engine 204, via the communication interface, may receive or input feedback (e.g., positive feedback, negative feedback, etc., in a textual format or audio format) from the user regarding the report. In some examples, the feedback (e.g., human-in-the-loop feedback) may be explicit feedback (e.g., positive ratings, negative ratings, follow-up instructions, etc.) or implicit feedback (e.g., ignoring the details) to enable efficient processing of user inputs. Based on the feedback (e.g., positive feedback about the report, negative feedback about the layout generation, etc.) received via the communication interface, the engine 204 may fine-tune its models to improve, for example, airfield management. At 440, the engine 204 may store or log the feedback and the report in a database (e.g., 142, FIG. 1) for later use. The method 400 may end following 440.

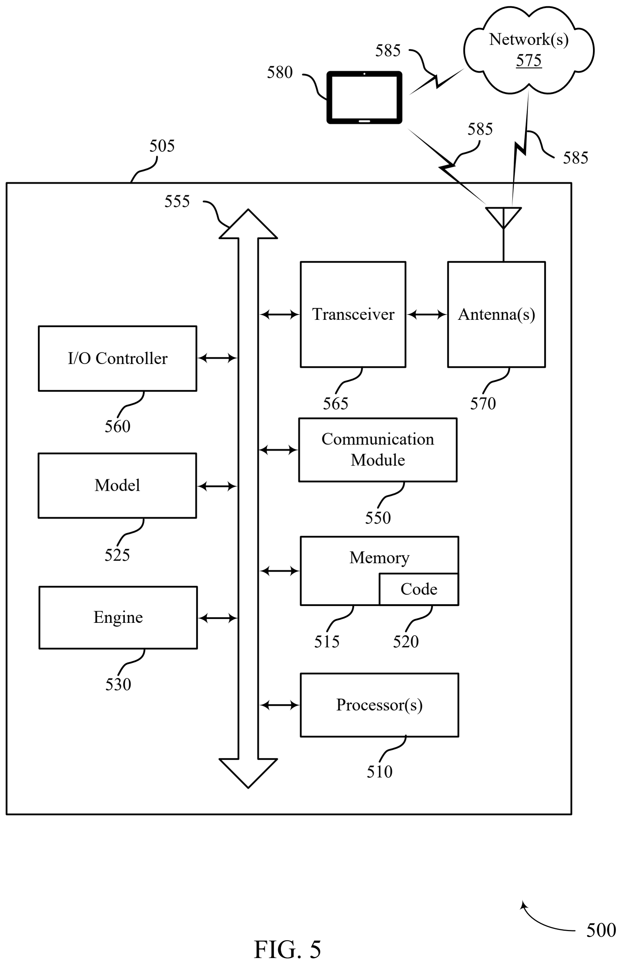

FIG. 5 is a block diagram of a computing environment 500 that supports a lighting management platform, in accordance with one or more aspects of the present disclosure. The computing environment 500 may include at least one device 505, at least one computing device 580, and at least one network 575. In some instances, the at least one device 505 may be, or include aspects of, the one or more computing devices 102 of FIG. 1. In some instances, the at least one network 575 may be, or include aspects of, the at least one network 140 of FIG. 1. The at least one device 505 may include at least one I/O controller 560, a communication module 550, at least one memory 515 storing code 520, at least one processor 510, at least one transceiver 565, at least one antenna 570, a model 525, an engine 530, and at least one bus 555. As described herein, the lighting management platform may be an example of, or include one or more aspects of, the platform 138 described with respect to FIG. 1.

In some instances, more than one model 525 may be included within the at least one device 505. In other instances, one or more models 525 may be distributed among one or more computing devices or stored in a server or a database of a network (e.g., 575). In some examples, one or more models 525 may be located within the at least one device 505, while additional models may be located externally to the at least one device 505.

The model 525 may be an example or may include aspects of the set of models 206 of FIG. 2. In some instances, the model 525 may be a single model or multiple models. In other instances, the model 525 may include a separate module within a single system. In some cases, the model 525 may be implemented as part of the at least one processor 510.

The engine 530 may be an example of, or may include aspects of, the engine 204 of FIG. 2. The engine 530 may integrate with an airport environment to manage the execution of various user inputs. In some cases, the engine 530 may be implemented as part of the at least one processor 510.

The I/O controller 560 may manage input and output signals for the device 505. The I/O controller 560 may manage peripherals not integrated into the device 505. In some cases, the I/O controller 560 may represent a physical connection or port to an external peripheral. In some cases, the I/O controller 560 may utilize an operating system such as iOS^{®}, ANDROID^{®}, MS-DOS^{®}, MS-WINDOWS^{®}, OS/2^{®}, UNIX^{®}, LINUX^{®}, or another known operating system. Additionally, or alternatively, the I/O controller 560 may represent or interact with a modem, a keyboard, a mouse, a joystick, a trackball, a microphone, a touchpad, a touchscreen, a tablet pen, a biometrics device, a display, a screen, a monitor, a point-of-sale terminal, a camera, a webcam, an external storage device, a speaker, lab equipment, a sensor, a printer, a scanner, or similar devices. In some cases, the I/O controller 560 may be implemented as part of one or more processors, such as the at least one processor 510. In some cases, a user may interact with the at least one user device 505 via the I/O controller 560 or via hardware components controlled by the I/O controller 560.

In some instances, the I/O controller 560 may include an input processing component capable of receiving, validating, and preprocessing incoming data from various sources, ensuring that the data is in a compatible format for use by the device 505. Within some examples, the I/O controller 560 may incorporate an output generation component designed to format and deliver the results or predictions generated by the device 505 to downstream applications, interfaces, or systems. Additionally, the I/O controller 560 may include a data buffering capability to temporarily store input or output data, ensuring stable and synchronized communication between the device 505 and other connected systems, particularly in real-time or high-throughput environments. The I/O controller 560 may further include error handling mechanisms to detect, report, and address any issues that arise during input or output operations, such as data inconsistencies, transmission failures, or incompatible formats.

In some cases, the device 505 may include the at least one antenna 570. However, in some other cases, the device 505 may have more than one antenna 570, which may be capable of concurrently transmitting or receiving multiple wireless transmissions. The transceiver 565 may communicate bi-directionally via the at least one antenna 570 using wired or wireless links as described herein. For example, the transceiver 565 may represent a wireless transceiver and may communicate bi-directionally with another wireless transceiver. The transceiver 565 may include a modem to modulate the packets, to provide the modulated packets to the at least one antenna 570 for transmission, and to demodulate packets received from the at least one antenna 570. The transceiver 565, or the transceiver 565 and the at least one antenna 570, may be an example of a separate transmitter or a separate receiver.

The communication module 550 may facilitate communication between the device 505 and the network 575 and/or communication between the various components of the device 505, the computing device 580, and the network 575 via at least one wired or wireless network connection 585. In some cases, the communication module 550 may be implemented as part of the at least one processor 510.

The memory 515 may be provided in the form of a single memory unit or multiple memory units and may be provided in the form of one or more articles of manufacture and/or machine components. The memory 515 may include static memory, dynamic memory, or both in communication. In some examples, the memory 515 may be one or more tangible storage mediums that can store data and executable instructions and may be non-transitory during the time instructions are stored therein. The memory 515 may be volatile or non-volatile, secure or encrypted, and unsecure or unencrypted.

The at least one memory 515 may store computer-readable, computer-executable, or processor-executable code, such as the code 520. The code 520 may be stored in a non-transitory computer-readable medium such as system memory or another type of memory. In some cases, the code 520 may not be directly executable by the at least one processor 510 but may cause a computer (e.g., when compiled and executed) to perform functions described herein. In some cases, the at least one memory 515 may include, among other things, a basic I/O system (BIOS) which may control basic hardware or software operation such as the interaction with peripheral components or devices. The code 520 stored in the memory 515 may include the software code for the engine and other components to operate.

The at least one processor 510, in some instances, may be a general-purpose processor or may be part of an application-specific integrated circuit (ASIC). In other instances, the at least one processor 510 may be at least one of an intelligent hardware device, a microprocessor, a microcomputer, a processor chip, a controller, a microcontroller, a digital signal processor (DSP), a state machine, a programmable logic device (PLD), a CPU, a GPU, a field programmable gate array (FPGA), neural processing units (NPUs) (e.g., neural network processors or deep learning processors (DLPs)), discrete gate or transistor logic, or at least one discrete hardware component. Additionally, any processor described herein may be provided in the form of a single processor, multiple processors, and/or parallel processors. Multiple processors may be included in or coupled to, a single device or multiple devices. In some cases, the at least one processor 510 may be configured to operate a memory array using a memory controller. In some other cases, a memory controller may be integrated into the at least one processor 510. The at least one processor 510 may be configured to execute computer-readable instructions stored in a memory (e.g., the at least one memory 515) to cause the device 505 to perform various functions (e.g., functions or tasks supporting a platform for sensitive-data enforcement and processing). For example, the device 505, or a component thereof, may include at least one processor 510 and at least one memory 515 operatively coupled to the at least one processor 510, the processor and memory being configured to perform various functions described herein.

In some examples, the at least one processor 510 may include multiple processors and the at least one memory 515 may include multiple memories. One or more of the multiple processors 510 may be coupled with one or more of the multiple memories 515, which may, individually or collectively, be configured to perform various functions described herein. In some examples, the at least one processor 510 may be a component of a processing system, which may refer to a system (such as a series) of machines, circuitry (including, for example, one or both of processor circuitry (which may include the at least one processor 510) and memory circuitry (which may include the at least one memory 515)), or components, that receives or obtains inputs and processes the inputs to produce, generate, or obtain a set of outputs. The processing system may be configured to perform one or more of the functions described herein. For example, the at least one processor 510 or a processing system including the at least one processor 510 may be designed to, designable to, configured to, configurable to, or operable to cause the device 505 to perform one or more of the functions described herein. Further, as described herein, being "designed to," being "designable to," being "configured to," being "configurable to," and being "operable to" may be used interchangeably and may be associated with a capability, when executing code 520 (e.g., processor-executable code) stored in the at least one memory 515 or otherwise, to perform one or more of the functions described herein.

The components of the device 505 may be interconnected and communicate via the at least one bus 555 or other communication link. The at least one bus 555 may enable communication via any standard or specification such as peripheral component interconnect, peripheral component interconnect express, parallel advanced technology attachment, or serial advanced technology attachment. The at least one bus 555 may be provided in the form of a single bus or multiple buses that are operatively interconnected.

In some examples, the engine 530 may be designed or configured to perform various operations (e.g., processing, receiving, monitoring, transmitting) using or otherwise in cooperation with the transceiver 565, the at least one antenna 570, or any combination thereof. Although the engine 530 is illustrated as a separate component, in some examples, one or more functions described with reference to the engine 530 may be supported by or performed by the at least one processor 510, the at least one memory 515, the code 520, or any combination thereof. For example, the code 520 may include instructions executable by the at least one processor 510 to cause the device 505 to perform various aspects related to sensitive data enforcement and processing as described herein, or the at least one processor 510 and the at least one memory 515 may be otherwise configured to, individually or collectively, perform or support such operations.

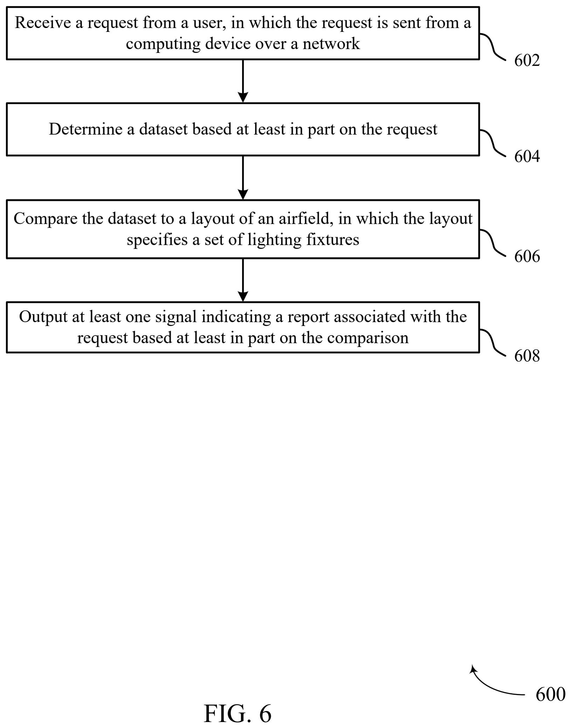

FIG. 6 is a flowchart of an example method 600 for managing a workload, in accordance with one or more aspects of the present disclosure. The operations of the method 600 may be implemented by one or more computing devices 102 or their components as described herein. For example, the operations of the method 600 may be performed by the engine 204 as described with reference to FIGs. 2, 4A, and 4B. In some examples, a computing device 102 or the aforementioned components may execute a set of instructions to control the functional elements of the computing devices 102 or the components to perform the described functions. Additionally, or alternatively, the computing devices 102 or the components may perform aspects of the described functions using special-purpose hardware.

At 602, the method 600 may include receiving a request from a user, in which the request is sent from a computing device over a network. The operations of 602 may be performed in accordance with examples as disclosed herein. In some examples, aspects of the operations of 602 may be performed by the engine 204 as described with reference to FIGs. 4A and 4B.

At 604, the method 600 may include monitoring an airfield to obtain a dataset based at least in part on the request. The operations of 604 may be performed in accordance with examples as disclosed herein. In some examples, aspects of the operations of 604 may be performed by the engine 204 as described with reference to FIGs. 4A and 4B.

At 606, the method 600 may include comparing the dataset to an airfield layout, in which the airfield layout specifies a set of lighting fixtures. The operations of 606 may be performed in accordance with examples as disclosed herein. In some examples, aspects of the operations of 606 may be performed by the engine 204 as described with reference to FIGs. 4A and 4B.

At 608, the method 600 may include determining that the airfield satisfies a set of airfield operational conditions based at least in part on the comparison. The operations of 608 may be performed in accordance with examples as disclosed herein. In some examples, aspects of the operations of 608 may be performed by the engine 204 as described with reference to FIGs. 4A and 4B.

At 610, the method 600 may include outputting at least one signal indicating a report associated with the request based at least in part on the determination. The operations of 610 may be performed in accordance with examples as disclosed herein. In some examples, aspects of the operations of 610 may be performed by the engine 204 as described with reference to FIGs. 4A and 4B.

The method 600 may further include analyzing the request to identify an interest of the user and an operation mode, and validating the request prior to analyzing the request based at least in part on the interest. In some forms of the method 600, the operation mode may be a primary mode or a sub-system mode.

In other forms of the method 600, the network may support MODBUS TCP/IP communication, and the computing device may communicate with a second computing device using MODBUS TCP/IP to send the request.

In other forms of the method 600, the computing device may be an air traffic control device, a handheld airfield controller, a pilot-activated lighting control device, or a combination thereof. In other forms of the method 600, the dataset may include a lighting fixture activation event, a fault condition associated with a lighting fixture, a control command associated with the lighting fixture, or a combination thereof.

The method 600 may further include analyzing the request to identify an interest of the user and an operation mode, validating the request prior to analyzing the request based at least in part on the interest, and generating the airfield layout on a communication interface based at least in part on the analysis of the request.

In other forms of the method 600, the set of lighting fixtures may include solar-powered radio frequency-enabled lighting fixtures, runway edge lighting fixtures, wired lighting fixtures, stand-alone steady burning lighting fixtures, or a combination thereof. The method 600 may further include receiving at least one signal indicating feedback regarding the report.

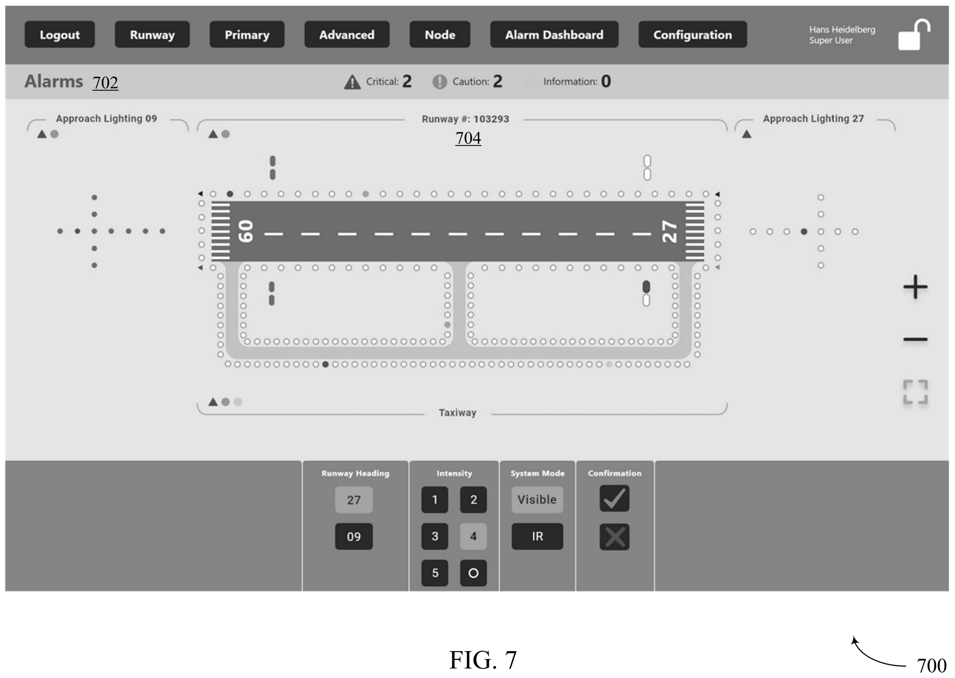

FIG. 7 is a schematic diagram 700 of another example communication interface, in accordance with one or more aspects of the present disclosure. The diagram 700 is for explanatory purposes only and is not intended to limit the scope of the present disclosure. The example communication interface may be an example of, or include one or more aspects of, the communication interface 210 of FIG. 2.

In some aspects, daily runway-level control may be performed through a "primary operations" panel presented via the example communication interface. The primary operations panel may provide high-level control of runway lighting and be configured to support routine operational tasks carried out by users (e.g., ATC personnel or other authorized operators). As shown in FIG. 7, the panel may display a graphical representation of a selected runway layout (e.g., 704), including runway geometry, associated taxiways, and lighting fixtures rendered in a schematic format. This graphical representation may enable users to maintain situational awareness of the airfield (e.g., 114, FIG. 1) by visually identifying the real-time operational state of lighting fixtures (e.g., 116, FIG. 1), including active, cautionary, and critical conditions.

In other aspects, the primary operations panel may enable users to perform coarse-grained, runway-wide lighting control using one or more inputs. For example, the panel may allow a user to select a runway heading, choose a day or night operating context, and set an intensity level corresponding to predefined intensity steps. The panel may further permit selection of a system mode, such as visible or IR operation, to support both conventional and night-vision-assisted activities. These controls may be intentionally consolidated into a small set of inputs to reduce cognitive load and reduce the likelihood of user error during time-sensitive situations, including low-visibility conditions or weather-related events.

In some cases, the primary operations panel may incorporate confirmation mechanisms to further enhance operational safety before executing lighting fixture changes. After the user selects the desired runway heading, operating context, intensity level, and system mode, the panel may ask for a confirmation action before applying the changes. Only upon confirmation are the corresponding control commands transmitted to the engine (e.g., 204, FIG. 2) for execution across the relevant light groups. This design may help ensure that inadvertent touches or incomplete selections do not result in unintended lighting changes. In addition, the panel may present an alarm summary that includes visual indicators distinguishing critical, cautionary, and informational alerts, along with direct navigation to an alarm dashboard for further investigation.

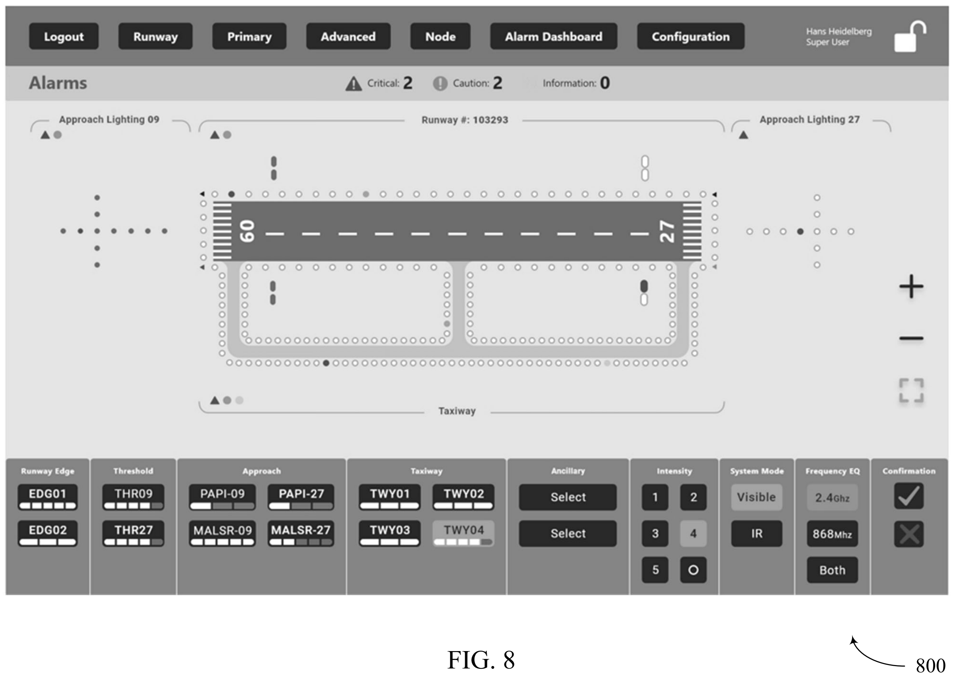

FIG. 8 is a schematic diagram 800 of another example communication interface, in accordance with one or more aspects of the present disclosure. The diagram 800 is for explanatory purposes only and is not intended to limit the scope of the present disclosure. The example communication interface may be an example of, or include one or more aspects of, the communication interface 210 of FIG. 2.

In some aspects, an "advanced operations" panel provided within the example communication interface may enable granular control of specific runway lighting types when more detailed or targeted commands are required beyond runway-wide control. The advanced operations panel may be accessed by switching from the primary operations panel via a navigation bar positioned at the top of the interface. Whereas the primary operations panel supports high-level, runway-wide control, the advanced operations panel may enable a user to selectively control individual lighting categories associated with a runway, such as runway edge lights, threshold lights, approach lights, taxiway lights, and auxiliary lights. The advanced operations panel may thus support fine-grained operational adjustments while maintaining a consistent visual context of the selected runway layout.

As illustrated in FIG. 8, the advanced operations panel may present a graphical runway layout together with selectable lighting type controls corresponding to distinct lighting fixture systems deployed along the runway and taxiways. A user may select one or more lighting categories (e.g., approach lighting fixtures, taxiway lighting fixtures, etc.) and then specify an intensity level using predefined intensity steps. The panel may further allow selection of a system operating mode, such as visible or IR, enabling compatibility with night-vision-assisted operations. In some aspects, the advanced operations panel may enable communication frequency selection for radio-controlled lighting fixtures, allowing a user to choose between available RF channels or to operate in a combined mode when multiple frequencies are supported. Visual indicators may highlight the currently active frequency and provide feedback regarding successful or unsuccessful frequency changes.

In some cases, the advanced operations panel may support lighting fixture aware interaction and investigation by allowing a user to select individual lighting fixture displayed on the runway layout or graphic. Selecting a particular fixture may open a summary dialog presenting basic fixture information (e.g., identification data, group association, active alarm types, etc.). From the summary dialog, the user may access a "check status" function that provides a direct link to a detailed "fixture status" view, enabling further investigation of operational or fault conditions. Similar to the primary operations panel, the advanced operations panel may incorporate explicit confirmation mechanisms before executing control commands, ensuring that granular adjustments (e.g., intensity changes, mode selections, frequency updates, etc.) are applied only after user confirmation.

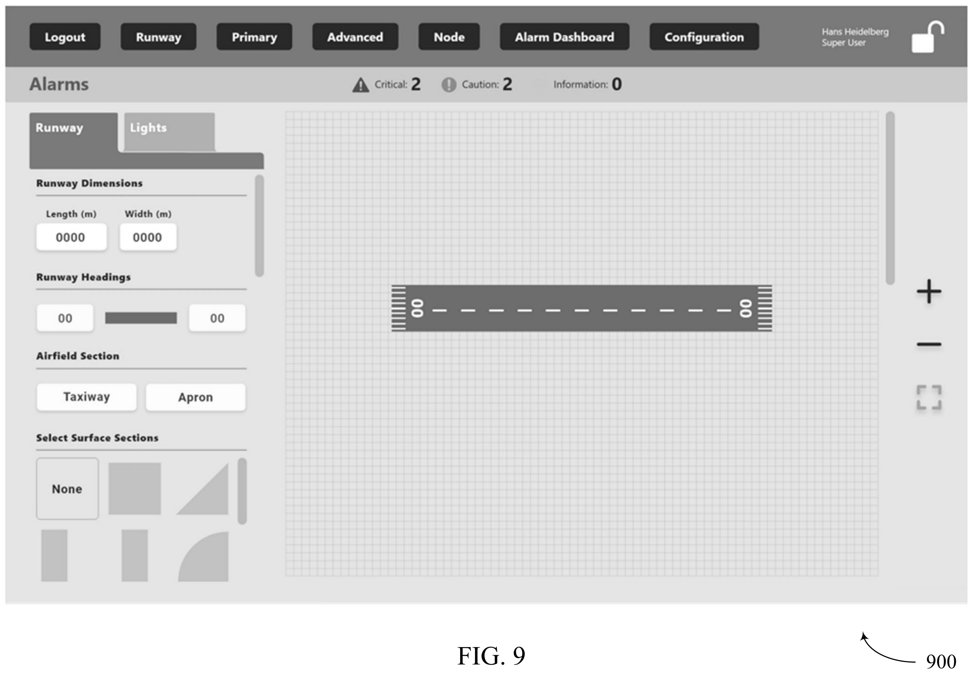

FIG. 9 is a schematic diagram 900 of another example communication interface, in accordance with one or more aspects of the present disclosure. The diagram 900 is for explanatory purposes only and is not intended to limit the scope of the present disclosure. The example communication interface may be an example of, or include one or more aspects of, the communication interface 210 of FIG. 2.

In some aspects, the communication interface may incorporate a "create/edit runway" panel that allows a user to build and adjust a schematic runway layout using an interactive runway builder. As shown in FIG. 9, runway-related and lighting-related functions may be accessible through dedicated "runway" and "lights" tabs. When the user selects the "runway" tab, the interface may display a drawing grid alongside a configuration menu on the left, through which one or more runway parameters (e.g., length, width, runway headings, etc.) may be defined. A basic runway layout may appear by default to provide an initial visual reference. As the user enters or updates runway dimensions and headings, the runway graphic may automatically refresh to reflect the new parameters, providing visual feedback on the runway's physical characteristics.

In other aspects, the runway builder may enable the user to directly manipulate the runway geometry within the drawing grid. For example, the user may resize, rotate, and reposition the runway graphic by interacting with the runway element itself. Zoom-in, zoom-out, and full-screen controls may be provided to support precise placement and detailed inspection of runway features. This direct manipulation capability may allow the user to align the runway depiction with the intended airfield layout while preserving consistency with the defined dimensional and heading inputs. Accordingly, the runway builder may provide both parameter-driven and graphical editing tools, providing a flexible yet structured environment for runway design within the communication interface.

After the runway geometry is defined, the "create/edit runway" panel may support incremental construction of additional airfield surfaces (e.g., taxiways, aprons, etc.) within the same drawing grid. Using an airfield section selector in the left side menu, the user may switch to a taxiway or apron mode and choose from a list of predefined surface tiles. The user may scroll through available tile shapes, select a desired tile, and place it onto the drawing grid by confirming the selection. This process may be repeated as needed, with each tile placement reflected in the visual layout until the desired taxiway configuration is achieved.

In some aspects, the communication interface may provide controls to confirm individual sections, save the overall layout, revert changes to the last saved state, or return to the configuration page. Once the runway and associated surfaces are saved, the resulting layout is persisted and automatically made available within the lights tab, where lighting fixtures may be added and aligned with the defined runway geometry. This workflow may enable a transition from runway design to lighting configuration while maintaining a consistent, user-defined airfield representation.

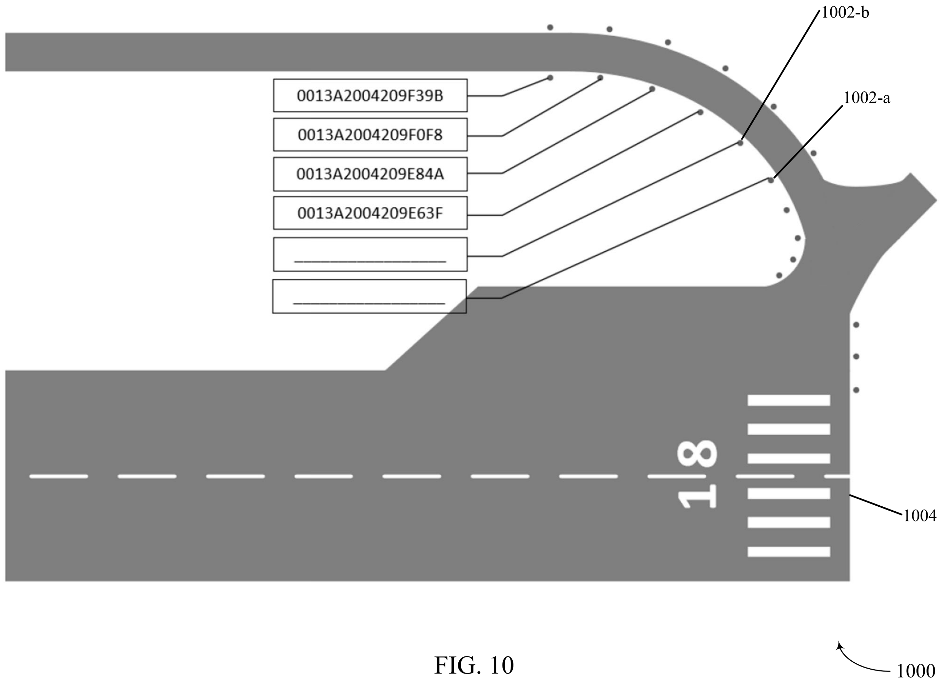

FIG. 10 is a schematic diagram 1000 of another example communication interface, in accordance with one or more aspects of the present disclosure. The diagram 1000 is for explanatory purposes only and is not intended to limit the scope of the present disclosure. The example communication interface may be an example of, or include one or more aspects of, the communication interface 210 of FIG. 2.

In some aspects, the communication interface may provide a graphical visualization of lighting fixtures (e.g., 1002-a, 1002-b, etc.) positioned along an airfield 1004. The interface may render the airfield 1004 as a schematic representation and overlays discrete visual markers corresponding to individual lighting fixtures (e.g., 1002-a, 1002-b, etc.) distributed along both curved and linear segments of the airfield 1004. Each lighting fixture (e.g., 1002-a, 1002-b, etc.) may be depicted by a distinct indicator placed in relation to the underlying airfield geometry, enabling a user to assess lighting fixture placement, spacing, and coverage along the defined route. This graphical representation may allow the user to understand how lighting fixtures (e.g., 1002-a, 1002-b, etc.) are arranged around bends, intersections, and terminal segments of the airfield 114, thereby supporting situational awareness during configuration, monitoring, or maintenance activities.

In other aspects, the communication interface may associate an identifier (e.g., an alphanumeric identifier) with each lighting fixture (e.g., 1002-a, 1002-b, etc.). As illustrated in FIG. 10, identifiers may be displayed near the corresponding fixture indicators and may be linked by callouts or leader lines, thereby clearly associating each identifier with a specific lighting fixture on the airfield 1004. In some cases, each identifier may be used by the engine (e.g., 204, FIG. 2) to facilitate control and monitoring of the corresponding lighting fixture. By presenting each fixture's physical location together with its associated identifier in a unified visual context, the interface may enable users to correlate system data (e.g., status, alarms, configuration parameters, etc.) with the actual placement of fixtures on the airfield 1004. This combined visual and logical representation may support efficient troubleshooting, targeted control actions, and accurate maintenance planning lighting fixtures (e.g., 1002-a, 1002-b, etc.) while reducing the potential for user error.

FIG. 11 is a flowchart that describes an example light group command sequence 1100, in accordance with one or more aspects of the present disclosure. The sequence 1100 is for explanatory purposes only and is not intended to limit the scope of the present disclosure.

Referring to FIG. 11, a main ALCMS (e.g., 138, FIG. 1) may receive a user request (e.g., via a communication interface) to modify the operating state of a selected light group and may issue a "light group command writing" request to a connected monitoring and control system (e.g., 106, 122, 130, FIG. 1). In response, the system may generate and transmit a "light group command" to the relevant set of lighting fixtures or light nodes (e.g., 116, FIG. 1), ensuring that the command is applied consistently across all lighting fixtures associated with the addressed light group. In some aspects, each light group may be controlled independently, and the main ALCMS may be designed to enforce a light group command only when the requested state differs from the current group state. Once the light group command is executed, the main ALCMS or the system may update the associated light group status within a defined update interval (e.g., on the order of one second) and may store or refresh node-level and/or group-level information in a node status database (e.g., 142, FIG. 1) so that the latest operational state is available for monitoring, reporting, and subsequent control actions.

Following execution of the light group command, the sequence may include a read-back and synchronization phase, in which the main ALCMS may obtain the updated light group status from the system. For example, after issuing the light group command writing request, the main ALCMS may subsequently issue a "light group status read" request after a short delay (e.g., approximately one second) to confirm that the group state has been refreshed and published. In parallel, each lighting fixture in the set of lighting fixtures may transmit internal status information during its heartbeat period (e.g., every 220 seconds), and the system may refresh stored status for each lighting fixture at least once per heartbeat period upon receiving the corresponding status messages. Additional details of the light group command sequence are described above with reference to FIG. 1.

FIG. 12 is a flowchart that describes an example lighting node status sequence 1200, in accordance with one or more aspects of the present disclosure. The sequence 1200 is for explanatory purposes only and is not intended to limit the scope of the present disclosure.

Referring to FIG. 12, each lighting fixture (e.g., 116, FIG. 1) may periodically transmits its node-level status information to a main ALCMS (e.g., 138, FIG. 1) via an intermediate monitoring and control system (e.g., 106, 122, 130, FIG. 1), in accordance with a defined heartbeat period. In some aspects, node-level status messages may be sent from each lighting fixture at regular intervals (e.g., once per heartbeat period) and may include operational state, communication status, and fault indicators. The intermediate system may receive these heartbeat messages and forward corresponding node-status updates to a node status database (e.g., 142, FIG. 1), ensuring that the most recent status of each light node is persistently stored. This architecture may enable the main ALCMS (e.g., 138, FIG. 1) to maintain an up-to-date representation of the operational condition of each lighting fixture.

In parallel with heartbeat-based reporting, the sequence may illustrate a coordinated read-back mechanism between the main ALCMS (e.g., 138, FIG. 1) and the system (e.g., 106, 122, 130, FIG. 1). At defined intervals (e.g., every several minutes for supervisory monitoring), the main ALCMS may issue one or more "node status read" requests or "light group status read" requests to the system. In response, the system may retrieve the most recent node-level data from the database and aggregate this information as needed to generate group-level status outputs, which are then returned to the main ALCMS.

By combining periodic heartbeat updates with structured read-back requests, the main ALCMS (e.g., 138, FIG. 1) may enable timely propagation of status information while reducing communication overhead. This approach may further support scalable monitoring and fault management of lighting fixtures (e.g., 116, FIG. 1) by allowing the engine (e.g., 204, FIG. 2) to evaluate node-level conditions against predefined thresholds and to produce actionable, group-level warnings or alarms that may be promptly reflected across the airport environment (e.g., 100, FIG. 1). Additional details of the lighting node status sequence are described above with reference to FIG. 1.

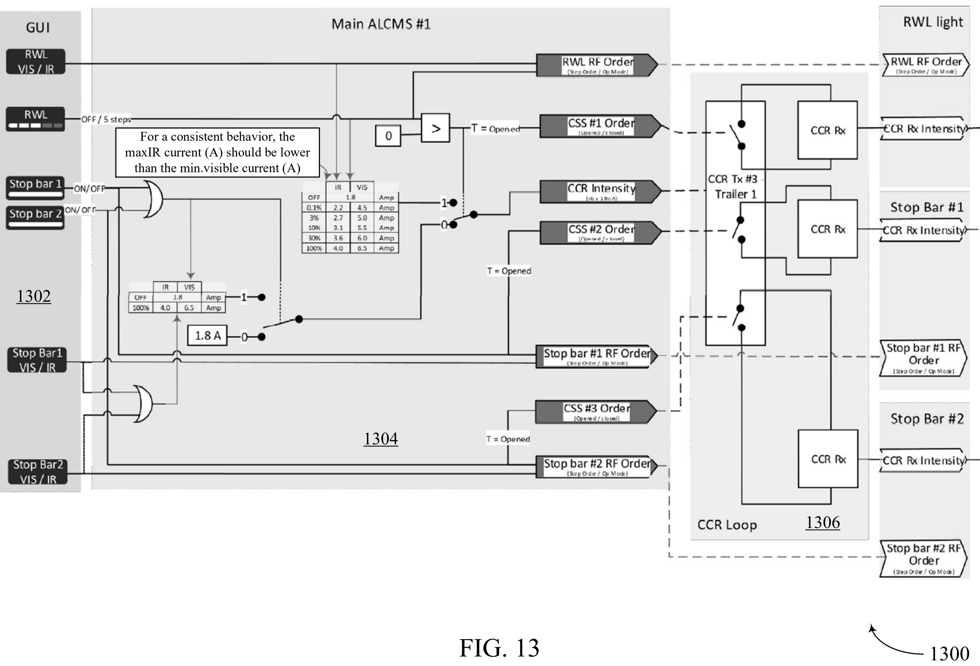

FIG. 13 is a schematic diagram 1300 illustrating CCR management, in accordance with one or more aspects of the present disclosure. The diagram 1300 is for explanatory purposes only and is not intended to limit the scope of the present disclosure.

Referring to FIG. 13, a user may modify a light group order through a communication interface 1302, initiating a coordinated control sequence that is executed by an engine (e.g., 204, FIG. 2) of a main ALCMS 1304 and applied across both RF-controlled lights and/or wired lights. A user-generated command (e.g., a change in intensity step, a change in light group order, etc.) may be transmitted from the interface to the main ALCMS. The engine of the main ALCMS may interpret the command and determine the appropriate control actions for the various lighting fixtures associated with the selected light group. For RF-enabled lighting fixtures (e.g., 116, FIG. 1), the engine may generate corresponding RF orders (e.g., stop-bar light RF commands), while for wired lighting fixtures, the engine may produce control signals suitable for driving CCRs (e.g., 120, FIG. 1). This architecture may enable a single user-initiated light group command to be translated into multiple, technology-specific control outputs, while maintaining synchronized behavior across the lighting fixtures.

Further, the engine (e.g., 204, FIG. 2) may manage CCR-based intensity control by mapping the requested light group order to one or more CCR intensity levels within a CCR loop 1306. As illustrated in FIG. 13, one or more CCR receivers may be coupled to respective lighting fixtures, with each CCR configured to receive an intensity command derived from the user's light group order. In some aspects, comparator and threshold logic within the control path may ensure that only valid and intentional changes (e.g., transitions between predefined current levels or operating states) are applied to the CCRs (e.g., 120, FIG. 1). In other aspects, the control sequence performed by the engine may incorporate explicit state checks and gating conditions (e.g., open/closed states) to ensure consistent behavior and prevent unintended current changes. By centrally coordinating RF orders and CCR intensity commands, the engine may enable unified, real-time control of heterogeneous lighting fixtures (e.g., 116, FIG. 1), ensuring that both wireless and wired lighting fixtures respond coherently to user commands while satisfying operational and regulatory requirements for airfield lighting management. Additional details of the CCRs are described above with reference to FIG. 1.

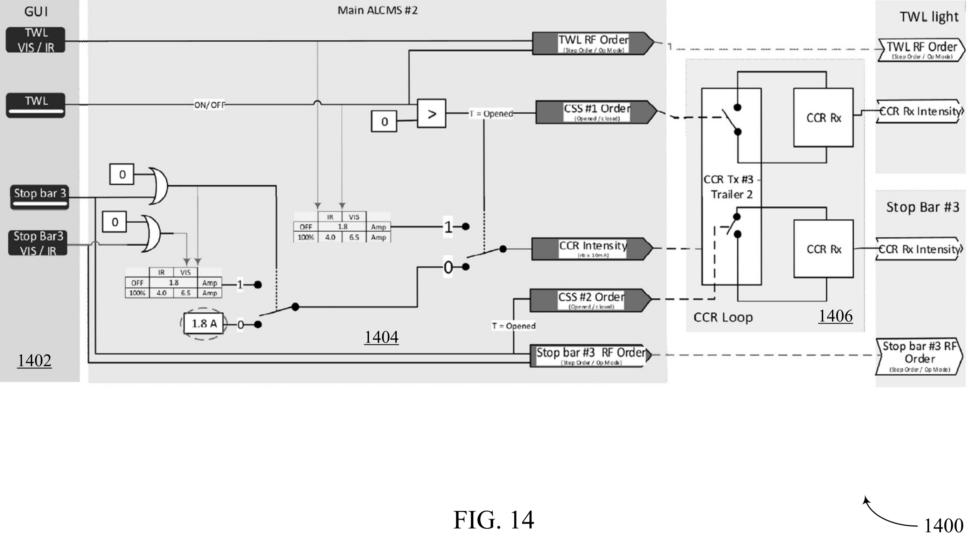

FIG. 14 is a schematic diagram 1400 illustrating CCR management, in accordance with one or more aspects of the present disclosure. The diagram 1400 is for explanatory purposes only and is not intended to limit the scope of the present disclosure.

Referring to FIG. 14, a user may send a command (e.g., a light group order) through a communication interface 1402, initiating a coordinated control sequence that is processed by an engine (e.g., 204, FIG. 2) of a main ALCMS 1404 to manage both RF-controlled lights and/or wired lights driven by constant one or more CCRs (e.g., 120, FIG. 1). In some aspects, the command may specify one or more parameters (e.g., ON/OFF state, intensity step, visible/IR operating mode for a selected light group, etc.). The engine may analyze the command and determine the appropriate control path for each lighting fixture (e.g., 116, FIG. 1) associated with the light group. For RF-enabled lighting fixtures, the engine may generate corresponding RF orders, while for wired lighting fixtures, the engine may derive a CCR intensity command that maps the requested light group behavior to a defined current level suitable for the CCR-driven loop.

As shown in FIG. 14, the engine (e.g., 204, FIG. 2) may apply logic, comparison operations, and gating conditions to translate the command into concrete CCR control signals. The requested light intensity or operating mode may be evaluated against predefined thresholds or lookup tables that associate intensity steps with corresponding current values, ensuring consistent and predictable behavior across different lighting fixtures. The engine may then issue CCR intensity commands to one or more CCR receivers within a CCR loop 1406, thereby setting the current supplied to the wired lights in accordance with the user's command. In parallel, RF orders may be transmitted to RF-controlled lights so that both wired and wireless lights respond coherently to the same command. The diagram 1400 may further indicate that certain control actions may be conditionally enabled (e.g., "T = Opened") to prevent unintended state transitions and to ensure safe, controlled changes in operating state. By centrally managing RF orders and CCR current control within a unified control sequence, the engine may enable synchronized, technology-agnostic execution of light group commands, ensuring that heterogeneous lighting fixtures respond consistently to user input while meeting operational and regulatory requirements.

FIG. 15 is a schematic diagram illustrating the airport environment of FIG. 1 from an alternative aspect, in accordance with one or more aspects of the present disclosure. As illustrated in FIG. 15, the airport environment 1500 may support distributed control and monitoring of one or more lighting fixtures (e.g., 1508, 1510, etc.) through multiple user access points and communication pathways. In some aspects, user interaction may occur through one or more communication interfaces (e.g., 1516-a-1516-e) located at different sites, including a remote location, an ATC location, and a vault location. Each communication interface may connect through a network infrastructure (e.g., 140, FIG. 1) that includes at least one or more Ethernet switches, fiber-optic links, and wide-area communication paths, enabling authorized users to issue commands and receive status information regardless of physical location. The architecture may further incorporate one or more firewalls and secure network boundaries separating the remote environment (e.g., the environment where 102-a of FIG. 1 operates), vault environment (e.g., the environment withing which 102-e of FIG. 1 operates), and airfield environment (e.g., 114, FIG. 1), thereby supporting controlled access and secure communication between different components.

Further, FIG. 15 may illustrate how the airport environment 1500 integrates the lighting fixtures and sensing components (e.g., 1506, 1512, etc.) under centralized supervision. While operating in the primary mode, a basestation 1520 (e.g., 138, FIG. 1) and associated wireless infrastructure may provide connectivity to RF-enabled lighting fixtures (e.g., 1508), handheld controllers (e.g., 1514), and PALC devices (e.g., 1504), while wired connections extend to one or more CCRs (e.g., 1518) and their corresponding lighting circuits. In some aspects, sensing components may also provide input to the basestation 1520. Through the network architecture, control commands and configuration data originating from any authorized communication interface may be routed through the network to the appropriate airfield components (e.g., 116, 120, FIG. 1), while status information, alarms, and operational feedback are returned along the same or complementary communication paths. This distributed yet unified design may enable coordinated control, monitoring, and fault management of heterogeneous lighting fixtures across the airport environment 1500.

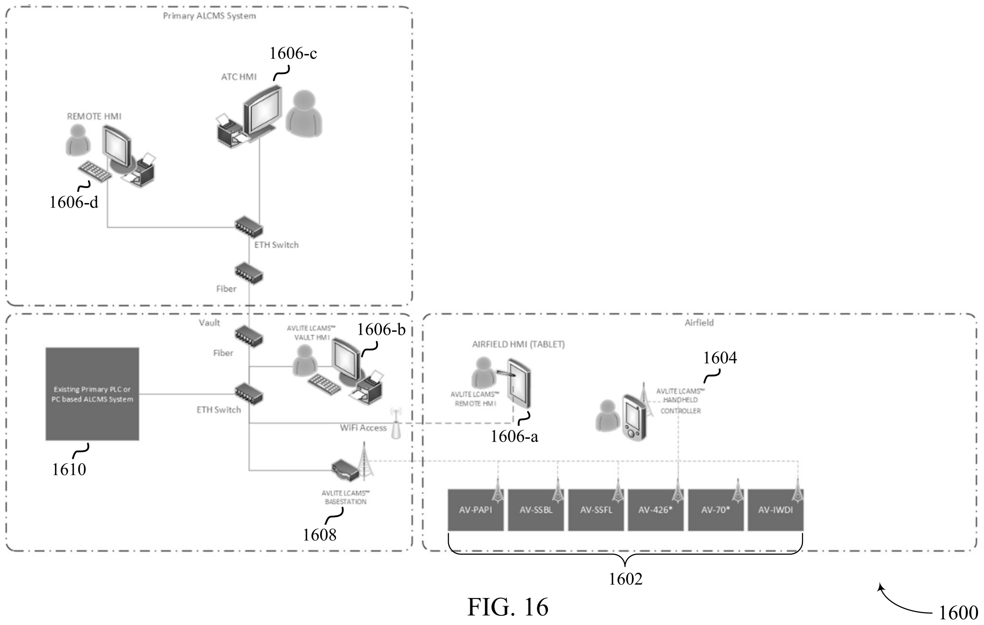

FIG. 16 is a schematic diagram illustrating the airport environment of FIG. 1 from another alternative aspect, in accordance with one or more aspects of the present disclosure. As illustrated in FIG. 16, the airport environment 1600 may support the basestation 1608 may operate in the sub-system mode under the supervision of an existing ALCMS 1610, rather than serving as the primary control authority for the airfield (e.g., 114, FIG. 1). In some aspects, one or more communication interfaces (e.g., 1606-a-1606-d) may be connected to the existing ALCMS 1610 through a network infrastructure (e.g., 140, FIG. 1) that includes at least Ethernet switches and fiber-optic links. Control commands and configuration actions may be initiated through the existing ALCMS (e.g., 128, FIG. 1), which maintains supervisory authority over airfield lighting operations. In this mode, the basestation (e.g., 138, FIG. 1) may not originate lighting control decisions independently; instead, the basestation may receive commands from the existing ALCMS and function as an intermediary component that extends the reach of the ALCMS into the airfield (e.g., 114, FIG. 1). This arrangement may allow the basestation 1608 to integrate one or more lighting fixtures 1602 and communication pathways without displacing or duplicating the existing ALCMS functionality.

Further, FIG. 16 may illustrate how, in the sub-system mode, the basestation 1608 may provide localized communication and monitoring services for the lighting fixtures 1602 while remaining logically subordinate to the existing ALCMS 1610. The basestation 1608 may interface with wireless access points and RF-enabled devices, including one or more handheld controllers (e.g., 1604) and RF-controlled lighting fixtures (e.g., 1602) deployed across the airfield. At the same time, the basestation 1608 may communicate status information, alarms, and operational feedback to the existing ALCMS 1610 through the network. This may enable centralized monitoring and control of both wired and wireless lighting fixtures through the ALCMS, while allowing the basestation 1608 to manage RF communications, device discovery, and localized status collection.

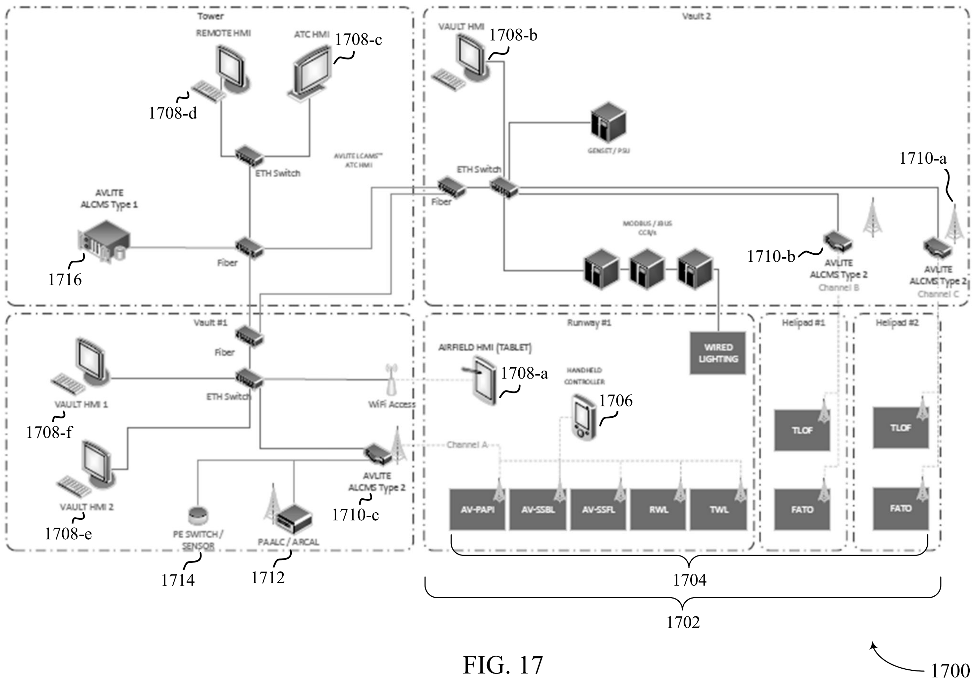

FIG. 17 is a schematic diagram illustrating the airport environment of FIG. 1 from another alternative aspect, in accordance with one or more aspects of the present disclosure. As illustrated in FIG. 17, an existing ALCMS (e.g., 1716) located within the airport environment 1700 may serve as a secondary control authority for the airfield 1702. User interactions may originate from communication interfaces (e.g., 1708-a-1708-d) connected to the existing ALCMS and/or one or more lighting management platforms (e.g., 1710-a-1710-c) through one or more Ethernet switches and fiber-optic links. Each lighting management platform may exchange control and monitoring data with the communication interfaces and associated networking equipment, thereby enabling centralized oversight of airfield lighting operations. In this environment 1700, one or more control commands may be issued by the lighting management platforms and transmitted downstream using a standardized protocol (e.g., Modbus TCP/IP) to airfield components (e.g., 1704).

Further, FIG. 17 may illustrate that the airfield 1702 includes one or more helipad environments. Each lighting management platform (e.g., 138, FIG. 1) may communicate wirelessly (e.g., via designated RF channels) with one or more RF-enabled lighting fixtures (e.g., 1704), including at least TLOF and FATO lighting fixtures. Each lighting management platform may also interface with wired lighting fixtures and auxiliary components, such as PALC devices (e.g., 1712), photoelectric sensors (e.g., 1714), and handheld controllers (e.g., 1706). Status information, alarms, and device telemetry collected from the airfield 1702 may be processed by each lighting management platform to support centralized monitoring and decision-making.

FIG. 18 is a flowchart that describes an example user management method, in accordance with one or more aspects of the present disclosure. The operations of the method 1800 shown in FIG. 18 may be performed by an engine 204 as described with reference to FIG. 2.

The method 1800 may begin when a user enters credentials (1802) to access the platform (e.g., 202, FIG. 2) via the communication interface (e.g., 210, FIG. 2), after which the user may navigate to a configuration tab on the interface (1804) and select a "manage user" tab (1806) to open a "manage user" page (1808). From this page, the user may choose to edit an existing user (1810), which opens an "edit user" popup (1812) that may allow modification of user details (e.g., contact information, profile data, etc.) and may save the changes to update the user record (1814). Alternatively, the user may select change access (1818), which opens an "access control" popup (1820), where a new access level or role may be assigned and saved to update the user's authorization settings (1822). The user may also select "remove user" (1826), which triggers a confirmation popup (1828) requesting verification before deletion; if confirmed, the user account is removed and the interface returns to the manage user page (1830), and if declined, no changes are applied (1832). At any point (1816 and 1824), the user may select back to return to the manage user page without applying modifications, ensuring that all user management actions remain deliberate, confirmable, and reversible. Additional details of the user management method are described above with reference to FIG. 3.

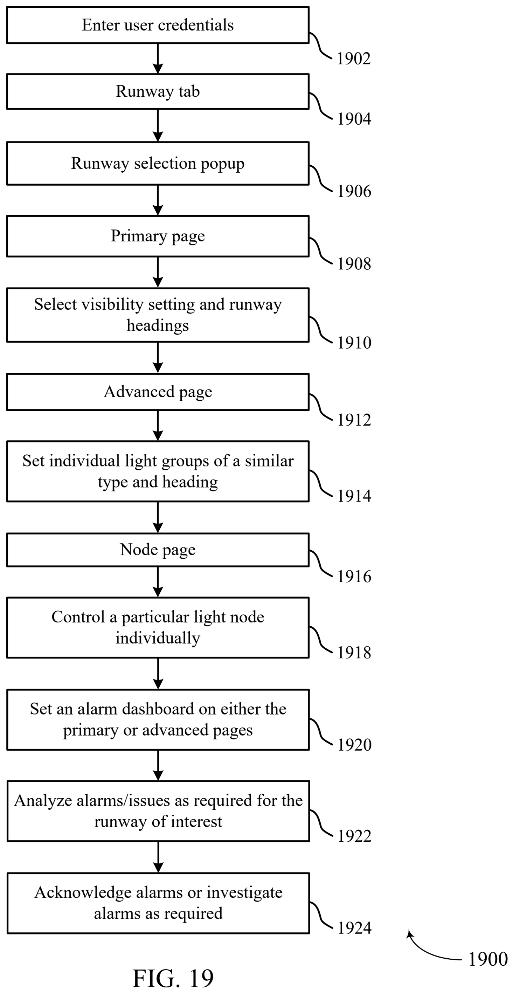

FIG. 19 is a flowchart that describes an example method 1900 for managing a workload, in accordance with one or more aspects of the present disclosure. The operations of the method 1900 shown in FIG. 19 may be performed by an engine 204 as described with reference to FIG. 2.

The method 1900 may begin with a login step (1902), in which a user may enter valid credentials, via the communication interface (e.g., 210, FIG. 2), to access the platform (e.g., 202, FIG. 2). After successful authentication, the user may navigate to a "runway" tab (1904), which provides access to runway-specific operational controls. Upon selecting the runway tab, a "runway selection" popup may be displayed on the interface (1906), allowing the user to choose a specific runway for operation. In some aspects, when multiple runways are configured for the airfield (e.g., 114, FIG. 1), the selected runway may determine which runway layout, lighting fixtures, and associated data are loaded. Once a runway is selected, the engine 204 may route, via the interface, the user to a "primary" page (1908), which presents high-level runway information and controls for the chosen runway, ensuring that all subsequent actions are contextually bound to that runway.

From the primary page, the user may perform routine runway-level operations, including selecting visibility settings and runway headings (1910), which may define how the runway lighting behaves under various operational conditions. In some cases, the engine 204 may process visibility data and runway steps during this step, preparing the corresponding lighting fixtures for appropriate intensity and mode settings. If more detailed control is required, the user may navigate to an "advanced" page (1912), where individual light groups of similar type and heading may be controlled independently (1914). From the advanced page, the user may proceed to a "light node" page (1916), which may provide direct control of a specific light node (1918). For monitoring and fault handling, the user may select an "alarm dashboard" from either the primary or advanced pages (1920), review alarms associated with the selected runway (1922), and acknowledge or investigate alarms as needed (1924), with the help of the engine 204. Additional details of managing the workload are described above with reference to FIGs. 4A and 4B.

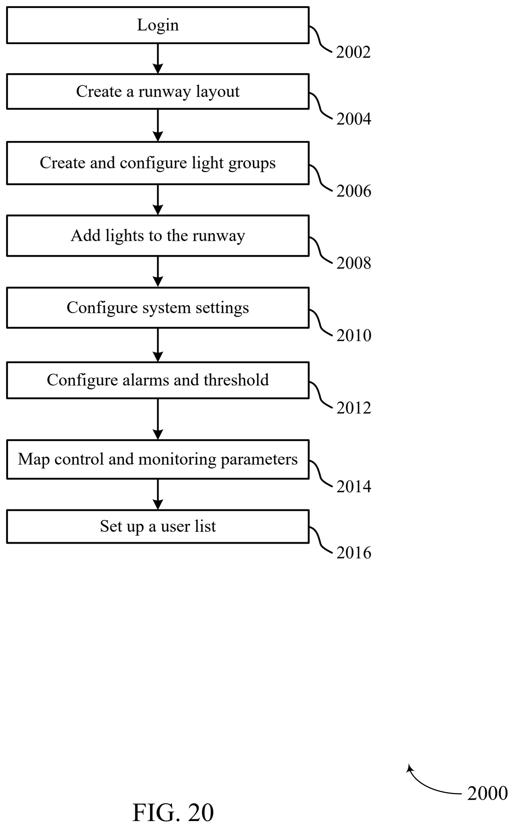

FIG. 20 is a flowchart that describes another example method 2000 for managing a workload, in accordance with one or more aspects of the present disclosure. The operations of the method 2000 shown in FIG. 20 may be performed by an engine 204 as described with reference to FIG. 2.

The method 2000 may begin with a login step, in which a user may gain access to the platform (e.g., 202, FIG. 2) after being authenticated (2002). After successful authentication, the user may proceed to create a runway layout (2004), during which the physical structure of one or more runways may be defined within the communication interface (e.g., 210, FIG. 2). The method may then proceed to creating and configuring one or more light groups (2006), allowing the user to logically organize one or more lighting fixtures based on various factors (e.g., location, function, operational purpose, etc.). Once the light groups are defined, the user may add one or more lights to the runway (2008), assigning individual lighting fixtures to specific runway segments and associating them with the previously configured light groups.

After the runway lighting fixtures are defined, the engine 204 configure one or more system settings (2010), during which global or platform-level operational parameters may be established. The user may then configure alarms and thresholds (2012), specifying warning and alarm criteria for monitoring lighting behavior, faults, or abnormal conditions. Further, the engine 204 may map control and monitoring parameters (2014), which links user commands, monitoring data, and system responses to the configured lighting fixtures and groups. The engine 204 may then set up a user list (2016), in which user accounts, roles, and access permissions are defined to control who may configure, operate, and monitor the lighting fixtures.

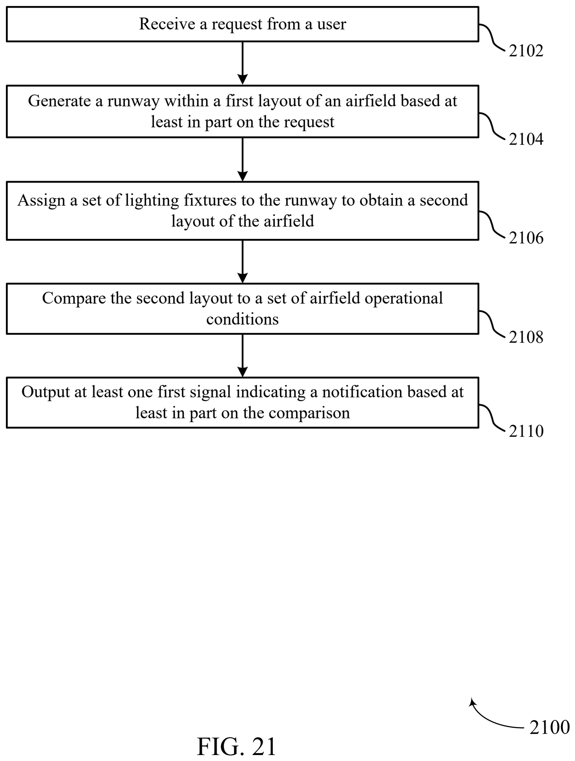

FIG. 21 is a flowchart of an example method 2100 for managing a workload, in accordance with one or more aspects of the present disclosure. The operations of the method 2100 may be implemented by one or more computing devices 102 or their components as described herein. For example, the operations of the method 2100 may be performed by the communication interface 210 as described with reference to FIGs. 2, 4A, and 4B. In some examples, a computing device 102 or the aforementioned components may execute a set of instructions to control the functional elements of the computing devices 102 or the components to perform the described functions. Additionally, or alternatively, the computing devices 102 or the components may perform aspects of the described functions using special-purpose hardware.

At 2102, the method 2100 may include receiving a request from a user. The operations of 2102 may be performed in accordance with examples as disclosed herein. In some examples, aspects of the operations of 2102 may be performed by the communication interface 210 as described with reference to FIGs. 4A and 4B. In some forms of the method 2100, the request may be a validated request. In other forms of the method 2100, the request may be validated while operating in a primary mode or in a sub-system mode. In other examples, the request may specify a set of inputs, and the set of inputs may specify a length of the runway, a width of the runway, an orientation of the runway, or a combination thereof.

At 2104, the method 2100 may include generating a runway within a first layout of an airfield based at least in part on the request. The operations of 2104 may be performed in accordance with examples as disclosed herein. In some examples, aspects of the operations of 2104 may be performed by the communication interface 210 as described with reference to FIGs. 4A and 4B.

At 2106, the method 2100 may include assigning a set of lighting fixtures to the runway to obtain a second layout of the airfield. The operations of 2106 may be performed in accordance with examples as disclosed herein. In some examples, aspects of the operations of 2106 may be performed by the communication interface 210 as described with reference to FIGs. 4A and 4B. In some examples, at least one of the set of lighting fixtures may be part of a light group in the runway. The set of lighting fixtures may include solar-powered radio frequency-enabled lighting fixtures, runway edge lighting fixtures, wired lighting fixtures, stand-alone steady burning lighting fixtures, or a combination thereof. In some examples, assigning the set of lighting fixtures to the runway may include associating each lighting fixture of the set of lighting fixture with a physical location on the second layout.

At 2108, the method 2100 may include comparing the second layout to a set of airfield operational conditions. The operations of 2108 may be performed in accordance with examples as disclosed herein. In some examples, aspects of the operations of 2108 may be performed by the communication interface 210 as described with reference to FIGs. 4A and 4B.

At 2110, the method 2100 may include outputting at least one first signal indicating a notification based at least in part on the comparison. The operations of 2110 may be performed in accordance with examples as disclosed herein. In some examples, aspects of the operations of 2110 may be performed by the communication interface 210 as described with reference to FIGs. 4A and 4B.

The method 2100 may further include determining that the second layout has an issue based at least in part on the comparison, and outputting at least one second signal indicating a second notification associated with the issue. The method 2100 may further include determining that the second layout satisfies the airfield operational conditions based at least in part on the comparison.

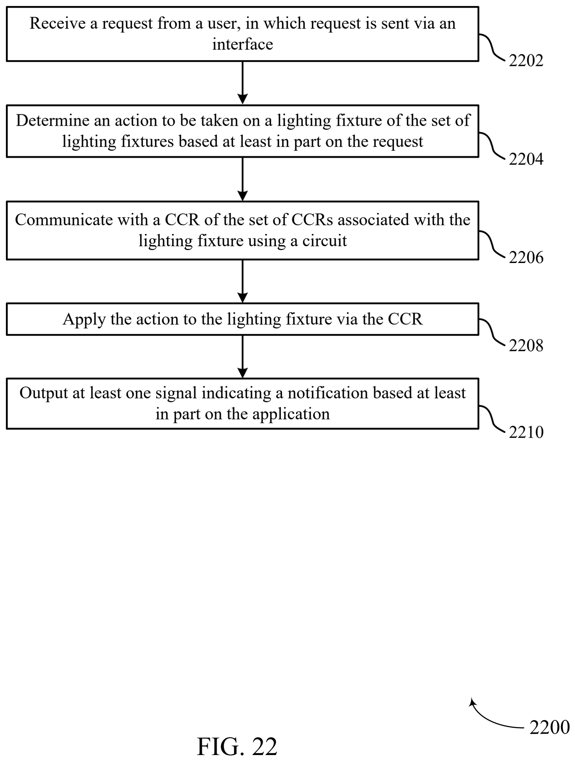

FIG. 22 is a flowchart of an example method 2200 for managing a workload, in accordance with one or more aspects of the present disclosure. The operations of the method 2200 may be implemented by one or more computing devices 102 or their components as described herein. For example, the operations of the method 2200 may be performed by the engine 204 as described with reference to FIGs. 2, 4A, and 4B. In some examples, a computing device 102 or the aforementioned components may execute a set of instructions to control the functional elements of the computing devices 102 or the components to perform the described functions. Additionally, or alternatively, the computing devices 102 or the components may perform aspects of the described functions using special-purpose hardware.

At 2202, the method 2200 may include receiving a request from a user, in which the request is sent via an interface. The operations of 2202 may be performed in accordance with examples as disclosed herein. In some examples, aspects of the operations of 2202 may be performed by the engine 204 as described with reference to FIGs. 4A and 4B.

At 2204, the method 2200 may include determining an action to be taken on a lighting fixture of the set of lighting fixtures based at least in part on the request. The operations of 2204 may be performed in accordance with examples as disclosed herein. In some examples, aspects of the operations of 2204 may be performed by the engine 204 as described with reference to FIGs. 4A and 4B. The lighting fixture may be part of a light group in the airfield. In some examples of the method 2200, the engine may further determine the action to be taken based at least in part on an airfield operational condition. The action may dictate changing a mode (e.g., intensity, color, etc.) of the lighting fixture, adjusting a workload of the lighting fixture, or a combination thereof.

At 2206, the method 2200 may include communicating with a CCR of the set of CCRs associated with the lighting fixture using a circuit. The operations of 2206 may be performed in accordance with examples as disclosed herein. In some examples, aspects of the operations of 2206 may be performed by the engine 204 as described with reference to FIGs. 4A and 4B. In some examples, the CCR may be a multi-step CCR, and the action may dictate modifying a current-level of the lighting fixture. The set of lighting fixtures may include solar-powered radio frequency-enabled lighting fixtures, runway edge lighting fixtures, wired lighting fixtures, stand-alone steady burning lighting fixtures, or a combination thereof.

At 2208, the method 2200 may include applying the action to the lighting fixture via the CCR. The operations of 2208 may be performed in accordance with examples as disclosed herein. In some examples, aspects of the operations of 2208 may be performed by the engine 204 as described with reference to FIGs. 4A and 4B.

At 2210, the method 2200 may include outputting at least one signal indicating a notification based at least in part on the application. The operations of 2210 may be performed in accordance with examples as disclosed herein. In some examples, aspects of the operations of 2210 may be performed by the engine 204 as described with reference to FIGs. 4A and 4B.

The method 2200 may further include analyzing the request to identify an interest of the user and an operation mode. In some forms of the method 2200, the operation mode may be a primary mode or a sub-system mode.

The method 2200 may further include receiving at least one second signal indicating feedback regarding the notification.

It should be noted that the methods described herein describe possible implementations. The operations and the steps may be rearranged, or otherwise modified and other implementations are possible. Further, aspects from two or more of the methods may be combined.

The various illustrative blocks and components described in connection with the disclosure herein may be implemented or performed using a general-purpose processor, a DSP, an ASIC, a CPU, a GPU, an NPU, an FPGA or other PLD, a discrete gate or transistor logic, discrete hardware components, or any combination thereof designed to perform the functions described herein. A general-purpose processor may be a microprocessor but, in the alternative, the processor may be any processor, controller, microcontroller, or state machine. A processor may be implemented as a combination of computing devices (for example, a combination of a DSP and a microprocessor, multiple microprocessors, one or more microprocessors in conjunction with a DSP core, a combination of classical and quantum processors, or any other such configuration). Any functions or operations described herein as being capable of being performed by a processor may be performed by multiple processors that, individually or collectively, are capable of performing the described functions or operations.

The functions described herein may be implemented using hardware, software executed by one or more processors, firmware, or any combination thereof. If implemented using software executed by multiple processors, the functions may be stored as or transmitted using one or more instructions or code of a computer-readable medium. Other examples and implementations are within the scope of the disclosure and appended claims. For example, due to the nature of software, functions described herein may be implemented using software executed by one or more processors, hardware, controllers, firmware, hardwiring, circuitry, or combinations of any of these. Features implementing functions may be physically located at various positions, including being distributed such that portions of functions are implemented at different physical locations.

Computer-readable media include both non-transitory computer storage media and communication media including any medium that facilitates transfer of a computer program from one location to another. A non-transitory storage medium may be any available medium that may be accessed by a general-purpose or special-purpose computer, whether classical or quantum. Any of the computing devices described herein may include at least one memory storing processor-executable code and at least one processor communicatively connected with the at least one memory. The at least one processor may be individually or collectively operable to execute the code to perform any of the described functions or operations.

By way of example, and not limitation, non-transitory computer-readable media may include random access memory (RAM), static RAM (SRAM), dynamic RAM (DRAM), read-only memory (ROM), programmable ROM (PROM), electrically erasable programmable ROM (EEPROM), flash memory, phase-change memory, resistive random-access memory (ReRAM), magnetoresistive random-access memory (MRAM), solid-state drives (SSD), embedded Multimedia Card (eMMC), Universal Flash Storage (UFS), hard disk drives (HDD), compact disc (CD) ROM or other optical disc storage, digital versatile disc (DVD), floppy disk, and Blu-ray disc, magnetic disc storage or other magnetic storage devices, holographic storage, DNA-based storage, protein-based storage, quantum memory, or any other non-transitory medium that may be used to carry or store desired program code means in the form of instructions or data structures and that may be accessed by a general-purpose or special-purpose computer or a general-purpose or special-purpose processor.

Any connection may be properly termed a computer-readable medium. For example, the software may be transmitted from a website, server, or other remote source using a wired technology such as a coaxial cable, fiber optic cable, twisted pair, digital subscriber line (DSL), universal serial bus (USB), high-definition multimedia interface (HDMI), DisplayPort, Thunderbolt, video graphics array (VGA), digital visual interface (DVI), Serial Advanced Technology Attachment (SATA), Peripheral Component Interconnect Express (PCIe), thunderbolt cable, power cable, ribbon cable, integrated services digital network (ISDN), or wireless technologies such as wireless fidelity (Wi-Fi), Wi-Fi 6 (IEEE 802.11ax), Bluetooth, Bluetooth Low Energy (BLE), cellular network (e.g., 5G and 6G networks and future-developed networks), near-field communication (NFC), Zigbee, Z-Wave, Thread, Matter, long-range (LoRa), infrared (IR), radio frequency identification (RFID), light fidelity (Li-Fi), satellite communication, ultra-wideband (UWB), millimeter wave (mmWave), terahertz communication, microwave, or the like.

Cloud storage services (e.g., object storage, block storage, file storage) that make data accessible via network connections also constitute computer-readable media within the scope of this disclosure. The wired and/or wireless technologies are included in the definition of computer-readable medium. Combinations of the above are also included within the scope of computer-readable media. Any functions or operations described herein as being capable of being performed by a memory may be performed by multiple memories that, individually or collectively, are capable of performing the described functions or operations.

Although the disclosure may describe components and functions that may be implemented in a particular example with reference to a particular standard or protocol, the disclosure is not limited to the standard or protocol. Other standards or protocols supporting similar functionality are considered equivalents thereof.

As used herein, including in the claims, "or" as used in a list of items (for example, a list of items prefaced by a phrase such as "at least one of" or "one or more of") indicates an inclusive list such that, for example, a list of at least one of A, B, or C means A or B or C or AB or AC or BC or ABC (e.g., A and B and C). Furthermore, "and/or" as used in a list of items indicates an inclusive list such that, for example, a list of at least one of A, B, and/or C means A or B or C or AB or AC or BC or ABC (e.g., A and B and C). Unless explicitly stated otherwise, the use of "or" and "and/or" are intended to be interchangeable. Also, as used herein, the phrase "based on" shall not be construed as a reference to a closed set of conditions. For example, a step that may be described as "based on condition A" may be based on both a condition A and on a condition B, and possibly additional conditions as well. For example, as used herein, the phrase "based on" shall be construed in the same manner as the phrase "based at least in part on."

As used herein, including in the claims, the article "a" before a noun may be openended and understood to refer to "at least one" of those nouns or "one or more" of those nouns. Thus, the terms "a," "at least one," "one or more," and "at least one of one or more" may be interchangeable. For example, if a claim recites "a component" that performs one or more functions, each of the individual functions may be performed by a single component or by any combination of multiple components. Thus, the term "a component" having characteristics or performing functions may refer to "at least one of one or more components" having a particular characteristic or performing a particular function. Subsequent reference to a component introduced with the article "a" using the terms "the" or "said" may refer to any or all of the one or more components. For example, a component introduced with the article "a" may be understood to mean "one or more components," and referring to "the component" subsequently in the claims may be understood to be equivalent to referring to "at least one of the one or more components." Similarly, subsequent reference to a component introduced as "one or more components" using the terms "the" may refer to any or all of the one or more components. For example, referring to "the one or more components" subsequently in the claims may be understood to be equivalent to referring to "at least one of the one or more components."

The terms "determine," "determining," "identify," "identifying," "analyze," "analyzing," "process," or "processing," for example, encompass a variety of actions and, therefore, "determining," "identifying," "analyzing," or "processing" may include calculating, computing, performing actions on, deriving, investigating, looking up (such as via looking up in a table, a database, or another data structure), receiving, ascertaining, or the like. Also, "determining," "identifying," "analyzing," or "processing" may include receiving (for example, receiving information), accessing (for example, accessing data stored in memory), retrieving, or the like. Also, "determining," "identifying," "analyzing," or "processing" may include resolving, obtaining, selecting, choosing, establishing, and other such similar actions.

In the appended figures, similar components or features may have the same reference label. Further, various components of the same type may be distinguished by following the reference label by a dash and a second label (or the reference label followed by a letter) that distinguishes among the similar components. If just the first reference label may be used in the specification, the description may be applicable to any one of the similar components having the same first reference label irrespective of the second reference label or other subsequent reference label.

The description set forth herein, in connection with the appended figures, describes example configurations and does not represent all the examples that may be implemented or that are within the scope of the claims. The term "example" or "instance" used herein means "serving as an example, instance, or illustration" and not "preferred" or "advantageous over other examples." The detailed description includes specific details for the purpose of providing an understanding of the techniques that are described. These techniques, however, may be practiced without these specific details. In some figures, known structures and devices are shown in block diagram form in order to avoid obscuring the concepts of the described examples. The features of the various examples described herein may be combined in any suitable manner. It is contemplated that one or more features from any example may be incorporated into any other example unless explicitly stated otherwise. The combinations of features from different examples are within the scope of the disclosure. Although terms such as "document," "file," "segment," "block," or "object" may be used by way of example, the present disclosure is not limited to any particular form of representing and storing data or other information. Rather, the present disclosure may be equally applicable to any object capable of representing information.

It will be appreciated by those skilled in the art that while the disclosure has been described above in connection with particular examples, the disclosure is not necessarily so limited, and that numerous other examples, uses, instances, means for, modifications and departures from the examples, instances, uses, and means for are intended to be encompassed by the claims attached hereto. The entire disclosure of any patent and publication cited herein is incorporated by reference, as if each such patent or publication were individually incorporated by reference herein. Various features and advantages of the disclosure are set forth in the following claims.

## Claims

1. A computing device, comprising:
at least one memory storing processor-executable code; and
at least one processor communicatively connected with the at least one memory and individually or collectively operable to execute the code to cause the computing device to:
receive a request from a user, wherein the request is sent from a second computing device over a network;
determine a dataset based at least in part on the request;
compare the dataset to a layout of an airfield, wherein the layout specifies a set of lighting fixtures; and
output at least one signal indicating a report associated with the request based at least in part on the comparison.

2. The computing device of claim 1, wherein the at least one processor operable to execute the code further causes the computing device to:
analyze the request to identify an interest of the user and an operation mode.

3. The computing device of claim 2, wherein the operation mode is a primary mode or a subsystem mode.

4. The computing device of any one of claims 1 to 3,
wherein the network supports Modbus transmission control protocol and Internet protocol (Modbus TCP/IP) communication, and
wherein the second computing device communicates with the computing device using the Modbus TCP/IP.

5. The computing device of any one of claims 1 to 4, wherein the set of lighting fixtures comprises solar-powered radio frequency enabled lighting fixtures, runway edge lighting fixtures, wired lighting fixtures, stand-along steady burning lighting fixtures, or a combination thereof.

6. A runway builder, comprising:
at least one memory storing processor-executable code; and
at least one processor communicatively connected with the at least one memory and individually or collectively operable to execute the code to cause the runway builder to:
receive a request from a user;
generate a runway within a first layout of an airfield based at least in part on the request;
assign a set of lighting fixtures to the runway to obtain a second layout of the airfield;
compare the second layout to a set of airfield operational conditions; and
output at least one first signal indicating a notification based at least in part on the comparison.

7. The runway builder of claim 6, wherein the request is a validated request.

8. The runway builder of claim 7, wherein the request is validated while operating in a primary mode.

9. The runway builder of any one of claims 6 to 8,
wherein the request specifies a set of inputs, and
wherein the set of inputs specifies a length of the runway, a width of the runway, an orientation of the runway, or a combination thereof.

10. The runway builder of any one of claims 6 to 9, wherein at least one of the set of lighting fixtures is part of a light group in the runway.

11. The runway builder of any one of claim 6 to 10, wherein the at least one processor operable to execute the code further causes the runway builder to:
determine that the second layout has an issue based at least in part on the comparison; and
output at least one second signal indicating a second notification associated with the issue.

12. An airport environment, comprising:
a lighting management platform comprising an engine and an interface;
an airfield comprising a set of lighting fixtures and a set of constant current regulators (CCRs), wherein the platform is communicatively connected to the airfield over a network, wherein the engine is designed to:
receive a request from a user, wherein the request is sent via the interface;
determine an action to be taken on a lighting fixture of the set of lighting fixtures based at least in part on the request;
communicate with a CCR of the set of CCRs associated with the lighting fixture using a circuit;
apply the action to the lighting fixture via the CCR; and
output at least one first signal indicating a notification based at least in part on the application.

13. The airport environment of claim 12, wherein the engine further designed to:
analyze the request to identify an interest of the user and an operation mode.

14. The airport environment of claim 11 or 12,
wherein the CCR is a multi-step CCR, and
wherein the action dictates modifying a current-level of the lighting fixture.

15. The airport environment of any one of claims 12 to 14, wherein the lighting fixture is part of a light group in the airfield.
